(19) Europäisches Patentamt
European Patent Office
Office européen des brevets

(11) EP 1 696 266 A2

# (12) EUROPEAN PATENT APPLICATION

(43) Date of publication:
**30.08.2006 Bulletin 2006/35**

(51) Int Cl.:
***G03F 7/00*** *(2006.01)*

(21) Application number: **06003827.0**

(22) Date of filing: **24.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **25.02.2005 JP 2005051773**

(71) Applicant: **FUJI PHOTO FILM CO., LTD.**
**Minami-Ashigara-shi, Kanagawa (JP)**

(72) Inventor: **Takizawa, Hiroo**
**Minami-Ashigara-shi,**
**Kanagawa (JP)**

(74) Representative: **Grünecker, Kinkeldey,**
**Stockmair & Schwanhäusser**
**Anwaltssozietät**
**Maximilianstrasse 58**
**80538 München (DE)**

## (54) Hologram recording material and optical recording medium

(57) A hologram recording material is provided and has: an optical refractive index-modulating component; and a curable polymer. The optical refractive index-modulating component performs at least one of: (1) a color development reaction; (2) a color development reaction amplified by a self-sensitization with a coloring material of a latent image; (3) a color development reaction amplified by a self-sensitization with a coloring material of a latent image; (4) an alignment change in a compound having a birefringence; (5) a dye discoloration reaction; and (6) a latent image-sensitized polymerization reaction sensitized by a latent image of a residual of a discolorable dye, to record interference fringes providing a refractive index modulation.

*FIG. 1*

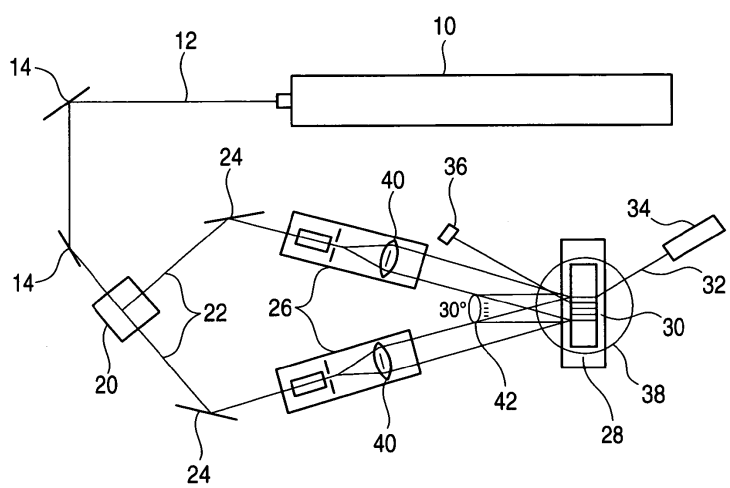




Printed by Jouve, 75001 PARIS (FR)

## Description

FIELD OF THE INVENTION

The present invention relates to a hologram recording material and hologram recording method which can be applied to high density optical recording medium, three-dimensional display, holographic optical element, etc.

BACKGROUND OF THE INVENTION

The general principle of preparation of hologram is described in some literatures and technical books, e.g., Junpei Tsujiuchi, "Holographic Display", Sangyo Tosho, Chapter 2. In accordance with these literatures and technical books, a recording object is irradiated with one of two fluxes of coherent laser beams and a photosensitive hologram recording material is disposed in a position such that all the lights reflected by the recording object can be received. Besides the light reflected by the recording object, the other coherent light is incident on the hologram recording material without hitting the object. The light reflected by the object is called object light. The light with which the recording material is directly irradiated is called reference light. The band of interference of reference light with object light is then recorded as image data. Subsequently, when the hologram recording material thus processed is irradiated with the same light (reproducing light) as the reference light, the hologram performs diffraction in such a manner that the wave front of the first reflected light which has reached the recording material from the object during recording is reproduced. As a result, substantially the same object image as the real image of the object can be three-dimensionally observed.

The hologram formed by allowing reference light and object light to be incident on the hologram recording material in the same direction is called transmission hologram. The interference fringes is formed in the direction perpendicular or substantially perpendicular to the surface of the recording material at an interval of from about 1,000 to 3,000 lines per mm.

On the other hand, the hologram formed by allowing reference light and object light to be incident on the hologram recording material in opposite directions is normally called reflection hologram. The interference fringes is formed in the direction parallel to or substantially parallel to the surface of the recording material at an interval of from about 3,000 to 7,000 lines per mm.

The transmission hologram can be prepared by any known method as disclosed in JP-A-6-43634. The reflection hologram can be prepared by any known method as disclosed in JP-A-2-3082, JP-A-3-50588, etc.

On the other hand, the hologram having a sufficiently thick layer relative to the interval of interference fringes (normally five times the interval of interference fringes or about 1 μm or more) is called volume hologram.

On the contrary, the hologram having a layer thickness which is five times or less the interval of interference fringes or about 1 μm or less is called plane or surface hologram.

Further, the hologram involving the absorption by dye or silver causing the recording of interference fringes is called amplified hologram. The hologram involving recording by surface relief or refractive index modulation is called phase hologram. The amplified hologram is subject to drastic drop of light diffraction efficiency or reflectance due to absorption of light and thus is disadvantageous in percent utilization of light. In general, the phase hologram is preferably used.

In accordance with the volume phase type hologram, many interference fringes having different refractive indexes are formed in the hologram recording material without by making optical absorption, making it possible to modulate the phase of light without absorbing light.

In particular, the reflection volume phase type hologram is also called Lipman type hologram. In accordance with the reflection volume phase type hologram, wavelength-selective reflection involving Bragg diffraction allows the formation of full-color image, reproduction of white color and enhancement of resolution at a high diffraction efficiency, making it possible to provide a high resolution full-color three-dimensional display.

In recent years, hologram has been put into practical use in the art of holographic optical element (HOE) such as headup display (HUD) to be mounted on automobile, pickup lens for optical disc, head mount display, color filter for liquid crystal and reflection type liquid crystal reflector by making the use of its wavelength-selective reflectivity.

Studies have been made also on the practical use or application of hologram to lens, diffraction grating, interference filter, connector for optical fiber, light polarizer for facsimile, window glass for building, etc.

In the recent tend for highly informative society, networks such as internet and highvision TV have bee rapidly spread. Further, with the operation of HDTV (high definition television) close at hand, there has been a growing demand for high density recording medium for simply recording image data having a capacity of 100 GB or more at reduced cost also in consumers' use.

In the trend for enhancement of computer capacity, an ultrahigh density recording medium capable of recording data having a capacity of about 1 TB or more at a high rate and reduced cost has been desired also in business uses such as computer backup and broadcast backup.

Under these circumstances, replaceable and random-accessible small-sized inexpensive optical recording media have been noted more than ever relative to magnetic tapes, which are not random-accessible, and hard discs, which are not replaceable and are subject to failure. Speaking from the standpoint of physical principle, however, existing two-dimensional optical recording media such as DVD-R allow recording of 25 GB data at greatest per one side even if the wavelength of the recording light is reduced. Thus, these two-dimensional recording media cannot be expected to have a recording capacity great enough to meet the future demand.

Then, three-dimensional optical recording media which perform recording in the thickness direction have been recently noted as ultimate ultrahigh density recording media. Effective methods for this system include method involving the use of two-photon absorbing material and method involving the use of holography (interference). Therefore, volume phase type hologram recording materials have recently been suddenly noted as three-dimensional optical recording media (holographic memory).

In operation, the holographic memory comprising a volume phase type hologram recording material records many two-dimensional digital data (called signal light) using a spatial light modulation element (SLM) such as DMD and LCD instead of object light reflected by the three-dimensional object. Since the recording involves multiplexed recording such as angle-multiplexed recording, phase-multiplexed recording, wavelength- multiplexed recording and shift-multiplexed recording, a capacity as high as up to 1 TB can be attained. Further, reading is normally accomplished by the use of CCD, CMOS or the like. These elements allow parallel writing/reading, making it possible to raise the transfer rate up to 1 Gbps.

However, the hologram recording materials to be used in holographic memory have severer requirements than for the three-dimensional display and HOE as follows.

(1) To have a high sensitivity.
(2) To have a high resolution.
(3) To have a high hologram diffraction efficiency.
(4) To use a fast dry processing during recording.
(5) To allow multiplexed recording (broad dynamic range).
(6) To have a small shrinkage after recording.
(7) To have good hologram storage properties.

In particular, the requirements (1) (To have a high sensitivity), (3) (To have a high hologram diffraction efficiency), (4) (To use a fast dry processing during recording), (6) (To have a small shrinkage after recording) and (7) (To have good hologram storage properties) are chemically opposing properties. It is very difficult to meet these requirements at the same time.

Examples of known volume phase type hologram recording materials include write-once-read-many type hologram recording materials such as gelatin bichromate process hologram recording material, bleached silver halide process hologram recording material and photopolymer process hologram recording material and rewritable type hologram recording materials such as photorefractive process hologram recording material and photochromic polymer process hologram recording material.

However, none of these known volume phase type hologram recording materials cannot meet all these requirements particularly when used as high sensitivity optical recording medium. Thus, these known volume phase type hologram recording materials leave something to be desired.

In some detail, the gelatin bichromate process hologram recording material is advantageous in that it has a high diffraction efficiency and a low noise but is disadvantageous in that it has extremely poor storage properties, requires wet processing and exhibits a low sensitivity. Thus, the gelatin bichromate process hologram recording material is not suitable for holographic memory.

The bleached silver halide process hologram recording material is advantageous in that it has a high sensitivity but is disadvantageous in that it requires wet processing and troublesome bleaching process, causes great scattering and has a poor light-resistance. Thus, the bleached silver halide process hologram recording material, too, is not suitable for holographic memory.

The photorefractive hologram recording material is advantageous in that it is rewritable but is disadvantageous in that it requires the application of a high electric field during recording and has poor record storage properties.

The photochromic polymer process hologram recording material such as azobenzene polymer process hologram recording material is advantageous in that it is rewritable but is disadvantageous in that it has an extremely low sensitivity and poor record storage properties. For example, WO97/44365 pamphlet proposes a rewritable hologram recording material utilizing the refractive anisotropy and orientation control of azobenzene polymer (photochromic polymer). However, this type of a rewritable hologram recording material is disadvantageous in that since the quantum yield of isomerization of azobenzene is low and this process involves orientation change, the sensitivity is extremely low. This type of a rewritable hologram recording material is also disadvantageous in that it has poor record storage

properties, which are contrary to rewritability. Thus, this type of a rewritable hologram recording material cannot be put into practical use.

Under these circumstances, the dry-processed photopolymer process hologram recording material disclosed in the above cited JP-A-6-43634, JP-A-2-3082 and JP-A-3-50588 has the following arrangement. In other words, the dry-processed photopolymer process hologram recording material is essentially composed of a binder, a radical-polymerizable monomer and a photopolymerization initiator. In order to enhance refractive index modulation, one of the binder and the radical-polymerizable monomer comprises a compound having an aromatic ring, chlorine or bromine incorporated therein to make a difference in refractive index therebetween. In this arrangement, the hologram exposure causes the progress of polymerization with the monomer and the binder gathering at the bright area and the dark area of the interference fringes thus formed, making it possible to form a refractive index difference. Thus, it can be said that the dry-processed photopolymer process hologram recording material is a relatively practical hologram recording material which can attain a high diffraction efficiency and dry processing properties at the same time.

However, the dry-processed photopolymer process hologram recording material is disadvantageous in that it has a sensitivity of about one thousandth of that of the bleached silver halide process hologram recording material, requires a heat-fixing step for about 2 hours to enhance diffraction efficiency, requires radical polymerization causing the effect of polymerization inhibition by oxygen and is subject to shrinkage after exposure and fixing and hence change of diffraction wavelength and angle during reproduction. Further, the dry-processed photopolymer process hologram recording material is in the form of soft membrane and lacks storage properties. Accordingly, the dry-processed photopolymer process hologram recording material can be by no means used for holographic memory.

In general, as opposed to radical polymerization, cationic polymerization, particularly cationic polymerization involving the ring opening of an epoxy compound, etc., causes little shrinkage after polymerization and no polymerization inhibition by oxygen. As a result, a rigid membrane can be given. It is also pointed out that cationic polymerization is more suitable for holographic memory than radical polymerization.

For example, JP-A-5-107999 and JP-A-8-16078 disclose a hologram recording material comprising in combination a cationically-polymerizable compound (monomer or oligomer) instead of binder and a sensitizing dye, a radical polymerization initiator, a cationic polymerization initiator and a radical-polymerizable compound.

Further, JP-T-2001-523842 and JP-T-11-512847 disclose a hologram recording material comprising only a sensitizing dye, a cationic polymerization initiator, a cationically- polymerizable compound and a binder but free from radical polymerization.

The aforementioned cationic polymerization process hologram recording material shows some improvement in shrinkage resistance as compared with the radical polymerization process hologram recording material but has a lowered sensitivity as opposed to the improvement. It is thought that this disadvantage gives a great problem in transfer rate during practical use. Further, the cationic polymerization process hologram recording material exhibits a reduced diffraction efficiency that probably gives a great problem in S/N ratio and multiplexed recording properties.

Further, JP-T-2004-537620 discloses a hologram recording material made of a polymer produced by the reaction of a photoreactive material with an NCO-terminated prepolymer and a polyol. Moreover, JP-A-2000-250382 discloses a recording material comprising a polymer matrix and an optical image-forming system containing a photoactive monomer, wherein the polymer matrix and the optical image forming system undergo phase separation to exhibit a Rayleigh ratio of about $7 \times 10^{-3}$ or less at 90° of scattering of light having a wavelength effective for formation of hologram and the polymer matrix is produced by a reaction independent of the reaction for the polymerization of the photoactive monomer. These recording materials give some solution to the problem of shrinkage after recording but leave something to be desired in the solution. In the latter stage of multiplexed recording, the polymerization proceeds to lower sensitivity. Thus, much exposure is needed. Accordingly, these recording materials show deteriorated multiplexed recording properties, making it impossible to raise the degree of multiplexity to disadvantage.

As previously mentioned, the photopolymer process hologram recording method involves the movement of materials. This causes a dilemma. In some detail, when the hologram recording material to be applied to holographic memory is arranged to have better storage properties and shrinkage resistance, the resulting sensitivity is lowered (cationic polymerization process hologram recording material). On the contrary, when the hologram recording material is arranged to have an enhanced sensitivity, the resulting storage properties and shrinkage resistance are deteriorated (radical polymerization process hologram recording material). In order to enhance the recording density of holographic memory, it is essential that multiplexed recording involving more than 50 times, preferably 100 times or more recording jobs be effected. However, since the photopolymer process hologram recording material employs polymerization process involving the movement of materials to perform recording, the recording speed in the latter half of multiplexed recording process, in which most of the compound has been polymerized, is reduced as compared with that in the initial stage of multiplexed recording process. Accordingly, exposure must be adjusted and a broad dynamic range must be used to control the recording speed. This gives a practically great problem.

The dilemma caused by the requirements for higher sensitivity, better storage properties and dry processing properties and the problem of multiplexed recording properties cannot be avoided from the physical standpoint of view

so far as the related art photopolymer process hologram recording material is used. It is also difficult for the silver halide process recording material in principle from the standpoint of dry processing properties to meet the requirements for holographic memory.

In order to apply a hologram recording material to holographic memory, it has been keenly desired to develop quite a new recording system which can give essential solution to these problems, particularly one which can attain higher sensitivity, lower shrinkage, better storage properties, dry processing properties and multiplexed recording properties (higher recording density) at the same time.

## SUMMARY OF THE INVENTION

An object of an illustrative, non-limiting embodiment of the invention is to provide a hologram recording material and hologram recording method which can be applied to high density optical recording medium, three-dimensional display, holographic optical element, etc. and can attain a high sensitivity, high diffraction efficiency, good storage properties, low shrinkage factor, dry processing properties and multiplexed recording properties (higher recording density) at the same time and an optical recording medium comprising same.

The invention has the following constituents.

(1) A hologram recording material comprising: an optical refractive index-modulating component; and a curable polymer, wherein the optical refractive index-modulating component performs any of (1) color development reaction, (2) latent image color development-coloring material self-sensitized amplification color development reaction (i.e., color development reaction amplified by a self-sensitization with a coloring material of a latent image), (3) latent image color development-coloring material sensitizing polymerization reaction (i.e., polymerization reaction sensitized with a coloring material of a latent image), (4) change of orientation (or alignment) of a compound having a birefringence (i.e., an alignment change in a compound having a birefringence), (5) dye discoloration reaction and (6) remaining discolorable dye latent image-latent image sensitization polymerization reaction (i.e., a latent image-sensitized polymerization reaction sensitized by a latent image of a residual of a discolorable dye), to record interference fringes providing a refractive index modulation.

(2) The hologram recording material as defined in Clause (1), wherein the curable polymer forms a polymer matrix produced by a polymerization reaction which is a cationic epoxy polymerization reaction, a cationic vinyl ether polymerization reaction, a cationic alkenyl ether polymerization reaction, a cationic allyl ether polymerization reaction, a cationic ketene acetal polymerization reaction, an epoxy amine stepwise polymerization reaction, an epoxy mercaptane stepwise polymerization reaction, an unsaturated ester amine stepwise polymerization reaction, an unsaturated ester mercaptane stepwise polymerization reaction, a vinyl- silicon hydride stepwise polymerization reaction, an isocyanate-hydroxyl group stepwise polymerization reaction, an isocyanate-amine stepwise polymerization reaction or a combination thereof.

(3) The hologram recording material as defined in Clause (1), wherein the curable polymer comprises a reactive polymer and a crosslinking agent and undergoes a polymerization reaction to form a polymer matrix.

(4) The hologram recording material as defined in Clause (2) or (3), wherein the polymer matrix is formed by a thermal reaction.

(5) The hologram recording material as defined in Clause (2) or (3), wherein the reaction for the production of the polymer matrix is independent of optical refractive index modulation reaction of the optical refractive index-modulating component and causes no reaction of the optical refractive index-modulating component during the polymer matrix production reaction.

(6) The hologram recording material as defined in Clause (3), wherein the reactive polymer is a polyol and the crosslinking agent is an NCO-terminated prepolymer.

(7) The hologram recording material as defined in Clause (6), wherein an exothermic peak occurs within 12 minutes after the mixing of the polyol and the NCO- terminated prepolymer.

(8) The hologram recording material as defined in Clause (6), wherein the polymerization reaction is an isocyanate-hydroxyl group stepwise polymerization reaction, an isocyanate-amine stepwise polymerization reaction or a combination thereof.

(9) The hologram recording material as defined in Clause (6), wherein the NCO-terminated prepolymer comprises a material selected from the group consisting of an aromatic isocyanate, an aliphatic isocyanate and a combination thereof.

(10) The hologram recording material as defined in Clause (6), wherein the NCO-terminated prepolymer comprises a material selected from the group consisting of an aromatic diisocyanate, a hexamethylene diisocyanate, a hexamethylene diisocyanate derivative and a combination thereof.

(11) The hologram recording material as defined in Clause (6), wherein the polyol comprises a polyol of polypropylene oxide.

(12) The hologram recording material as defined in Clause (6), wherein the polyol comprises a polytetramethylene ether diol.

(13) The hologram recording material as defined in Clause (6), having a thickness of 200 μm or more and Δn of 3 x $10^{-3}$ or more.

(14) The hologram recording material as defined in Clause (6), wherein the NCO-terminated prepolymer comprises biscyclohexylmethane diisocyanate, an NCO-terminated prepolymer produced by the reaction of biscyclohexylmethane diisocyanate with a polytetramethylene glycol, butylated hydroxyltoluene and/or a hexamethylene diisocyanate derivative, the polyol comprises a polyol of polypropylene oxide and a polyol of polytetramethylene ether and an exothermic peak occurs within 12 minutes after the mixing of the polyol with the NCO-terminated prepolymer.

(15) The hologram recording material as defined in Clause (6), wherein the NCO-terminated prepolymer comprises a material selected from the group consisting of diphenylmethane diisocyanate, toluene diisocyanate, hexamethylene diisocyanate and hexamethylene diisocyanate, the polyol comprises a polyol of polypropylene oxide and an exothermic peak occurs within 12 minutes after the mixing of the polyol with the NCO-terminated prepolymer.

(16) The hologram recording material as defined in Clause (1), wherein the curable polymer comprises a melamine-formaldehyde resin.

(17) The hologram recording material as defined in Clause (1) comprising an optical refractive index-modulating component and a curable polymer, wherein the optical refractive index-modulating component system and the curable polymer system undergo phase separation to exhibit a Rayleigh ratio of about 7 x $10^{-3}$ or less at 90° of scattering of light having a wavelength effective for formation of hologram and the curable polymer is produced by a reaction independent of the optical refractive index modulation reaction of the optical refractive index-modulating component.

(18) The hologram recording material as defined in any of Clauses (1) to (17), wherein hologram recording by 2) latent image color development-coloring material self-sensitized amplification color development reaction comprises at least a first step of forming a coloring material having no absorption at hologram reproducing light wavelength as a latent image by hologram exposure and a second step of irradiating the coloring material latent image with light having a wavelength different from hologram exposure wavelength at which the sensitizing dye exhibits a molar absorptivity of 5,000 or less to cause the self-sensitized amplification of the coloring material, whereby interference fringes is recorded as refractive index modulation, which steps being effected in a dry process.

(19) The hologram recording material as defined in any one of Clauses (1) to (17), comprising as a group of compounds capable of performing hologram recording by 1) color development reaction or 2) latent image color development-coloring material self-sensitized amplification color development reaction at least:

1) a sensitizing dye which absorbs light upon hologram exposure to generate excited state; and
2) an interference fringes-recording component containing a dye precursor which can form a coloring material that has absorption at longer wavelength than in the original state and no absorption at hologram reproducing light wavelength, which interference fringes-recording component can undergo electron movement (transfer) or energy movement from the excited state of the sensitizing dye or coloring material to cause color development leading to refractive index modulation by which interference fringes is recorded.

(20) The hologram recording material as defined in any one of Clauses (1) to (17), wherein hologram recording involving 3) latent image color development-coloring material sensitized polymerization reaction comprises at least a first step of forming a coloring material having no absorption at hologram reproducing light wavelength as a latent image by hologram exposure and a second step of irradiating the coloring material latent image with light having a wavelength different from hologram exposure wavelength to cause polymerization, whereby interference fringes is recorded as refractive index modulation, which steps being effected in a dry process.

(21) The hologram recording material as defined in any one of Clauses (1) to (17), comprising as a group of compounds defined in Clause (20) capable of performing hologram recording at least:

1) a sensitizing dye which absorbs light upon hologram exposure to generate excited state at the first step;
2) an interference fringes-recording component containing a dye precursor which can form a coloring material that has absorption at longer wavelength than in the original state at which wavelength the sensitizing dye exhibits a molar absorptivity of 5,000 or less and no absorption at hologram reproducing light wavelength when electron or energy moves from the excited state of the sensitizing dye at the first step or from excited state of coloring material at the second step;
3) a polymerization initiator which can initiate the polymerization of a polymerizable compound when electron or energy moves from the excited state of the sensitizing dye at the first step and from excited state of coloring material at the second step;
4) a polymerizable compound; and

(22) The hologram recording material as defined in any one of Clauses (1) to (17), comprising as a group of compounds capable of performing (5) dye discoloration reaction at least:

1) an sensitizing dye which absorbs light upon hologram exposure to generate excited state; and
2) a discolorable dye or discolorable agent precursor made of any of radical generator, acid generator, base generator, nucleophilic agent, electrophilic agent and triplet oxygen and discoloring dye as interference fringes-recording component, wherein, when subjected to hologram exposure, the sensitizing dye generates excited state in which it then undergoes direct energy movement or electron movement to the discolorable dye to discolor the discolorable dye or undergoes energy movement or electron movement with the discolorable agent precursor to cause the discolorable agent precursor to generate a discolorable agent which then discolors the discolorable dye, causing refractive index modulation by which interference fringes is formed.

(23) The hologram recording material as defined in any one of Clauses (1) to (17), wherein hologram recording involving (6) remaining discolorable dye latent image-latent image polymerization reaction comprises a first step at which the sensitizing dye having absorption at hologram exposure wavelength absorbs light during hologram exposure to generate excited state in which it undergoes direct energy movement or electron movement to the discolorable dye defined in Clause (22) to discolor the discolorable dye or undergoes energy movement or electron movement with the discolorable agent precursor to cause the discolorable agent precursor to generate a discolorable agent which then discolors the discolorable dye, whereby the discolorable dye left undiscolored forms a latent image and a second step at which the latent image of discolorable dye left undiscolored is irradiated with light having a wavelength different from that used for hologram exposure to activate the polymerization initiator to cause polymerization by which interference fringes is recorded as refractive index modulation.
(24) The hologram recording material as defined in any one of Clauses (1) to (17), comprising as a group of compounds capable of performing hologram recording defined in Clause (23) at least:

1) a sensitizing dye which absorbs light upon hologram exposure to generate excited state at the first step;
2) a discolorable dye having a molar absorptivity of 1,000 or less at hologram reproducing light wavelength capable of performing direct energy or electron movement from the excited state of the sensitizing dye or direct energy or electron movement to the discoloring agent precursor to undergo discoloration at the first step;
3) a polymerization initiator (optionally acting as a discoloring agent precursor 2) as well) which can undergo electron movement or energy movement from excited state of remaining discolorable dye to initiate the polymerization of the polymerizable compound at the second step;
4) a polymerizable compound; and
5) a binder.

(25) The hologram recording material as defined in any one of Clauses (1) to (24), wherein hologram recording is effected in a non-rewritable process. That is, the interference fringes recorded are non-rewritable.
(26) The hologram recording method as defined in any one of Clauses (1) to (24), which allows multiplexed recording comprising 10 or more recording jobs (i.e., subjecting a hologram recording material to holographic exposure 10 or more times).
(27) The hologram recording material as defined in Clause (26), wherein multiplexed recording can be effected from beginning to end with the exposure kept constant. That is, the multiplexed recording is performed under a common exposure amount in each holographic exposure.
(28) An optical recording medium comprising a hologram recording material defined in any one of Clauses (1) to (27).
(29) An optical recording medium comprising a hologram recording material defined in Clauses (1) to (27) stored in a light-shielding cartridge during storage.

In accordance with the invention, there can be provided a hologram recording material and hologram recording method which can be applied to high density optical recording medium, three-dimensional display, holographic optical element, etc. and can attain a high sensitivity, high diffraction efficiency, good storage properties, low shrinkage factor, dry processing properties and multiplexed recording properties at the same time and an optical recording medium comprising same.

BRIEF DESCRIPTION OF THE DRAWINGS

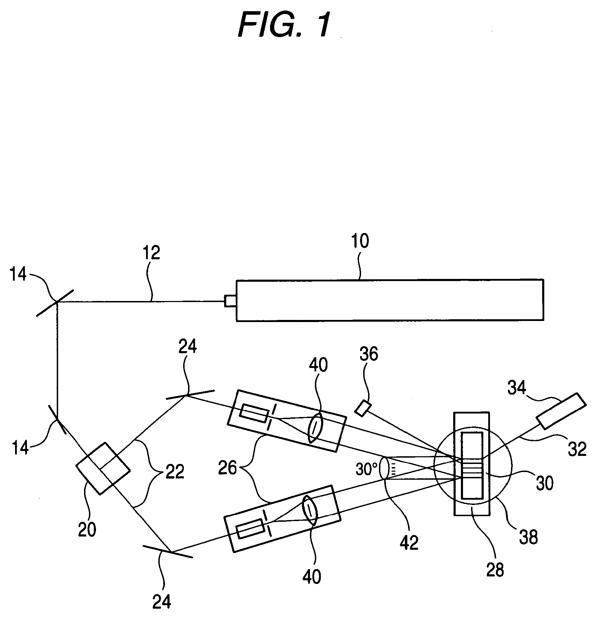

Fig. 1 is a schematic diagram illustrating a two-flux optical system for hologram exposure.
Reference numerals and signs in Fig. 1 are set forth below.

10 YAG laser
12 Laser beam
14 Mirror
20 Beam splitter
22 Beam segment
24 Mirror
26 Spatial filter
28 Sample
30 Hologram recording material
32 He-Ne laser beam
34 He-Ne laser
36 Detector
38 Rotary stage
40 Beam expander
42 Fixing xenon lamp + band pass filter

DETAILED DESCRIPTION OF THE INVENTION

Exemplary embodiments of a hologram recording material of the invention will be further described hereinafter.

A hologram recording material of the invention includes an optical refractive index-modulating component and a curable polymer, and the optical refractive index-modulating component is a component which performs any of 1) color development reaction, 2) latent image color development-coloring material self-sensitized amplification color development reaction, 3) latent image color development-coloring material sensitized polymerization reaction, 4) change of orientation of a compound having an intrinsic birefringence, 5) dye discoloration reaction and 6) remaining discolorable dye latent image-latent image polymerization reaction to record interference fringes as refractive index modulation.

It is preferred that the hologram recording material of the invention be not subjected to wet process.

The hologram recording material of the invention is preferably not of rewritable type. The term "not of rewritable type" as used herein is meant to indicate the type which causes irreversible reaction to perform recording. Once recorded, data can be stored without being rewritten even in an attempt to overwrite thereon. Thus, the hologram recording material of the invention is suitable for the storage of important data which are needed to be stored over an extended period of time. It goes without saying that data can be additionally recorded on unrecorded area. In this sense, this type of a recording material is called "write-once-read-many type" recording material.

The light to be used in the hologram recording method of the invention is preferably any of ultraviolet ray, visible light and infrared ray having a wavelength of from 200 to 2,000 nm, more preferably ultraviolet ray or visible light having a wavelength of from 300 to 700 nm, even more preferably visible light having a wavelength of from 400 to 700 nm.

The radiation to be used in the hologram recording method of the invention is preferably coherent laser beam (having uniform phase and wavelength). As the laser to be used herein there may be used any of solid laser, semiconductor laser, gas laser and liquid laser. Preferred examples of laser beam include YAG laser second harmonic having a wavelength of 532 nm, YAG laser third harmonic having a wavelength of 355 nm, GaN laser having a wavelength of from about 405 to 415 nm, Ar ion laser having a wavelength of from 488 nm or 515 nm, He-Ne laser having a wavelength of 632 nm to 633 nm, Kr ion laser having a wavelength of 647 nm, ruby laser having a wavelength of 694 nm, and He-Cd laser having a wavelength of 636 nm, 634 nm, 538 nm, 534 nm and 442 nm.

Further, pulse laser on the order of nanosecond or picosecond is preferably used.

In the case where the hologram recording material of the invention is used as an optical recording medium, YAG laser second harmonic having a wavelength of 532 nm or semiconductor laser such as GaN laser or InGa laser having a wavelength of from about 400 to 415 nm and AlGaInP laser having a wavelength of from about 650 to 660 nm is preferably used.

The wavelength of the light for use in hologram reproduction is preferably the same as or longer than, more preferably the same as that of the light for use in hologram exposure (recording).

The hologram recording material which has been subjected to hologram exposure may be fixed by either or both of light and heat.

In the case where the hologram recording material of the invention comprises an acid proliferator or base proliferator, it is particularly preferred that fixing be carried out by heating to cause the acid proliferator or base proliferator to act effectively.

In the case of light fixing, the hologram recording material is entirely irradiated with ultraviolet ray or visible light (non-interference exposure). Preferred examples of the light employable herein include visible light laser, ultraviolet laser, carbon arc, high pressure mercury vapor lamp, xenon lamp, metal halide lamp, fluorescent lamp, tungsten lamp, LED, and organic EL.

In the case of heat fixing, fixing is preferably effect at a temperature of from 40°C to 160°C, more preferably from 60°C to 130°C.

In the case where both light fixing and heat fixing are effect, light and heat may be applied at the same time or separately.

The refractive index modulation during recording of interference fringes is preferably from 0.00001 to 0.5, more preferably from 0.0001 to 0.3. It is preferred that the more the thickness of the hologram recording material is, the less is the refractive index modulation. It is preferred that the less the thickness of the hologram recording material is, the more is the refractive index modulation.

The (relative) diffraction efficiency η of a hologram recording material is given by the following equation:

$$\eta = Idiff/Io \quad \text{... (equation 1)}$$

where Io is the intensity of transmitted light which is not diffracted; and Idiff is the intensity of light which is diffracted (transmitted type) or reflected (reflected type). The diffraction efficiency may range from 0% to 100%, preferably 30% or more, more preferably 60% or more, most preferably 80% or more.

The sensitivity of a hologram recording material is normally represented by exposure per unit area (mJ/cm$^2$). The less this value is, the higher is the sensitivity. The exposure at which the sensitivity is defined differs from literature or patent to literature or patent. In some cases, the exposure at which recording (refractive index modulation) begins is defined as sensitivity. In other cases, the exposure at which the maximum diffraction efficiency (refractive index modulation) is given is defined as sensitivity. In further cases, the exposure at which half the maximum diffraction efficiency is given is defined as sensitivity. In still further cases, the exposure at which the gradient of diffraction efficiency relative to exposure E becomes maximum is defined as sensitivity.

According to Kugelnick's theoretical equation, the refractive index modulation Δn at which a certain diffraction efficiency is given is inversely proportional to the thickness d. In other words, the sensitivity at which a certain diffraction efficiency is given differs with thickness. Thus, the more the thickness d is, the less is the required refractive index modulation Δn. Accordingly, the sensitivity cannot be unequivocally compared unless the conditions such as thickness are uniform.

In the invention, in the case where sensitivity is defined by "exposure at which half the maximum diffraction efficiency is given (mJ/cm$^2$)", the sensitivity of the hologram recording material of the invention is preferably 2 J/cm$^2$ or less, more preferably 1 J/cm$^2$ or less, even more preferably 500 mJ/cm$^2$ or less, most preferably 200 mJ/cm$^2$ or less if the thickness is from about 10 μm to 200 μm.

In the case where the hologram recording material of the invention is used in holographic memory as an optical recording medium, it is preferred that many two-dimensional digital data (referred to as "signal light") be recorded using a spatial light modulation element (SLM) such as DMD and LCD. Recording is preferably accomplished by multiplexed recording to raise the recording density. Examples of multiplexed recording methods include angular multiplexed, phase multiplexed, wavelength multiplexed and shift multiplexed recording methods. Preferred among these multiplexed recording methods are angular multiplexed recording and shift multiplexed recording. In order to read reproduced three-dimensional data, CCD or CMOS is preferably used.

In the case where the hologram recording material of the invention is used in holographic memory as an optical recording medium, it is essential that multiplexed recording be effected to enhance the capacity (recording density). In this case, multiplexed recording involving preferably 10 or more times, more preferably 50 times or more, most preferably 100 times or more of recording jobs is performed. More preferably, any multiplexed recording can be effected always at a constant exposure to simplify recording system and enhance S/N ratio.

In the case where the hologram recording material of the invention is used as an optical recording medium, the hologram recording material is preferably stored in a light-shielding cartridge during storage. It is also preferred that the hologram recording material be provided with a light filter capable of cutting part of wavelength range of ultraviolet ray, visible light and infrared ray other than recording light and reproduced light on the surface or back surface or on the both surfaces thereof.

In the case where the hologram recording material of the invention is used as an optical recording medium, the optical recording medium may be in the form of disc, card or tape or in any other form.

The optical refractive index-modulating component of the invention and the hologram recording method using same will be further described hereinafter.

1) Interference fringes recording involving color development reaction

The term "color development reaction" as used herein is meant to indicate a reaction involving the change of

absorption spectrum form or preferably either or both of the shift of λmax to longer wavelength and rise of ε in absorption spectrum in the range of ultraviolet ray, visible light and infrared ray having a wavelength of from 200 nm to 2,000 nm. The color development reaction preferably occurs at a wavelength of from 200 nm to 1,000 nm, more preferably from 300 nm to 900 nm.

In the case where recording involves color development reaction, the hologram recording material of the invention preferably contains at least:

1) a sensitizing dye which absorbs light upon hologram exposure to generate excited state; and

2) an interference fringes-recording component containing a dye precursor which can form a coloring material that has absorption at longer wavelength than in the original state and no absorption at hologram reproducing light wavelength, which interference fringes-recording component can undergo electron movement or energy movement from the excited state of the sensitizing dye to cause color development leading to refractive index modulation by which interference fringes is recorded.

The refractive index of the dye rises in the range of from close to linear absorption maxima wavelength (λmax) to wavelength longer than linear absorption maxima wavelength (λmax), rises drastically in the range of from λmax to wavelength about 200 nm longer than λmax. In this wavelength range, some dyes show a refractive index of more than 1.8, as high as more than 2 in some cases. On the other hand, organic compounds which are not a dye, such as binder polymer, normally have a refractive index of from about 1.4 to 1.6.

It is thus made obvious that the color development of the dye precursor by hologram exposure makes it possible to fairly make not only a difference in absorbance but also a great difference in refractive index.

The hologram recording material of the invention is preferably a phase type hologram recording material which undergoes refractive index modulation to record interference fringes from the standpoint of enhancement of diffraction efficiency. In other words, it is preferred that the hologram recording material have little or no absorption at the wavelength of reproducing light during hologram reproduction.

Accordingly, the coloring material produced by hologram exposure of the dye precursor of the invention preferably has no absorption at the wavelength of hologram recording and reproduction but has absorption at the wavelength of shorter than the wavelength of hologram recording and reproduction. Further, the sensitizing dye preferably is decomposed to lose its absorbing and sensitizing capacity during hologram recording or subsequent fixing.

Further, in order to make great refractive index modulation and raise sensitivity or dynamic range, it is preferred that when subjected to hologram exposure, the dye precursor of the invention form a coloring material that has no absorption at the wavelength of hologram recording and reproduction but has an absorption maxima in the range between the wavelength of hologram recording and the wavelength of 200 nm shorter than the wavelength of hologram recording, more preferably between the wavelength of hologram recording and the wavelength of 100 nm shorter than the wavelength of hologram recording.

Firstly, the sensitizing dye of the invention which absorbs light during hologram exposure to generate excited state will be further described hereinafter.

The sensitizing dye of the invention preferably absorbs any of ultraviolet ray, visible light and infrared ray having a wavelength of from 200 nm to 2,000 nm, more preferably ultraviolet ray or visible light having a wavelength of from 300 to 700 nm, even more preferably visible light having a wavelength of from 400 to 700 nm to generate excited state.

Preferred examples of the sensitizing dye employable herein include cyanine dye, squarilium cyanine dye, styryl dye, pyrilium dye, melocyanine dye, arylidene dye, oxonol dye, azlenium dye, coumarine dye, ketocoumarine dye, styrylcoumarine dye, pyrane dye, xanthene dye, thioxanthene dye, phenothiazine dye, phenoxazine dye, phenazine dye, phthalocyanine dye, azaporphyrin dye, porphyrin dye, fused ring aromatic dye, perylene dye, azomethine dye, anthraquinone dye, metal complex dye, and metalocene dye. Even more desirable among these sensitizing dyes are cyanine dye, melocyanine dye, oxonol dye, metal complex dye, and metalocene dye. A particularly preferred example of the metal complex dye is Ru complex dye. A particularly preferred example of the metalocene dye is ferrocene.

In addition to these sensitizing dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as sensitizing dye of the invention. The sensitizing dye to be used in the invention is not limited to these examples. Any dye or dyestuff may be used so far as it absorbs light in the visible range. These sensitizing dyes may be selected such that they are adapted for the wavelength of radiation from the light source depending on the purpose. Two or more sensitizing dyes may be used in combination depending on the purpose.

Since the hologram recording material needs to be used in the form of thick layer and light needs to be transmitted by the layer, the molar absorptivity of the sensitizing dye at the wavelength of hologram exposure is preferably reduced to maximize the added amount of the sensitizing dye for the purpose of enhancing sensitivity. The molar

absorptivity of the sensitizing dye at the wavelength of hologram exposure is preferably from not smaller than 1 to not greater than 10,000, more preferably from not smaller than 1 to not greater than 5,000, even more preferably from not smaller than 5 to not greater than 2,500, most preferably from not smaller than 10 to not greater than 1,000.

The transmittance of the hologram recording material at the recording wavelength is preferably from 10% to 99%, more preferably from 20% to 95%, even more preferably from 30% to 90%, particularly from 40% to 85% from the standpoint of diffraction efficiency, sensitivity and recording density (multiplexity). To this end, the molar absorptivity of the sensitizing dye at the recording wavelength and the molarity of the sensitizing dye to be added are preferably adjusted according to the thickness of the hologram recording material.

λmax of the sensitizing dye is preferably shorter than the wavelength of hologram recording, more preferably between the wavelength of hologram recording and the wavelength of 100 nm shorter than the wavelength of hologram recording.

Further, the molar absorptivity of the sensitizing dye at the recording wavelength is preferably one fifth or less, more preferably one tenth or less of that at λmax.

In particular, when the sensitizing dye is an organic dye such as cyanine dye and melocyanine dye, the molar absorptivity of the sensitizing dye at the recording wavelength is more preferably one twentieth or less, even more preferably one fiftieth or less, particularly one hundredth or less of that at λmax.

Specific examples of the sensitizing dye employable herein will be given below, but the invention is not limited thereto.

<Cyanine dye>

S-1

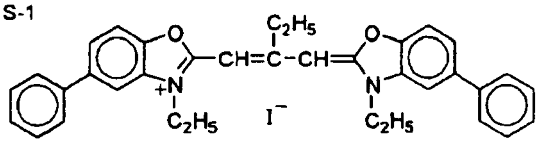

S-2

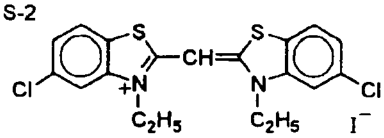

S-3

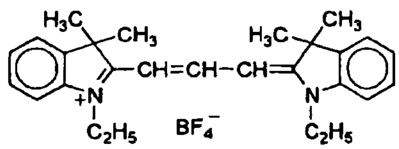

S-4

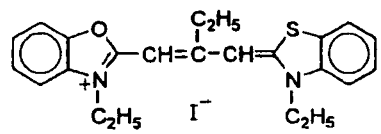

S-5

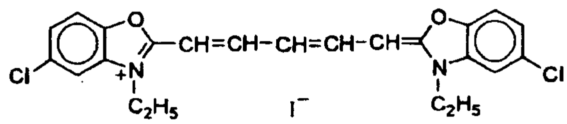

S-6

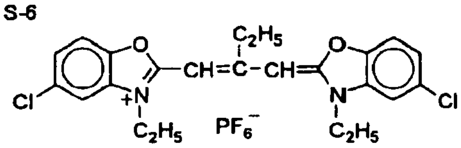

S-7

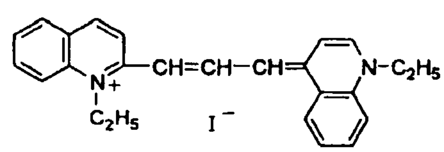

S-8

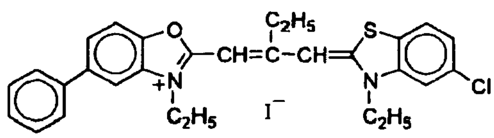

S-9

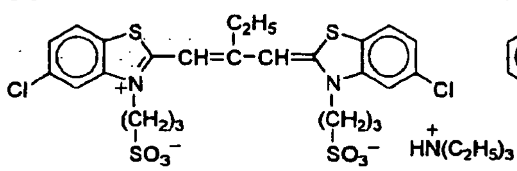

S-10

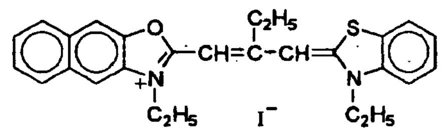

S-11

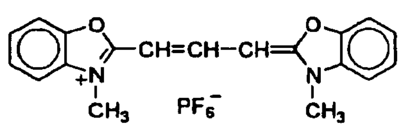

<Squarilium cyanine dye>

S-12

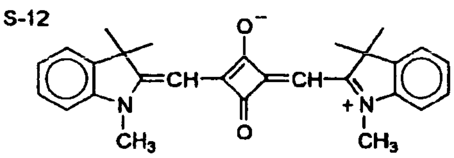

S-13

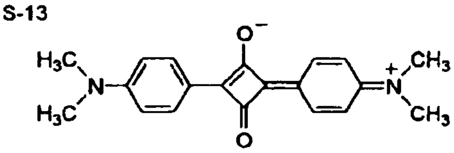

<Styryl dye>

S-14

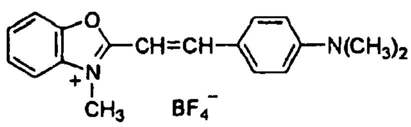

S-15

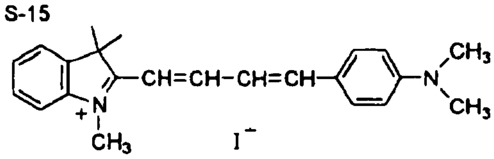

<Pyrilium dye>

S-16

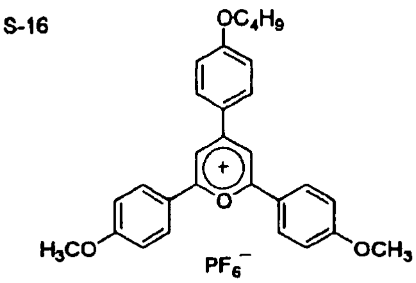

S-17

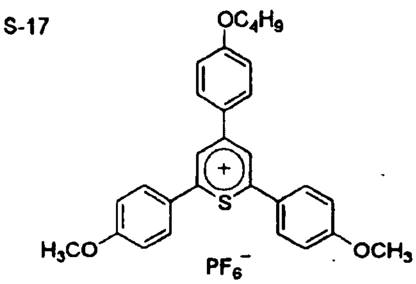

<Melocyanine dye>

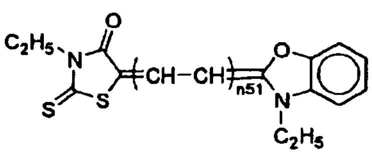

| | n51 |
|---|---|
| S-18 | 0 |
| S-19 | 1 |
| S-20 | 2 |

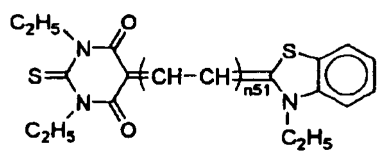

| | n51 |
|---|---|
| S-23 | 1 |
| S-24 | 2 |

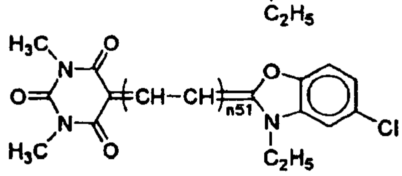

| | n51 |
|---|---|
| S-21 | 1 |
| S-22 | 2 |

$Q_{51}$=CH−CH=$Q_{52}$

| | $Q_{51}$ | $Q_{52}$ | | $Q_{51}$ | $Q_{52}$ |
|---|---|---|---|---|---|
| S-25 | 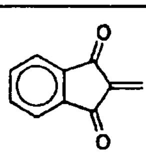 | 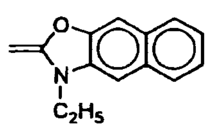 | S-26 | 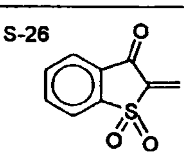 | 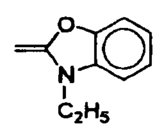 |
| S-27 | 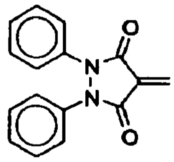 | 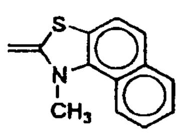 | S-28 | 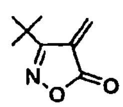 | 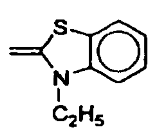 |
| S-29 | 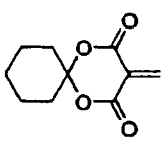 | 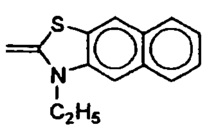 | | | |

<Melocyanine dye (continued)>

S-30

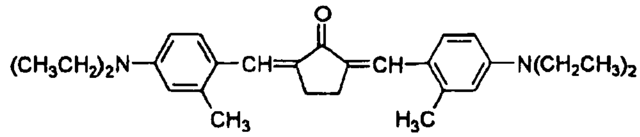

S-31

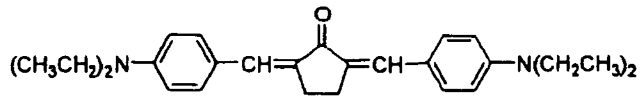

S-32

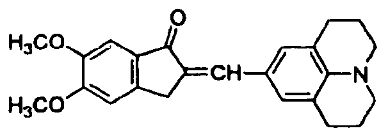

S-33

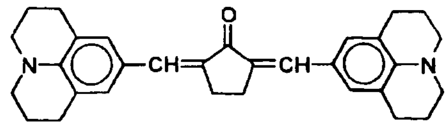

S-34

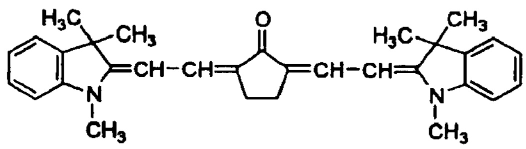

S-35

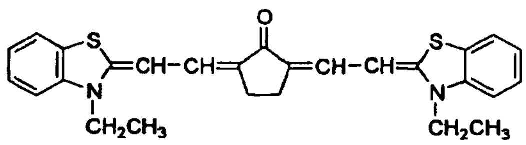

S-36

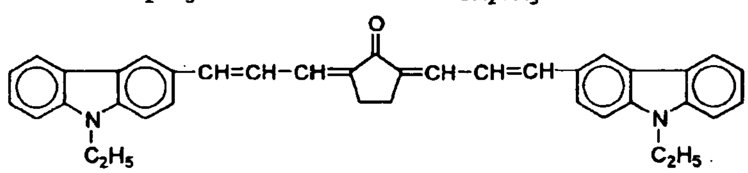

<Arylidene dye>

S-37

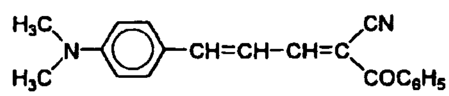

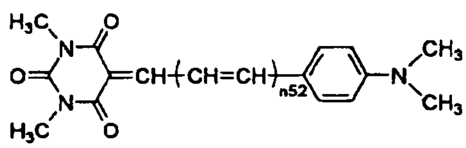

| | n52 |
|---|---|
| S-38 | 0 |
| S-39 | 1 |

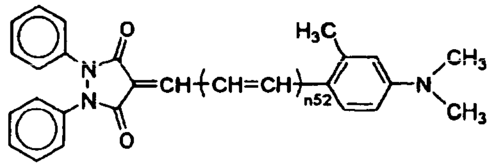

| | n52 |
|---|---|
| S-40 | 0 |
| S-41 | 1 |

<Oxonol dye>

$Q_{52}=CH-(CH=CH)_{n53}-Q_{53}$ Cl

| | $Q_{52}$ | $Q_{53}$ | $n_{53}$ | Cl |
|---|---|---|---|---|
| S-42 | 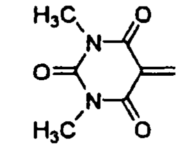 | 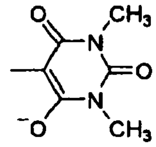 | 2 | $H^+$ |
| S-43 | 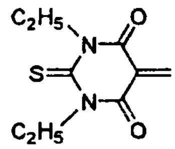 | 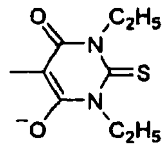 | 1 | 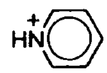 |
| S-44 | 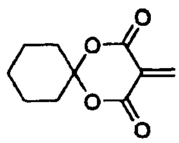 | 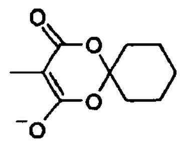 | 2 | $H^+$ |
| S-45 | 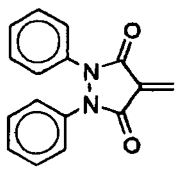 | 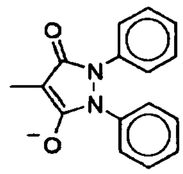 | 1 | $H^+$ |
| S-46 | 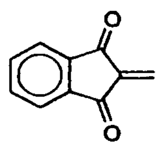 | 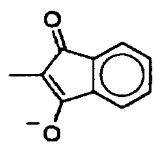 | 1 | $H\overset{+}{N}(C_2H_5)_3$ |

<Azlenium dye>

S-47

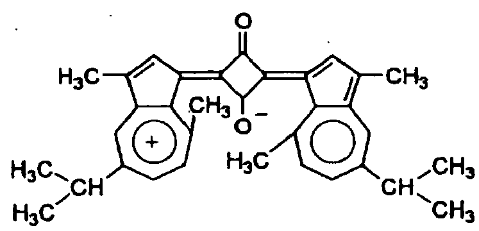

<Coumarine dye>

S-48

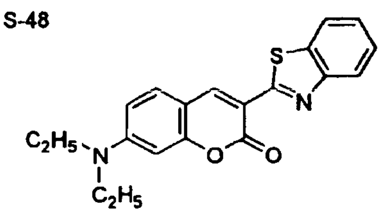

S-49

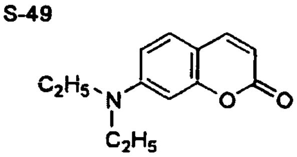

<Ketocoumarine dye>

S-50

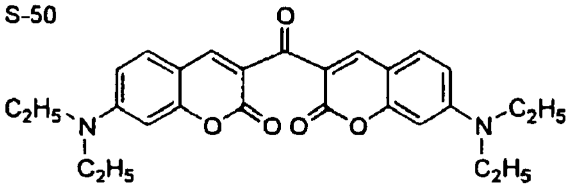

S-51

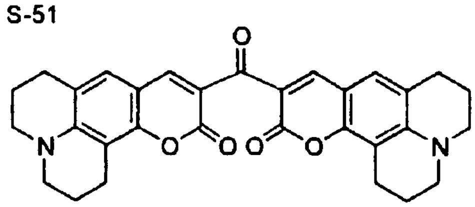

<Styrylcoumarine dye>

S-52

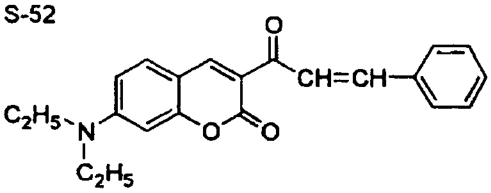

S-53

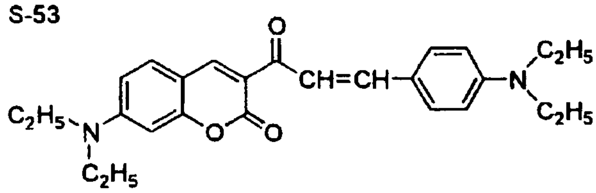

<Pyrane dye>

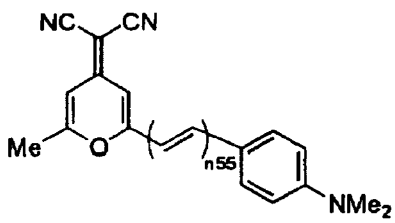

| | n55 |
|---|---|
| S-54 | 1 |
| S-55 | 2 |
| S-56 | 3 |

<Xanthene dye>

S-57

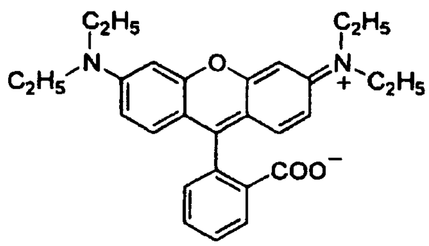

S-58

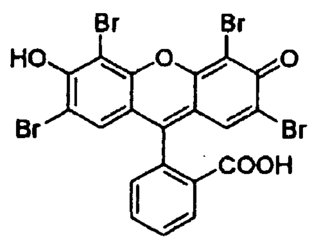

<Thioxanthene dye>

S-59

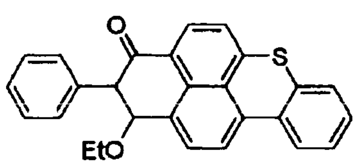

<Phenothiazine dye>

S-60

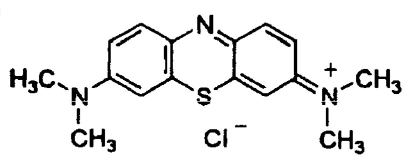

<Phenoxazine dye>

S-61

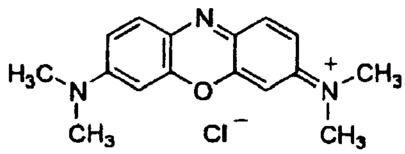

<Phenazine dye>

S-62

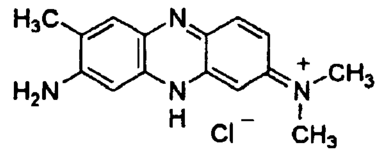

<Phthalocyanine dye>

S-63

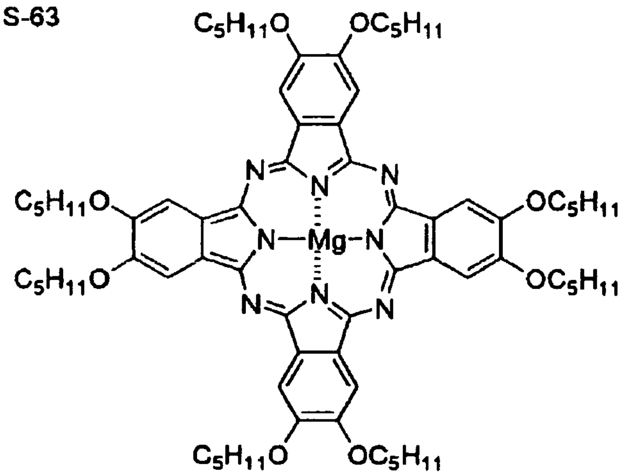

<Azaporphiline dye>

S-64

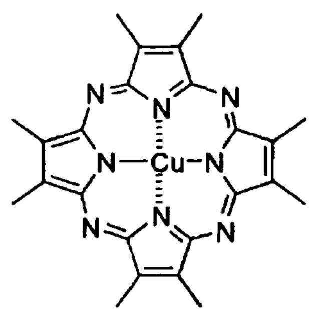

<Porphiline dye>

S-65

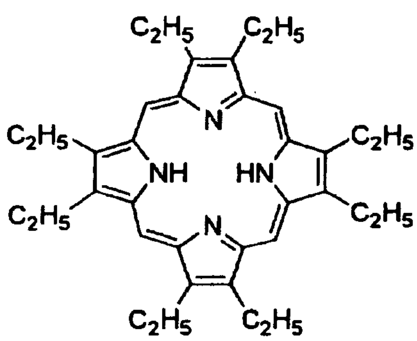

<Condensed aromatic dye>

S-66

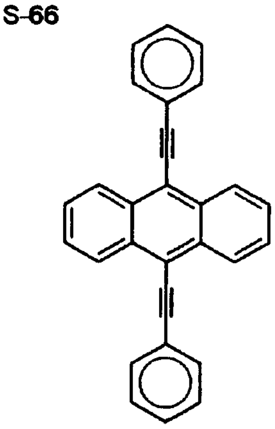

S-67

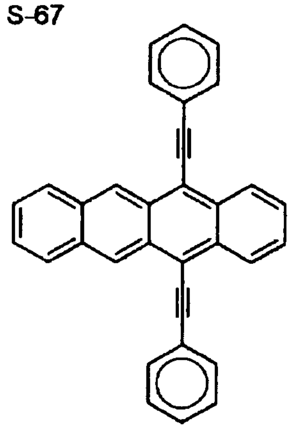

<Perylene dye>

S-68

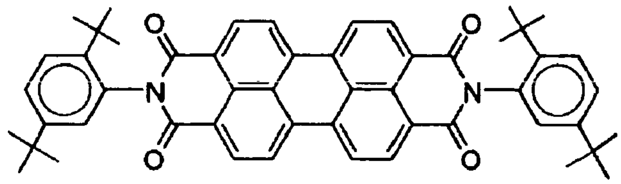

<Azomethine dye>

S-69

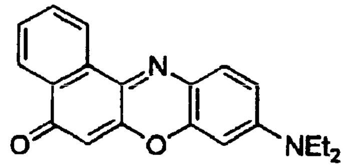

<Anthraquinone dye>

S-70

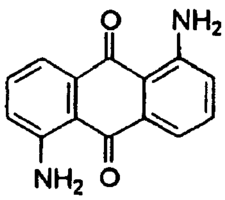

<Metal complex dye>

S-71

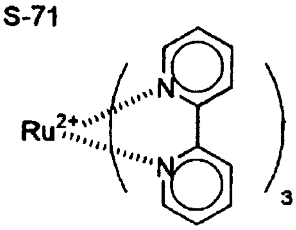

$(PF_6^-)_2$

S-72

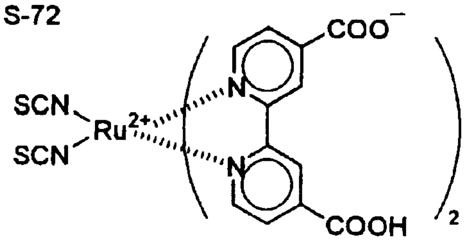

S-73

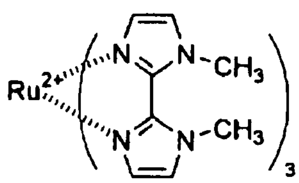

$(PF_6^-)_2$

S-74

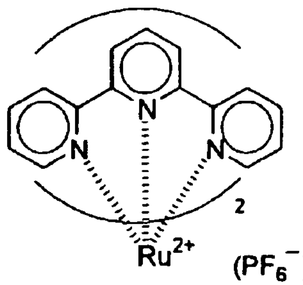

$(PF_6^-)_2$

S-75

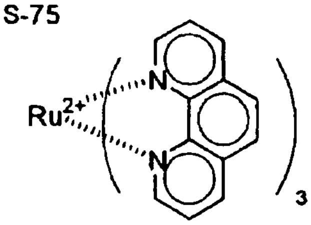

$(PF_6^-)_2$

S-76

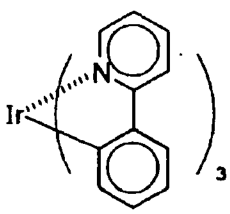

S-77

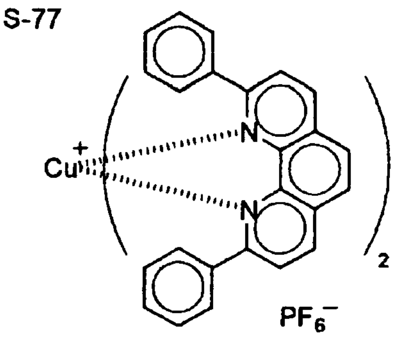

$PF_6^-$

S-78

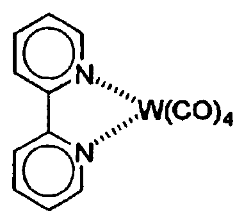

S-79

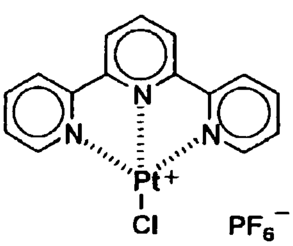

$PF_6^-$

S-80

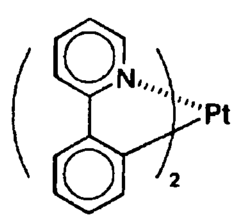

<Metalocene dye>

S-81

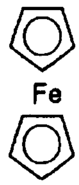

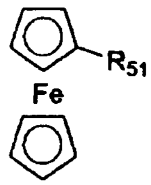

| | $R_{51}$ |
|---|---|
| S-82 | $-CHO$ |
| S-83 | $-CH_2CH_2COOH$ |
| S-84 | $-CH_2CH_2COOCH_3$ |
| S-85 | 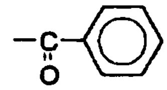 |
| S-86 | $-CH_2OH$ |
| S-87 | $-COOCH_3$ |

S-88

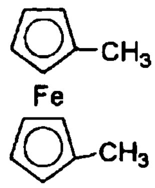

S-89

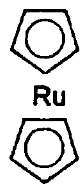

S-90

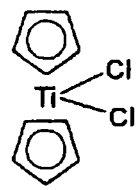

<Cyanine dye (continued)>

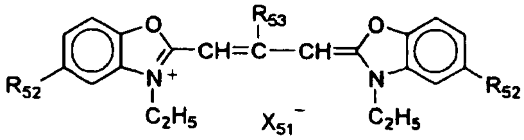

| | $R_{52}$ | $R_{53}$ | $X_{51}^-$ |
|---|---|---|---|
| S-91 | $-Cl$ | $-H$ | $I^-$ |
| S-92 | $-H$ | $-C_2H_5$ | $I^-$ |
| S-93 | $-H$ | $-H$ | $I^-$ |
| S-94 | $-H$ | $-H$ | $PF_6^-$ |
| S-95 | $-Br$ | $-H$ | $BF_4^-$ |
| S-96 | $-CH_3$ | $-H$ | $I^-$ |
| S-97 | $-OCH_3$ | $-C_2H_5$ | $PF_6^-$ |

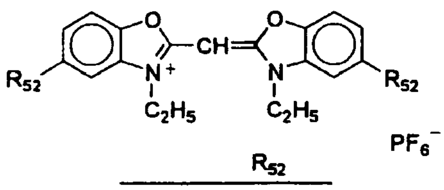

| | $R_{52}$ |
|---|---|
| S-98 | $-H$ |
| S-99 | $-Cl$ |
| S-100 | $-Ph$ |
| S-101 | $-CH_3$ |
| S-102 | $-OCH_3$ |

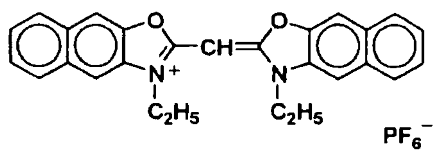

S-103

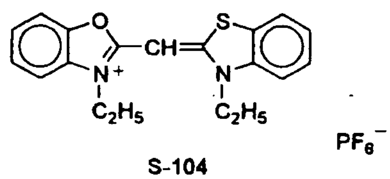

S-104

In the case where hologram recording is effected using frequency-doubled YAG laser beam of 532 nm, the sensitizing dye to be used is particularly preferably a trimethinecyanine dye having a benzoxazole ring, Ru complex dye or ferrocene. In the case hologram recording is effected using GaN laser beam or InGaN of 400 to 415 nm, the sensitizing dye to be used is particularly preferably a monomethinecyanine dye having a benzoxazole ring, Ru complex dye or ferrocene.

Other preferred examples of the sensitizing dye of the invention are disclosed in Japanese Patent Application No. 2004-238427. The sensitizing dye of the invention is commercially available or can be synthesized by any known method.

Preferred examples of the interference fringes- recording component include the following combinations. Specific preferred examples of these combinations include those described in Japanese Patent Application No. 2004-238077.

i) Combination of at least an acid-colorable dye precursor as dye precursor, an acid generator and optionally an acid proliferator
As the acid generator there may be used a diaryl iodonium salt, sulfonium salt or sulfonic acid ester, preferably the aforementioned acid generator (cationic polymerization initiator).
Preferred examples of the coloring material produced from the acid-colorable dye precursor include xanthene dyes, fluorane dyes, and triphenylmethane dyes. Particularly preferred examples of the acid-colorable dye precursor will be given below, but the invention is not limited thereto.

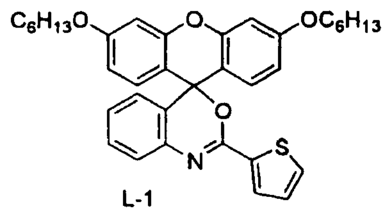

L-1

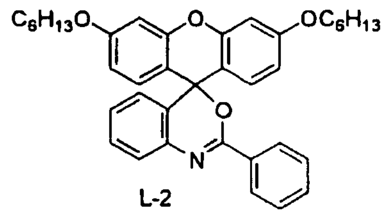

L-2

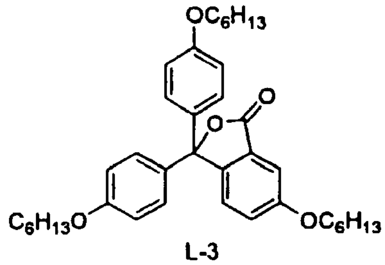

L-3

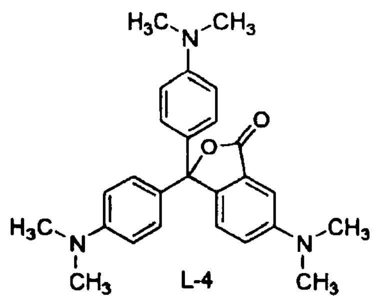

L-4

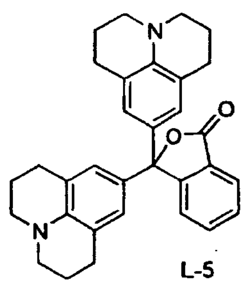

L-5

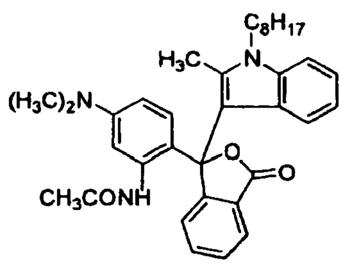

L-6

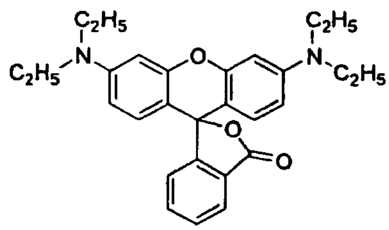

L-7

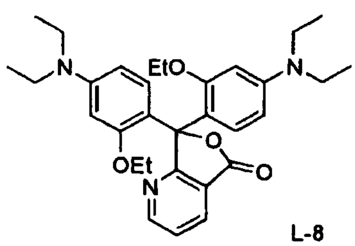

L-8

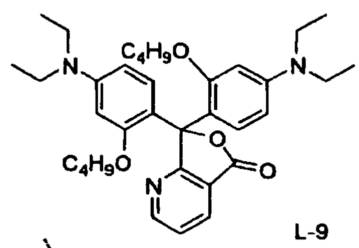

L-9

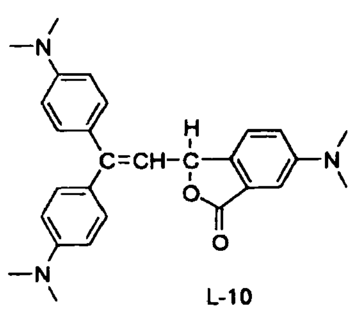

L-10

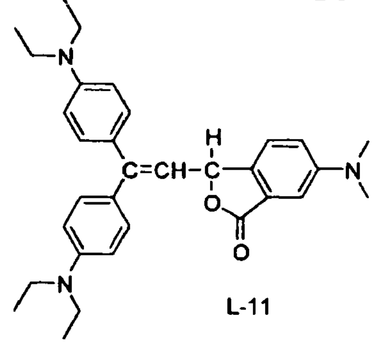

L-11

As the acid generation type dye precursor of the invention there is preferably used a cyanine base (leucocyanine dye) which develops color when an acid (proton) is added thereto. Specific preferred examples of the cyanine base will be given below, but the invention is not limited thereto.

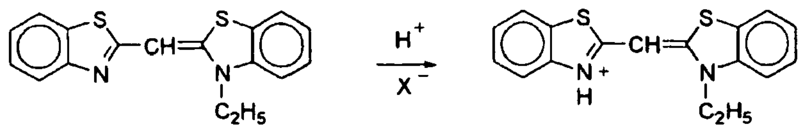


Cyanine base
(Leucocyanine dye), colorless

Cyanine dye (yellow)

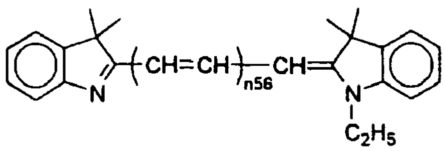

| | $n_{56}$ |
|---|---|
| LC-1 | 0 |
| LC-2 | 1 |
| LC-3 | 2 |

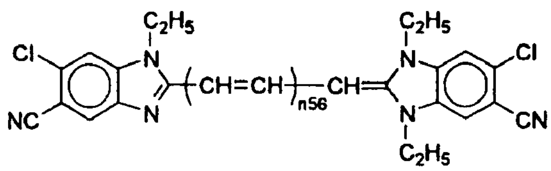

| | $n_{56}$ |
|---|---|
| LC-4 | 0 |
| LC-5 | 1 |
| LC-6 | 2 |

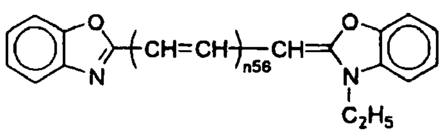

| | $n_{56}$ |
|---|---|
| LC-7 | 0 |
| LC-8 | 1 |

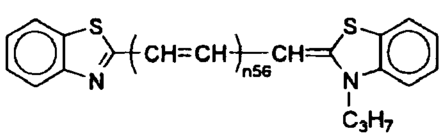

| | $n_{56}$ |
|---|---|
| LC-9 | 0 |
| LC-10 | 1 |

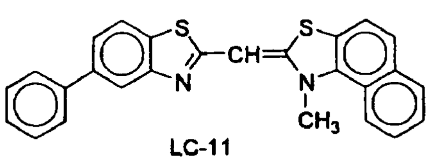

LC-11

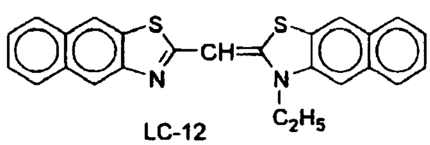

LC-12

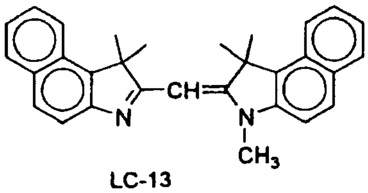

LC-13

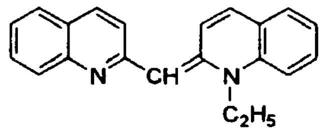

LC-14

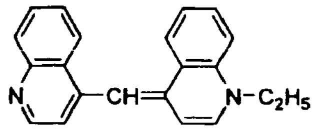

LC-15

ii) Combination of at least a base-colorable dye precursor as dye precursor, a base generator and optionally a base proliferator

As the base generator there is preferably used the aforementioned base generator (anionic polymerization initiator).

Examples of the base-colorable dye precursor include dissociative azo dyes, dissociative azomethine dyes, dissociative oxonol dyes, dissociative xanthene dyes, dissociative fluorane dyes and dissociative triphenylmethane dyes in undissociated form.

Particularly preferred examples of the base- colorable dye precursor will be given below, but the invention is not limited thereto.

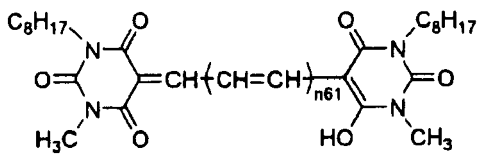

| | n61 |
|---|---|
| DD-1 | 1 |
| DD-2 | 2 |
| DD-3 | 3 |

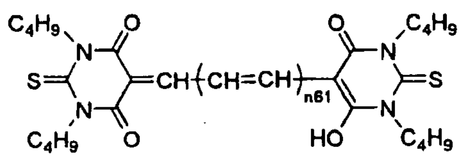

| | n61 |
|---|---|
| DD-4 | 0 |
| DD-5 | 1 |
| DD-6 | 2 |

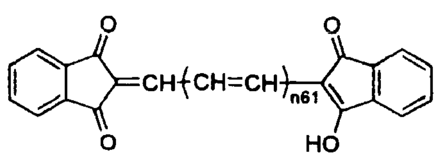

| | n61 |
|---|---|
| DD-7 | 0 |
| DD-8 | 1 |
| DD-9 | 2 |

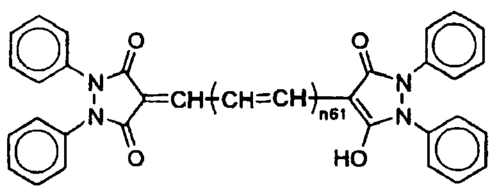

| | n61 |
|---|---|
| DD-10 | 0 |
| DD-11 | 2 |
| DD-12 | 3 |

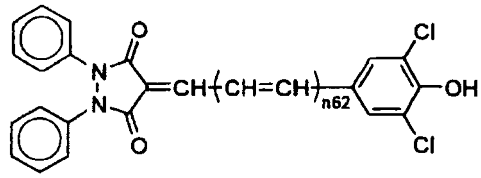

| | n62 |
|---|---|
| DD-13 | 0 |
| DD-14 | 1 |

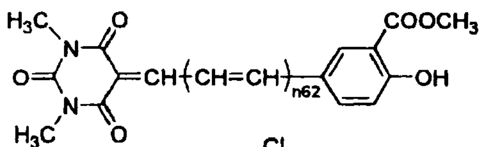

| | n62 |
|---|---|
| DD-15 | 0 |
| DD-16 | 1 |

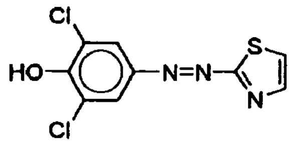

DD-17

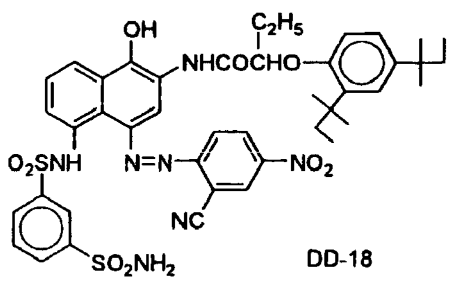

DD-18

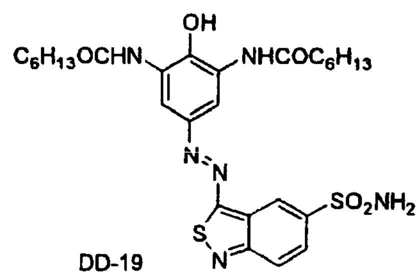

DD-19

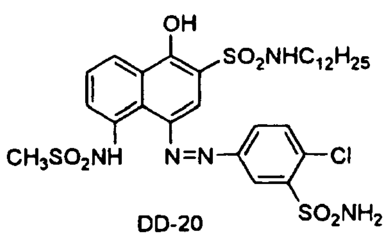

DD-20

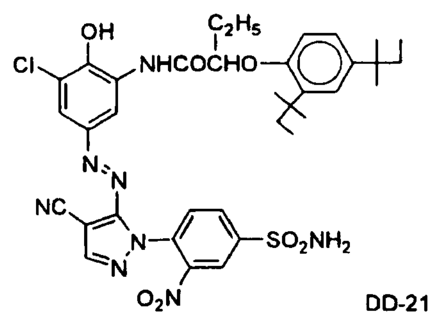

DD-21

DD-22

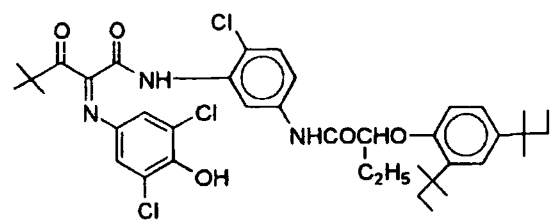

DD-23

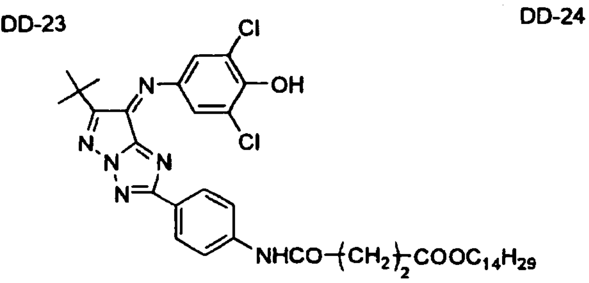

DD-24

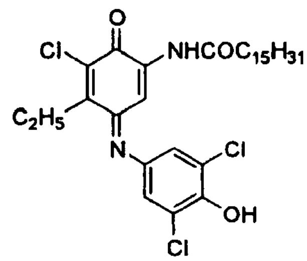

DD-25

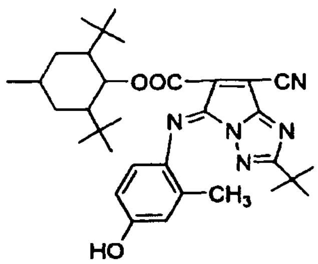

DD-26

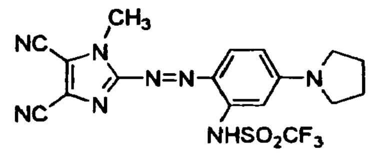

DD-27

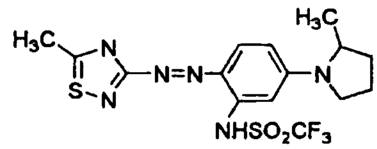

DD-28

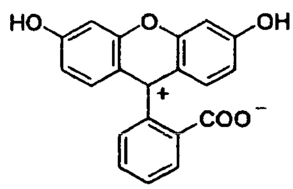

DD-29

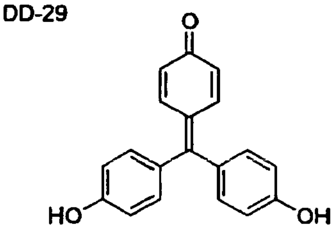

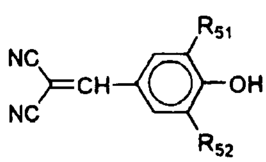

| | $R_{51}$ | $R_{52}$ |
|---|---|---|
| DD-30 | —H | —H |
| DD-31 | —Cl | —H |
| DD-32 | —Cl | —Cl |

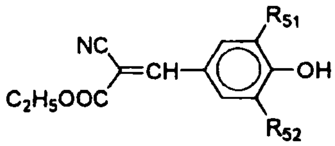

| | $R_{51}$ | $R_{52}$ |
|---|---|---|
| DD-33 | $-H$ | $-H$ |
| DD-34 | $-Cl$ | $-H$ |
| DD-35 | $-Cl$ | $-Cl$ |
| DD-36 | $-H$ | $-OCH_3$ |
| DD-37 | $-CH_3$ | $-CH_3$ |
| DD-38 | $-C_3H_7$-i | $-C_3H_7$-i |

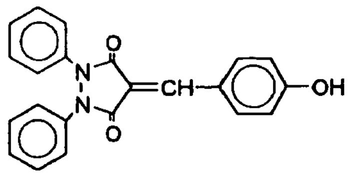

DD-39

iii) A compound having an organic compound moiety capable of severing covalent bond upon electron movement or energy movement from or to the excited state of the sensitizing dye and an organic compound moiety capable of forming a coloring material during covalent bonding and when released, which moieties being covalently bound, optionally combined with a base. Particularly preferred examples of such a combination will be given below, but the invention is not limited thereto.

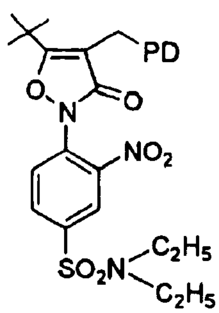

| | PD | | PD | | PD |
|---|---|---|---|---|---|
| E-1 | PD-1 | E-6 | PD-10 | E-11 | PD-19 |
| E-2 | PD-2 | E-7 | PD-12 | E-12 | PD-20 |
| E-3 | PD-22 | E-8 | PD-13 | E-13 | PD-24 |
| E-4 | PD-27 | E-9 | PD-16 | E-14 | PD-25 |
| E-5 | PD-8 | E-10 | PD-18 | E-15 | PD-29 |

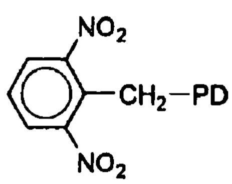

| | PD | | PD | | PD |
|---|---|---|---|---|---|
| E-16 | PD-22 | E-21 | PD-11 | E-26 | PD-20 |
| E-17 | PD-2 | E-22 | PD-14 | E-27 | PD-23 |
| E-18 | PD-27 | E-23 | PD-15 | E-28 | PD-25 |
| E-19 | PD-7 | E-24 | PD-17 | E-29 | PD-26 |
| E-20 | PD-8 | E-25 | PD-18 | E-30 | PD-29 |

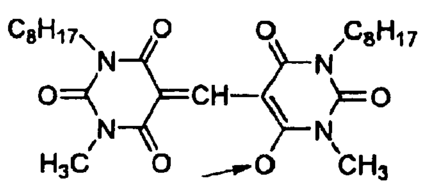

PD-1

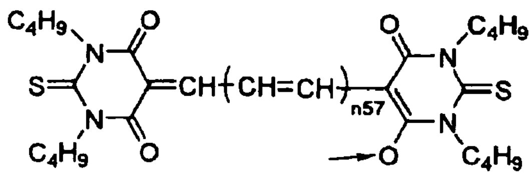

| | n57 |
|---|---|
| PD-2 | 0 |
| PD-3 | 1 |
| PD-4 | 2 |

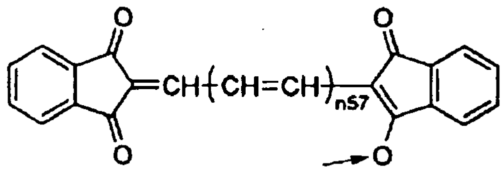

| | n57 |
|---|---|
| PD-5 | 0 |
| PD-6 | 2 |

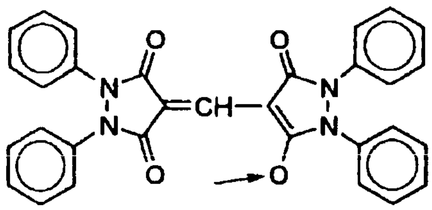

PD-7

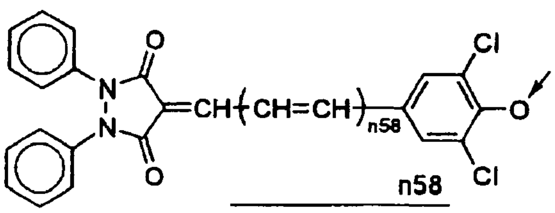

| | n58 |
|---|---|
| PD-8 | 0 |
| PD-9 | 1 |

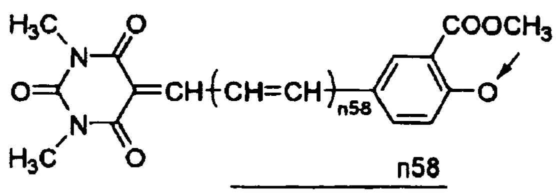

| | n58 |
|---|---|
| PD-10 | 0 |
| PD-11 | 1 |

PD-12

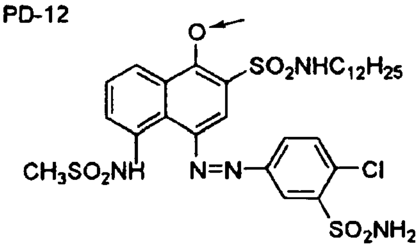

PD-13

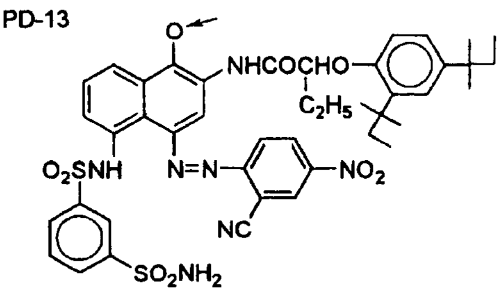

PD-14

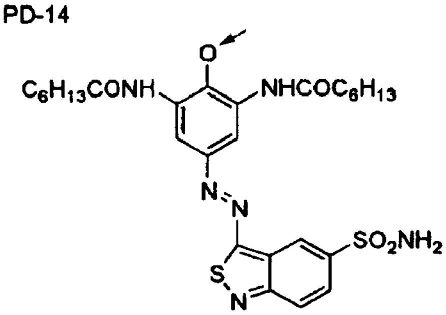

PD-15

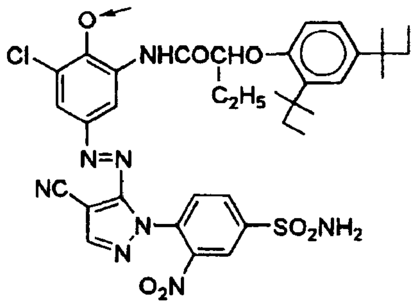

PD-16

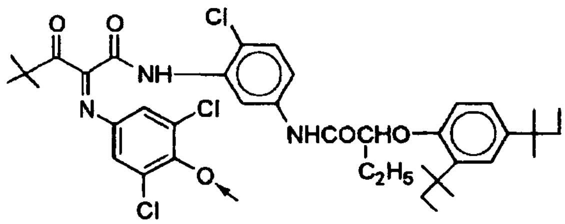

PD-17

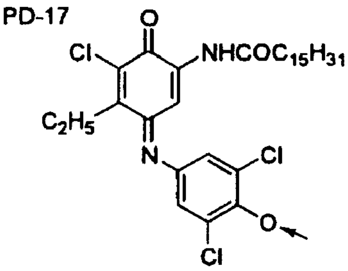

PD-18

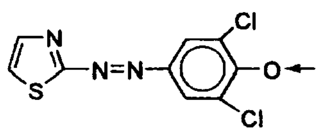

PD-19

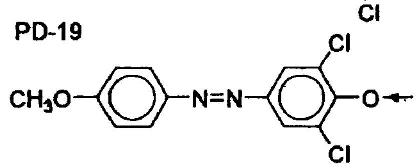

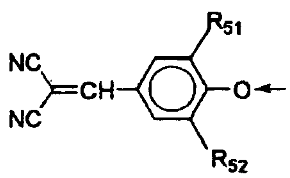

| | $R_{51}$ | $R_{52}$ |
|---|---|---|
| PD-20 | $-H$ | $-H$ |
| PD-21 | $-Cl$ | $-H$ |
| PD-22 | $-Cl$ | $-Cl$ |
| PD-23 | $-Cl$ | $-COOC_2H_5$ |
| PD-24 | $-Cl$ | $-CN$ |

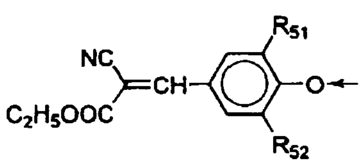

| | $R_{51}$ | $R_{52}$ |
|---|---|---|
| PD-25 | $-H$ | $-H$ |
| PD-26 | $-Cl$ | $-H$ |
| PD-27 | $-Cl$ | $-Cl$ |
| PD-28 | $-OCH_3$ | $-OCH_3$ |
| PD-29 | $-CH_3$ | $-CH_3$ |
| PD-30 | $-C_3H_7$-i | $-C_3H_7$-i |

iv) Compound capable of reacting upon electron movement from or to the excited state of the sensitizing dye to change absorption form. A so-called electrochromic compound is preferably used.

More preferably, a curable polymer (binder polymer) is incorporated. Examples of the binder polymer include those exemplified later with reference to 3) interference recording involving latent image color development-coloring material sensitized polymerization reaction, and those disclosed in Japanese Patent Application No. 2004-238077. Particularly preferred examples of the binder polymer include those exemplified below.

2) Recording of interference fringes by latent image color development-coloring material self-sensitized amplification color development reaction

This hologram recording method comprises at least a first step of forming a coloring material having no absorption at hologram reproducing light wavelength as a latent image by hologram exposure and a second step of irradiating the coloring material latent image with light having a wavelength different from hologram exposure wavelength at which the sensitizing dye exhibits a molar absorptivity of 5,000 or less to cause the self-sensitized amplification of the coloring material, whereby interference fringes is recorded as refractive index modulation, which steps being effected in a dry process. This hologram recording method is advantageous in high speed writing properties, high S/N ratio reproducibility, etc.
The term "latent image" as used herein is meant to indicate that the refractive index difference formed after the second step is preferably one second or less (that is, magnification or 2 or more is preferably effected at the second step), more preferably one fifth, even more preferably one tenth, most preferably one thirtieth (that is, magnification of 5 or more, more preferably 10 or more, most preferably 30 or more is effected at the second step).
The second step preferably involves either or both of the irradiation with light and the application of heat, more preferably the irradiation with light. The irradiation with light preferably involves entire exposure (so-called solid exposure, blanket exposure or non-imagewise exposure).
Preferred examples of the light source to be used herein include visible light laser, ultraviolet laser, infrared laser, carbon arc, high pressure mercury vapor lamp, xenon lamp, metal halide lamp, fluorescent lamp, tungsten lamp, LED, and organic EL. In order to irradiate the hologram recording material with light having a specific wavelength, a sharp cut filter, band pass filter, diffraction grating or the like is preferably used as necessary.
Further, the hologram recording material allowing the aforementioned hologram recording method preferably comprises at least:

1) a sensitizing dye which absorbs light upon hologram exposure to generate excited state; and

2) an interference fringes-recording component containing a dye precursor which can form a coloring material that has absorption at longer wavelength than in the original state and no absorption at hologram reproducing light wavelength, which interference fringes-recording component can undergo electron movement or energy movement from the excited state of the sensitizing dye or coloring material to cause color development leading to refractive index modulation by which interference fringes is recorded.

Preferred examples of the sensitizing dye and the interference fringes-recording component include those exemplified with reference to 1) color development reaction.
The light emitted at the second step preferably has a wavelength range at which the sensitizing dye exhibits a molar absorptivity of 1,000 or less, more preferably 500 or less.
Further, the light emitted at the second step preferably has a wavelength range at which the coloring material exhibits a molar absorptivity of preferably 1,000 or more.
The concept of "latent image color development -coloring material self-sensitized amplification color development reaction process" will be described hereinafter.
For example, the hologram recording material is irradiated with YAG·SHG laser beam having a wavelength of 532 nm so that the laser beam is absorbed by the sensitizing dye to generate excited state. Energy or electron is then moved from the the excited state of the sensitizing dye to the interference fringes-recording component to cause the dye precursor contained in the interference fringes-recording component to change to a coloring material, whereby a latent image is formed by color development (first step). Subsequently, the hologram recording material is irradiated with light having a wavelength of from 350 nm to 420 nm so that the light is absorbed by the coloring material which is then self-sensitized to cause the amplification thereof (second step). At the area which has become a dark interference area at the first step, there is produced little latent image. Therefore, little self-sensitized color development reaction occurs at the second step as well. As a result, a great refractive index modulation can be performed between the bright interference area and the dark interference area. The refractive index modulation can be recorded as interference fringes. For example, when the hologram recording material having data, image, etc. recorded thereon is again irradiated with a laser beam having a wavelength of 532 nm, the data, image, etc. can be reproduced.
Specific preferred examples of the latent image color development-coloring material self-sensitized amplification color development reaction include those exemplified in Japanese Patent Application No. 2004- 238427.

3) Recording of interference fringes by latent image color development-coloring material sensitized polymerization reaction

This hologram recording method preferably comprises at least a first step of forming a coloring material having no absorption at hologram reproducing light wavelength as a latent image by hologram exposure and a second step of irradiating the coloring material latent image with light having a wavelength different from hologram exposure wavelength to cause polymerization, whereby interference fringes is recorded as refractive index modulation, which steps being effected in a dry process. This hologram recording method is excellent in high speed writing properties, storage properties, etc.

It is also preferred that the polymerization be effected while causing self-sensitized amplification of coloring material at the second step.

Further, the hologram recording material allowing the aforementioned hologram recording method comprises at least:

1) a sensitizing dye which absorbs light upon hologram exposure to generate excited state at the first step;
2) an interference fringes-recording component containing a dye precursor which can form a coloring material that has absorption at longer wavelength than in the original state at which wavelength the sensitizing dye exhibits a molar absorptivity of 5,000 or less and no absorption at hologram reproducing light wavelength when electron or energy moves from the excited state of the sensitizing dye at the first step or from excited state of coloring material at the second step;
3) a polymerization initiator which can initiate the polymerization of a polymerizable compound when electron or energy moves from the excited state of the sensitizing dye at the first step and from excited state of coloring material at the second step;
4) a polymerizable compound; and
5) a binder.

Preferred examples of the sensitizing dye and the interference fringes-recording component include those exemplified with reference to 1) color development reaction.

Preferred examples of the polymerization initiator, the polymerizable compound and the binder will be further described hereinafter.

Referring to the interference fringes recording involving polymerization reaction, the binder preferably has a refractive index different from that of the polymerizable compound. In order to enhance the refractive index modulation, it is preferred that the refractive index difference between the polymerizable compound and the binder in bulky form be great, more preferably 0.01 or more, even more preferably 0.05 or more, particularly 0.1 or more.

To this end, it is preferred that one of the polymerizable compound or the binder contain at least one aryl group, aromatic heterocyclic group, chlorine atom, bromine atom, iodine atom and sulfur atom and the other be free of these groups or atoms. Either the polymerizable compound or the binder may have a greater refractive index than the other.

The term "polymerizable compound" as used herein is meant to indicate a compound which can undergo addition polymerization with a radical, acid (Bronsted acid or Lewis acid) or base (Bronsted base or Lewis base) generated when the sensitizing dye (or coloring material) or polymerization initiator with light to form an oligomer or polymer.

The polymerizable compound of the invention may be monofunctional or polyfunctional, may be of one-component system or multi-component system or may be a monomer, prepolymer (e.g., dimer, oligomer) or mixture thereof, preferably monomer.

The polymerizable compound may stay liquid or solid at room temperature but is preferably a liquid having a boiling point of 100˚C or more or a mixture of a liquid monomer having a boiling point of 100˚C or more and a solid monomer.

The polymerizable compound of the invention can be roughly divided into radical-polymerizable compound and cationically- or anioniocally-polymerizable compound.

Preferred examples of the radical-polymerizable compound and the cationically- or anioniocally- polymerizable compound will be described hereinafter in connection with the two groups: A) case where the refractive index of polymerizable compound is greater than that of binder and B) case where the refractive index of binder is greater than that of polymerizable compound.

A) Preferred examples of radical-polymerizable compound having a greater refractive index than binder

In this case, the radical-polymerizable compound preferably has a high refractive index. The high refractive index radical-polymerizable compound of the invention is preferably a compound having at least one ethylenically-unsaturated double bond per molecule and at least one aryl group, aromatic heterocyclic group, chlorine atom, bromine atom, iodine atom or sulfur atom per molecule, more preferably a liquid having a boiling point of 100˚C or more.

Specific examples of the radical-polymerizable compound include the following monomers and prepolymers (dimer, oligomer) comprising these polymerizable monomers.

Preferred examples of the high refractive index radical-polymerizable monomer include styrene, 2-chlorostyrene, 2-bromostyrene, methoxystyrene, phenyl acrylate, p-chlorophenyl acrylate, 2-phenylethyl acrylate, 2-phenoxyethyl acrylate, 2-phenoxyethyl methacrylate, 2-(p-chlorophenoxy)ethyl acrylate, benzyl acrylate, 2-(1-naphthyloxy)ethyl acrylate, 2,2-di(p-hydroxyphenyl)propane diacrylate, 2,2-di(p-hydroxyphenyl)propane dimethacrylate, di(2-methacryloxyethyl)ether of bisphenol A, di(2-acryloxy ethyl)ether of bisphenol A, di(2-methacryloxy)ether of tetrachloro-bisphenol A, di(2-methacryloxy)ether of tetrabromo-bisphenol A, 1,4-benzenediol dimethacrylate, and 1,4-diisopropenylbenzene. Even more desirable among these compounds are 2-phenoxyethyl acrylate, 2-phenoxyethyl methacrylate, 2-(p-chlorophenoxy)ethyl acrylate, p-chlorophenyl acrylate, phenyl acrylate, 2- phenylethyl acrylate, di(2-acryloxyethyl)ether of bisphenol A, and 2-(1-naphthyloxy)ethyl acrylate.

The preferred polymerizable compound is a liquid but may be used in admixture with a second solid polymerizable compound such as N-vinylcarbazole, 2- naphthyl acrylate, pentachlorophenyl acryate, 2,4,6- tribromophenyl acrylate, disphenol A diacrylate, 2-(2-naphthyloxy)ethyl and N-phenylmaleimide.

B) Preferred examples of radical-polymerizable compound having a smaller refractive index than binder

In this case, the radical-polymerizable compound preferably has a low refractive index. The low refractive index radical-polymerizable compound of the invention preferably has at least one ethylenically-unsaturated double bond per molecule but is free of aryl group, aromatic heterocyclic group, chlorine atom, bromine atom, iodine atom and sulfur atom.

The radical-polymerizable compound of the invention is preferably a liquid having a boiling point of 100˚C or more.

Specific examples of the radical-polymerizable compound of the invention include the following polymerizable monomers and prepolymers (dimer, oligomer, etc.) comprising these polymerizable monomers.

Preferred examples of the low refractive index radical-polymerizable compound employable herein include t-butyl acrylate, cyclohexyl acrylate, isobornyl acrylate, 1,5-pentanediol diacrylate, ethylene glycol diacrylate, 1,4-butanediol diacrylate, diethylene glycol diacrylate, hexamethylene glycol diacrylate, 1,3-propanediol diacrylate, decamethylene glycol diacrylate, 1,4-cyclohexyldiol diacrylate, 2,2-dimethylolpropane diacrylate, glycerol diacrylate, trimethylolpropane diacrylate, pentaerythritol triacrylate, pentaerythritol tetraacrylate, triethylene glycol diacrylate, triethylene glycol dimethacrylate, ethylene glycol dimethacrylate, 1,3- propanediol dimethacrylate, 1,2,4-butanetriol trimethacrylate, 2,2,4-trimethyl-1,3-propanediol dimethacrylate, pentaerythritol trimethacrylate, pentaerythritol tetramethacrylate, trimethylolpropane trimethacrylate, 1,5-pentanediol dimethacrylate, diallyl fumarate, 1H,1H-perfluorooctyl acrylate, 1H,1H, 2H,2H-perfluorooctyl methacrylate, 1H,1H, 2H,2H-perfluorooctyl acrylate, and 1-vinyl-2- pyrrolidone. More desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, triacrylate ester of ethoxylated trimethylopropane, and 1-vinyl-2-pyrrolidine. Even more desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, 1H,1H-perfluorooctyl acrylate, 1H,1H,2H,2H-perfluorooctyl methacrylate, 1H,1H, 2H,2H-perfluorooctyl acrylate, and 1-vinyl-2-pyrrolidone.

The preferred polymerizable compound is a liquid but may be used in admixture with a second solid polymerizable compound monomer such as N- vinylcaprolactam.

The term "cationically-polymerizable compound" as used herein is meant to indicate a compound which begins polymerization with an acid generated when the sensitizing dye and the cation polymerization initiator are irradiated with light. The term "anionically- polymerizable compound" as used herein is meant to indicate a compound which begins polymerization with a base generated when the sensitizing dye and the anion polymerization initiator are irradiated with light.

The cationically-polymerizable compound of the invention is preferably a compound having at least one oxirane ring, oxethanone ring, vinylether group or N- vinylcarbazole moiety, more preferably N- vinylcarbazole moiety per molecule.

The anionically-polymerizable compound of the invention is preferably a compound having at least one oxirane ring, oxethanone ring, vinylether group, N-vinyl carbazole moiety, ethylenic double bond moiety provided with an electrophilic substituent, lactone moiety, lactam moiety, cyclic urethane moiety, cyclic urea moiety or cyclic siloxane moiety per molecule, more preferably oxirane ring moiety.

A) Preferred examples of cationically- or anionically- polymerizable compound having a greater refractive index than binder

In this case, the cationically- or anionically- polymerizable compound preferably has a high refractive index.

The high refractive index cationically- or anionically-polymerizable compound of the invention is preferably a compound having at least one oxirane ring, oxethanone ring, vinylether group, styryl group or N-vinylcarbazole moiety per molecule and at least aryl group, aromatic heterocyclic group, chlorine atom, bromine atom, iodine atom or sulfur atom per molecule, more preferably at least one aryl group. The cationically- or anionically- polymerizable compound of the invention is preferably a liquid having a boiling point of 100˚C or more.

Specific examples of the cationically- or anionically-polymerizable compound of the invention include the following polymerizable monomers and prepolymers (dimer, oligomer, etc.) comprising these polymerizable monomers.

Preferred examples of the high refractive index cationically- or anionically-polymerizable monomers having oxirane ring include phenylglycidyl ether, phthalic acid diglycidyl ester, trimellitic acid triglycidyl ester, resorcine diglycidyl ether, dibromophenyl glycidyl ether, dibromoneopentyl glycol diglycidyl ether, 4,4'-bis(2,3-epoxypropoxyperfluoro isopropyl)diphenyl ether, p-bromostyrene oxide, bisphenol-A-diglycidyl ether, tetrabromobisphenol-A- diglycidyl ether, bisphenol-F-diglycidyl ether, and 1,3-bis(3',4'-epoxycyclohexyl)ethyl)-1,3,-diphenyl-1,3,-dimethyldisiloxane.

Specific examples of the high refractive index cation or anionically-polymerizable monomer having oxethanone ring include compounds obtained by replacing the oxirane ring in the specific examples of the high refractive index cation or anionically-polymerizable monomer having oxirane ring by oxethanone ring.

Specific examples of the high refractive index cationically- or anionically-polymerizable monomer having vinylether group moiety include vinyl-2- chloroethyl ether, 4-vinyletherstyrene, hydroquinone divinyl ether, phenylvinyl ether, bisphenol A divinyl ether, tetrabromobisphenol A divinyl ether, bisphenol F divinyl ether, phenoxyethylenevinyl ether, and p-bromophenoxyethylenevinyl ether.

In addition, styrene monomers such as styrene, 2-chlorostyrene, 2-bromostyrene, and methoxystyrene, and N-vinyl carbazole are also preferred as the high refractive index cationically polymerizable monomer.

B) Preferred examples of cationically- or anionically- polymerizable compound having a smaller refractive index than binder

In this case, the cationically- or anionically- polymerizable compound preferably has a low refractive index. The low refractive index cationically- or anionically-polymerizable compound of the invention is preferably a compound having at least one oxirane ring, oxethanone ring, vinylether group or N-vinylcarbazole moiety per molecule but free of aryl group, aromatic heterocyclic group, chlorine atom, bromine atom, iodine atom and sulfur atom. The cationically- or anionically-polymerizable compound of the invention is preferably a liquid having a boiling point of 100˚C or more.

Specific examples of the cationically- or anionically-polymerizable compound of the invention include the following polymerizable monomers and prepolymers (dimer, oligomer, etc.) comprising these polymerizable monomers.

Specific examples of the low refractive index cationically- or anionically-polymerizable monomer having oxirane ring include glyceroldiglycidyl ether, glyceroltriglycidyl ether, pentaerythritol polyglycidyl ether, trimethylolpropanetriglycidyl ether, 1,6-hexanediolglycidyl ether, ethylene glycol diglycidyl ether, ethylene glycol monoglycidyl ether, propylene glycol diglycidyl ether, neopentyl glycol diglycidyl ether, adipic acid diglycidyl ester, 1,2,7,8- diepoxyoctane, 1,6-dimethylolperfluorohexane diglycidyl ether, vinyl cyclohexene dioxide, 3,4-epoxycyclohexylmethyl-3',4'-epoxycyclohexane carboxylate, 3,4-epoxycyclohexyloxirane, bis(3,4-epoxycyclohexyl)adipate, 2,2-bis(4-(2,3-epoxypropoxy) cyclohexyl)hexafluoropropane, 2-(3,4-epoxycyclohexyl) -3',4'-epoxy-1,3-dioxane-5-spirocyclohexane, 1,2-ethylenedioxy-bis(3,4-epoxycyclohexylmethane), ethyleneglycol-bis(3,4-epoxycyclohexanecarboxylate), bis-(3,4-epoxycyclohexylmethyl)adipate, di-2,3- epoxycyclopentyl ether, vinyl glycidyl ether, allyl glycidyl ether, 2-ethylhexyl glycidyl ether, and 1,3-bis(3',4'-epoxycyclohexyl)ethyl)-1,1,3,3-tetramethyldisiloxane.

Specific examples of the low refractive index cationically- or anionically-polymerizable monomer having oxathanone ring include compounds obtained by replacing the oxirane ring in the aforementioned specific examples of low refractive index cationically- or anionically-polymerizable monomer having oxirane ring by oxethanone ring.

Specific examples of the low refractive index cationically- or anionically-polymerizable monomer having vinylether group moiety include vinyl-n- butylether, vinyl-t-butylether, ethylene glycol divinyl ether, ethylene glycol monovinyl ether, propylene glycol divinyl ether, neopentyl glycol divinyl glycol, glycerol divinyl ether, glycerol trivinyl ether, triethylene glycol divinyl ether, trimethylol propane monovinyl ether, trimethylol propane divinyl ether, trimethylol propane trivinyl ether, allyl vinyl ether, 2,2- bis(4-cyclohexanol)propanol divinyl ether, and 2,2-bis(4-cyclohexanol)trifluoropropane divinyl ether.

Specific preferred examples of the binder to be used in recording of interference fringes by polymerization reaction will be described hereinafter in connection with the two groups: A) case where the refractive index of polymerizable compound is greater than that of binder and B) case where the refractive index of binder is greater than that of polymerizable compound.

A) Preferred examples of binder having a smaller refractive index than polymerizable compound

In this case, the binder preferably has a low refractive index. The binder of the invention is preferably a binder free of aryl group, aromatic heterocyclic group, chlorine atom, bromine atom, iodine atom and sulfur atom.

Specific preferred examples of the low refractive index binder include acrylates, $\alpha$-alkyl acrylates, acidic polymers, interpolymers (e.g., polymethacrylic acid methyl, polymethacrylic acid ethyl, copolymer of methyl methacylate with other (meth)acrylic acid akylesters), polyvinylesters (e.g., polyvinyl acetate, polyacetic acid/acrylic acid vinyl, polyacetic acid/ methacrylic acid vinyl, hydrolyzable polyvinyl acetate), ethylene/vinyl acetate copolymers, saturated and unsaturated polyurethanes, butadiene polymers and copolymers, isoprene polymers and copolymers, high molecular polyethylene oxides of polyglycol having an average molecular weight of from about 4,000 to 1,000,000, epoxy compounds (e.g., epoxylated compounds having acrylate or methacrylate), polyamides (e.g., N-methoxy methylpolyhexamethylene adipamide), cellulose esters (e.g., cellulose acetate, cellulose acetate succinate, cellulose acetate butyrate), cellulose ethers (e.g., methyl cellulose, ethyl cellulose, ethylbenzeyl cellulose), polycarbonates, polyvinyl acetals (e.g., polyvinyl butyral, polyvinyl formal), polyvinyl alcohols, and polyvinyl pyrrolidones.

Further preferred examples of the low refractive index binder include fluorine atom-containing polymers. A preferred example of the fluorine atom-containing polymers is an organic solvent-soluble polymer comprising a fluoroolefin as an essential component and one or more unsaturated monomers selected from the group consisting of alkylvinyl ether, alicyclic vinyl ether, hydroxyvinyl ether, olefin, haloolefin, unsaturated carboxylic acid, ester thereof and carboxylic acid vinyl ester as copolymerizable components. The fluorine atom- containing polymer preferably has a weight-average molecular weight of from 5,000 to 200,000 and a fluorine atom content of from 5 to 70% by weight.

Specific examples of the aforementioned fluorine atom-containing polymer include Lumiflon Series (e.g., Lumiflon LF200; weight-average molecular weight: approx. 50,000, produced by Asahi Glass Co., Ltd.), which are organic solvent-soluble fluorine atom-containing polymers having hydroxyl group. Besides these products, organic solvent-soluble fluorine atom-containing polymers have been marketed by DAIKIN INDUSTRIES, LTD., Central Glass Co., Ltd., Penwalt Corp., etc. These products, too, can be used.

Further preferred examples of the fluorine atom- containing polymer include silicon compounds such as pioly (dimethylsiloxane) and silicon oil free of aromatic group.

Besides the aforementioned compounds, epoxy oligomer compounds free of aromatic groups can be used as low refractive index reactive binders.

B) Preferred examples of binder having a greater refractive index than polymerizable compound

In this case, the binder preferably has a high refractive index. The binder of the invention is preferably a binder containing at least one aryl group, aromatic heterocyclic group, chlorine atom, bromine atom, iodine atom or sulfur atom, more preferably aryl group.

Specific preferred examples of the high refractive index binder include polystyrene polymers, acrylonitrile, maleic anhydride, acrylic acid, methacrylic acid, methacrylic acid ester copolymer, vinylidene chloride copolymer (e.g., vinylidene chloride/acrylonitrile copolymer, vinylidene chloride/methacrylate copolymer, vinylidene/vinyl acetate copolymer), polyvinyl chloride copolymer (e.g., polyvinyl chloride/acetate, vinyl chloride/ acrylonitrile copolymer), polyvinyl benzal synthetic rubber (e.g., butadiene/acrylonitrile copolymer, acrylonitrile/butadiene/styrene copolymer, methacrylate/acrylonitrile/butadiene/styrene copolymer, 2-chlorobutadiene-1,3-polymer, chlorinated rubber, styrene/butadiene/ styrene, styrene/isoprene/ styrene block copolymer), polymethylene glycol of copolyester (represented, e.g., by the general formula $HO(CH_2)_nOH$ (in which n is an integer of from 2 to 10), those produced from the reaction product of (1) hexahydroterephthalic acid, sebacic acid and terephthalic acid, (2) terephthalic acid, isophthalic acid and sebacic acid, (3) terephthalic acid and sebacic acid, (4) terephthalic acid and isophthalic acid, (5) the glycol and mixture of copolyesters produced from (i) terephthalic acid, isophthalic acid and sebacic acid and (ii) terephthalic acid, isophthalic acid, sebacic acid and adipic acid, poly-N-vinylcarbazole, copolymer thereof, and polycarbonate made of carboxylic acid ester and bisphenol.

Further preferred examples of the high refractive index binder include silicon compounds such as poly (methylphenylsiloxane) and 1,3,5-trimethyl-1,1,3,5,5- pentaphenyltrisiloxane and silicon oil containing much aromatic groups.

Besides these compounds, epoxy oligomer compounds containing much aromatic groups can be used as high refractive index reactive binder.

Preferred examples of the polymerization initiator to be used in interference fringes recording involving polymerization reaction of the invention include ketone-based, organic peroxide-based, trihalomethyl-substituted triazine-based, diazonium salt-based, diaryl iodonium salt-based, sulfonium salt- based, borate-based, diaryl iodonium-organic boron complex-based, sulfonium-organic boron complex-based, cationic sensitizing dye-organic boron complex-based, anionic sensitizing dye-onium salt complex-based, metal -allene complex-based and sulfonic acid ester-based radical polymerization initiators (radical generators), cationic polymerization initiators (acid generators) and radical polymerization-cationic polymerization initiators.

An acid proliferator is preferably used to enhance sensitivity. Preferred examples of the acid proliferator employable herein include those exemplified in Japanese Patent Application No. 2003-182849.

Further, anionic polymerization and an anionic polymerization initiator (base generator) are preferably used. Moreover, in this case, a base proliferator is preferably used to enhance sensitivity. Specific preferred examples of the anionic polymerization initiator and the base proliferator include those exemplified in Japanese Patent Application No. 2003-178083.

Specific preferred examples of polymerization initiators, polymerizable compounds and binders include those exemplified in Japanese Patent Application No. 2004-238932.

Specific preferred examples of the polymerization initiator of the invention will be given below, but the invention is not limited thereto.

<Radical polymerization initiator (radical generator), cationic polymerization initiator (acid generator)>

I-1

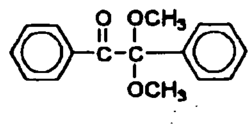

I-2

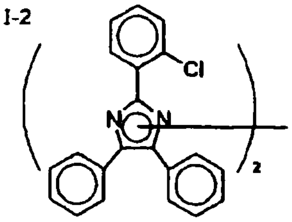

I-3

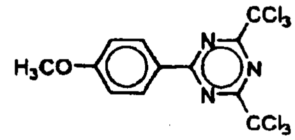

I-4

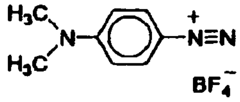

I-5

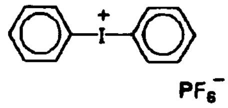

I-6

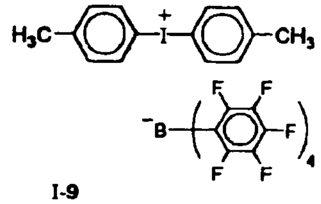

I-7

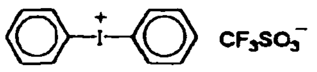

I-8

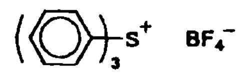

I-9

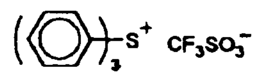

I-10

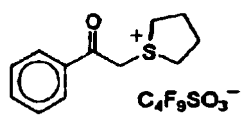

I-11

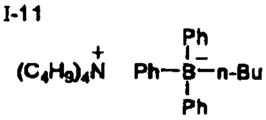

I-12

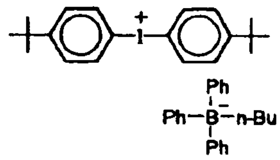

I-13

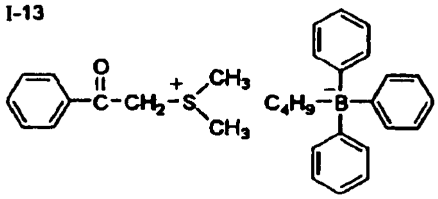

I-14

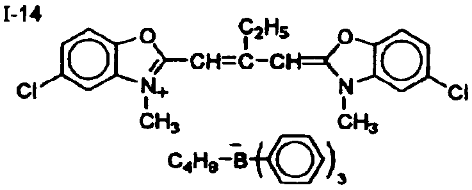

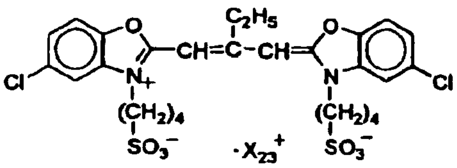

| | $X_{23}^{+}$ | |
|---|---|---|
| I-15 | 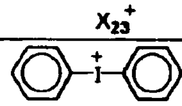 | (=C-1) |
| I-16 | 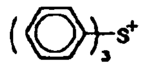 | (=C-2) |
| I-17 | 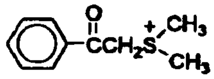 | (=C-3) |

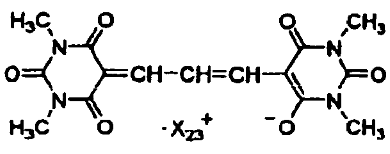

| | $X_{23}^{+}$ |
|---|---|
| I-18 | C-1 |
| I-19 | C-2 |
| I-20 | C-3 |

I-21

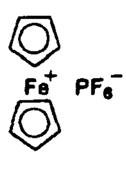

I-22

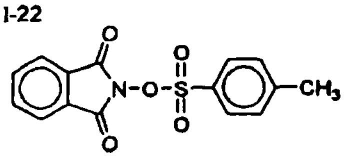

I-23

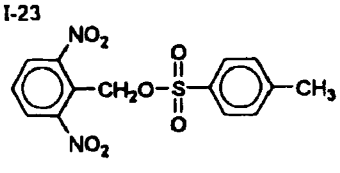

Anionic polymerization initiator (base generator)

PB-1

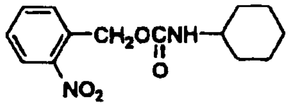

PB-2

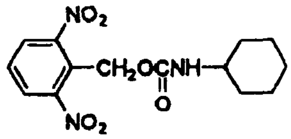

PB-3

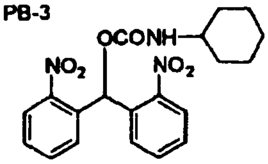

PB-4

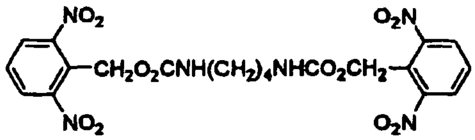

PB-5

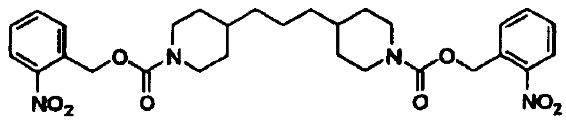

PB-6

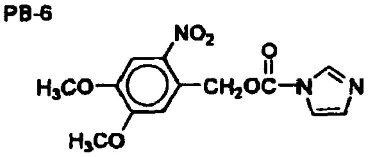

PB-7

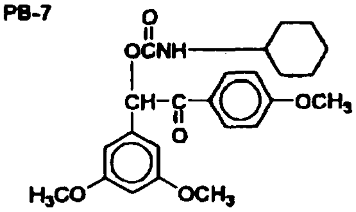

PB-8

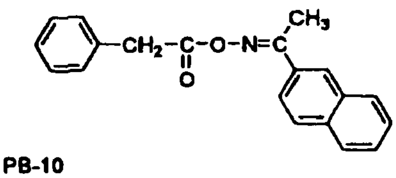

PB-9

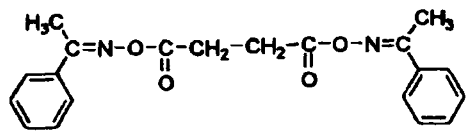

PB-10

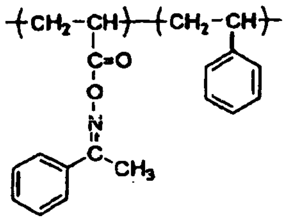

PB-11

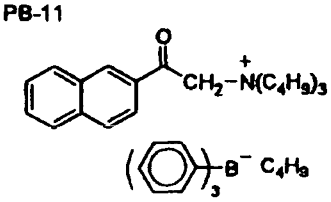

PB-12

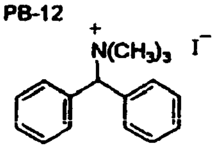

The light emitted at the second step preferably has a wavelength range at which the sensitizing dye exhibits a molar absorptivity of 1,000 or less, more preferably 500 or less.

Further, the light emitted at the second step preferably has a wavelength range at which the coloring material exhibits a molar absorptivity of preferably 1,000 or more.

In the hologram recording material, it is preferred from the standpoint of storage properties and non-destructive reproducibility that the sensitizing dye be decomposed and fixed at the first, the second step or the subsequent fixing step involving either or both of irradiation with light and application of heat. It is more preferred that the sensitizing dye be decomposed and fixed at the first step, the second step or the subsequent fixing step involving either or both of irradiation with light and application of heat and the coloring material be decomposed and fixed at the second step or the subsequent fixing step involving either or both of irradiation with light and application of heat.

The concept of "latent image color development- coloring material sensitized polymerization reaction process" will be described hereinafter.

For example, the hologram recording material is irradiated with YAG SHG laser beam having a wavelength of 532 nm so that the laser beam is absorbed by the sensitizing dye to generate excited state. Energy or electron is then moved from the the excited state of the sensitizing dye to the interference fringes-recording component to cause the dye precursor contained in the interference fringes-recording component to change to a coloring material, whereby a

latent image is formed by color development (first step). Subsequently, the hologram recording material is irradiated with light having a wavelength of from 350 nm to 420 nm so that the light is absorbed by the coloring material. Thus, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference fringes. So far as the sensitizing dye and remaining discolorable dye can be decomposed and discolored at the first and second steps or the subsequent fixing step, a hologram recording material excellent in non-destructive reproduction and storage properties can be provided.

For example, when the hologram recording material having data, image, etc. recorded thereon is again irradiated with a laser beam having a wavelength of 532 nm, the data, image, etc. can be reproduced.

Specific preferred examples of the latent image- coloring material sensitized polymerization reaction include those exemplified in Japanese Patent Application No. 2004-238392.

4) Recording of interference fringes by the change of orientation of compound intrinsic birefringence

This hologram recording method preferably involves the change of orientation of a compound having an intrinsic birefringence upon hologram exposure. The compound is then chemically reacted so that it is fixed. In this manner, interference fringes can be recorded as refractive index modulation in a non-rewritable process. As the compound having an intrinsic birefringence there is preferably used a liquid crystal-based compound, more preferably a low molecular liquid crystal-based compound, even more preferably a low molecular liquid crystal- based compound having a polymerizable group. The low molecular liquid crystal-based compound having a polymerizable group is preferably any of nematic liquid crystal-based compound, smectic liquid crystal-based compound, discotic nematic liquid crystal-based compound, discotic liquid crystal-based compound and cholesteric liquid crystal-based compound, more preferably a nematic liquid crystal-based compound or smectic liquid crystal-based compound.

Further, the hologram recording material which performs interference fringes recording involving the change of orientation of a compound having an intrinsic birefringence preferably comprises at least a low molecular liquid crystal-based compound having a polymerizable group, a photoreactive compound and a polymerization initiator, more preferably a sensitizing dye, a binder polymer, etc. as well. Preferred examples of the polymerization initiator, the sensitizing dye, the binder polymer, etc. include those exemplified above.

The photoreactive compound is preferably an optically anisotropic compound, more preferably an azobenzene-based compound, a stilbene-based compound, a spiropyran-based compound, a spirooxazine-based compound, a diarylethene-based compound, a fulgide- based compound, a fulgimide-based compound, a cinnamic acid-based compound, a coumarine-based compound or a chalcone-based compound, most preferably an azobenzene- based compound.

The photoreactive compound may be a low molecular compound or a polymer compound. The photoreactive compound which is a polymer compound is preferably a polymer compound which is pendanted at the photoreactive site thereof.

Specific preferred examples of interference fringes recording method involving change of orientation of compound having an intrinsic birefringence and material therefor include those exemplified in Japanese Patent Application No. 2003-327594.

5) Dye discoloration reaction

In this hologram recording method, at least one discolorable dye is used and the discolorable dye is discolored during hologram exposure to cause refractive index modulation by which interference fringes is formed.

The term "discolorable dye" as used herein generically indicates a dye which has absorption in the ultraviolet range of from 200 to 2,000 nm, visible light range and infrared range and directly or indirectly causes any, preferably both of shifting of $\lambda$max to shorter wavelength and reduction of molar absorptivity when irradiated with light. The discoloration reaction occurs preferably in the wavelength range of from 200 to 1,000 nm, more preferably from 300 to 900 nm.

Preferred examples of the aforementioned combination include:

(A) A hologram recording method wherein the discolorable dye is a sensitizing dye having absorption in the hologram exposure wavelength and absorbs light during hologram exposure to discolor itself, causing refractive index modulation by which interference fringes is formed; and

(B) A hologram recording method wherein there are provided at least a sensitizing dye having absorption at hologram exposure wavelength and a discolorable dye having a molar absorptivity of 1,000 or less, preferably 100 or less at hologram reproducing light wavelength and the sensitizing dye absorbs light during hologram exposure to generate excitation energy by which electron or energy moves to discolor the discolorable dye, causing refractive index modulation by which interference fringes is formed. The hologram recording method (B) is preferred.

It is more preferred that there is provided a discoloring agent precursor other than the discolorable dye and the sensitizing dye and when subjected to hologram exposure, the sensitizing dye or the discolorable dye generates excited state in which it then undergoes energy movement or electron movement with the discoloring agent precursor to cause the discoloring agent precursor to generate a discoloring agent which then discolors the discolorable dye, causing refractive index modulation by which interference fringes is formed. The discoloring agent is preferably any of radical, acid, base, nucleophilic agent, electrophilic agent and singlet oxygen. Accordingly, the discoloring agent precursor is preferably any of radical generator, acid generator, base generator, nucleophilic agent generator, electrophilic agent generator and triplet oxygen. The discoloring agent precursor is preferably any of radical generator, acid generator and base generator.

In any case, it is more desirable that a binder polymer be further incorporated. Examples of the binder polymer include those exemplified above. Particularly preferred examples of the binder polymer will be described below.

The discolorable dye for making the refractive index different from the bright interference area to the dark interference area in the "dye discoloration reaction process" will be further described hereinafter.

In order to allow the discolorable dye to act also as a sensitizing dye in the aforementioned process (A), the previously exemplified examples of sensitizing dye are preferably used as discolorable dye. λmax of the sensitizing dye/discolorable dye is preferably in between the hologram recording light wavelength and wavelength 100 nm shorter than the hologram recording light wavelength.

On the other hand, in the aforementioned process (B), a discolorable dye is used separately of the sensitizing dye. The discolorable dye to be used herein preferably exhibits a molar absorptivity of 1,000 or less, more preferably 100 or less, most preferably 0 at hologram recording light wavelength.

In the process (B), the discolorable dye is preferably any of cyanine dye, squarilium cyanine dye, styryl dye, pyrilium dye, melocyanine dye, arylidene dye, oxonol dye, coumarine dye, pyrane dye, xanthene dye, thioxanthene dye, phenothiazine dye, phenoxazine dye, phenazine dye, phthalocyanine dye, azaporphyrin dye, porphyrin dye, fused ring aromatic dye, perylene dye, azomethine dye, azo dye, anthraquinone dye and metal complex dye, more preferably any of cyanine dye, styryl dye, melocyanine dye, arylidene dye, oxonol dye, coumarine dye, xanthene dye, azomethine dye, azo dye and metal complex dye.

In particular, when the discoloring agent is an acid, the discolorable dye is preferably a dissociation product of dissociative arylidene dye, dissociative oxonol dye, dissociative xanthene dye or dissociative azo dye, more preferably a dissociation product of dissociative arylidene dye, dissociative oxonol dye or dissociative azo dye. The term "dissociative dye" as used herein generically indicates a dye having an active hydrogen having pKa of from about 2 to 14 such as -OH group, -SH group, -COOH group, $-NHSO_2R$ group and $-CONHSO_2R$ group which undergoes deprotonation to have absorption in longer wavelength or with higher ε. Accordingly, such a dissociative dye can be previously treated with a base to form a dissociated dye from which a dye having absorption in longer wavelength or with higher ε can be prepared, making it possible to render the dye non-dissociative during photo-acid generation so that it is discolored (have absorption in lower wavelength or with lower ε).

In particular, in the case where the discoloring agent is a base, when a product of color development of an acid-colorable dye such as triphenylmethane dye, xanthene dye and fluorane dye with an acid is used as a discolorable dye, it can be converted to unprotonated product and thus discolored (have absorption in lower wavelength or with lower ε) during photo-base generation.

Specific examples of the discolorable dye of the invention will be given below, but the invention is not limited thereto.

G-1

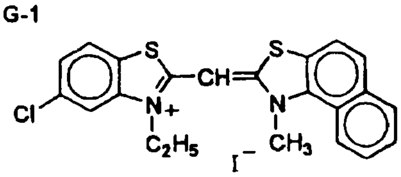

G-2

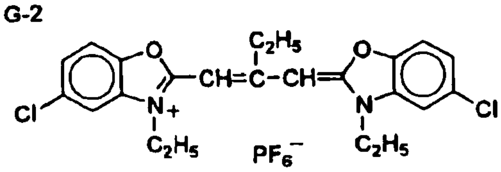

G-3

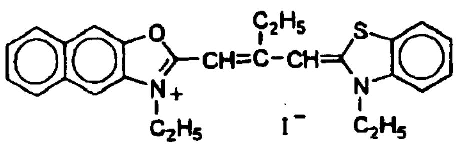

G-4

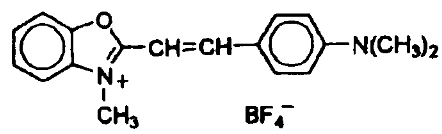

G-5

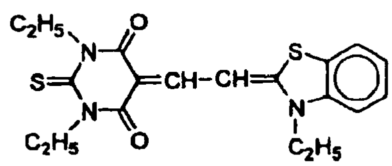

G-6

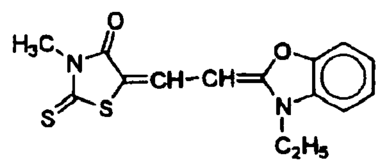

G-7

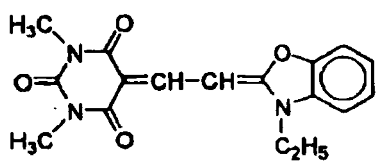

G-8

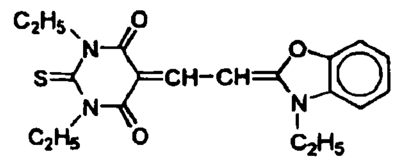

G-9

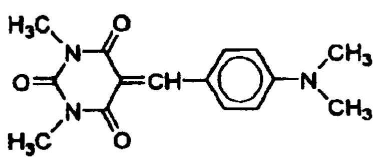

G-10

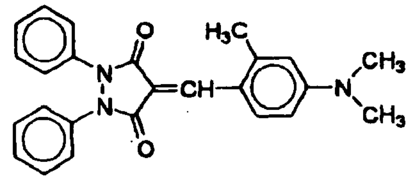

G-11

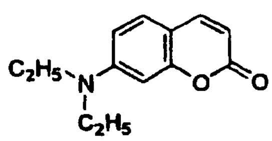

G-12

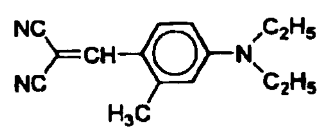

<Dissociation product of dissociative dye, mainly acid-discolorable dye>

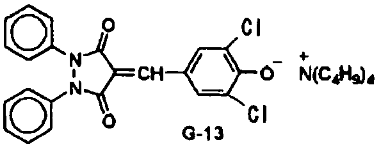

G-13

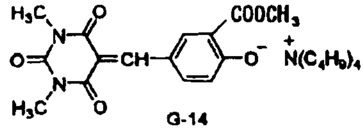

G-14

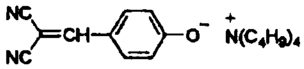

G-15

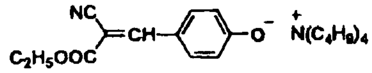

G-16

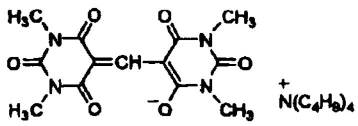

G-17

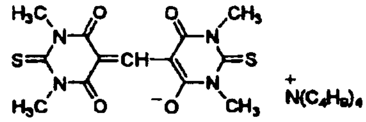

G-18

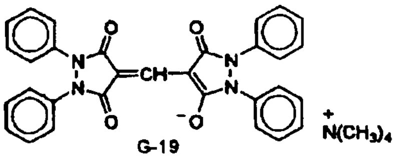

G-19

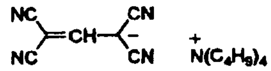

G-20

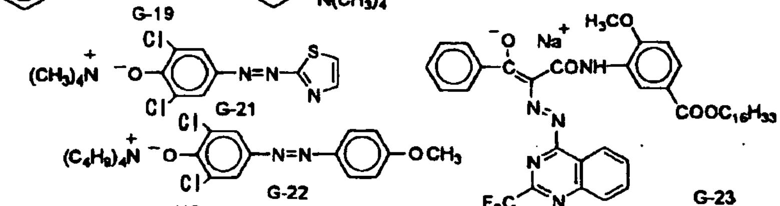

G-21

G-22

G-23

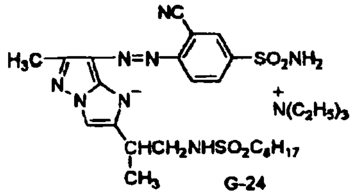

G-24

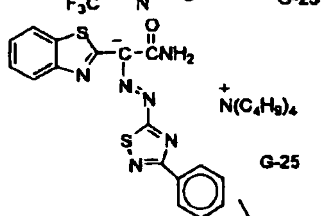

G-25

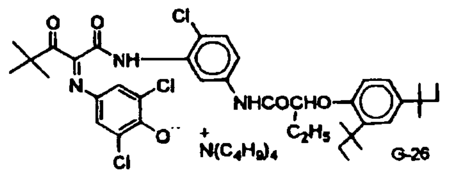

G-26

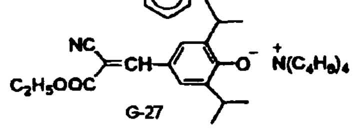

G-27

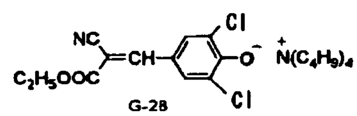

G-28

<Color development product of acid-colorable dye. mainly base-discolorable dye>

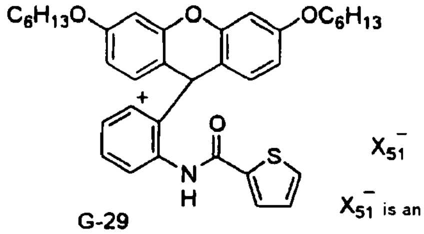

$X_{51}^-$

$X_{51}^-$ is an anion.

G-29

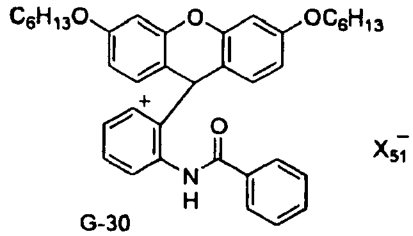

$X_{51}^-$

G-30

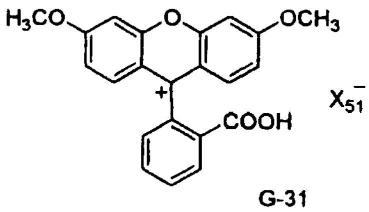

$X_{51}^-$

G-31

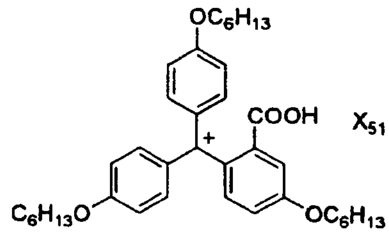

$X_{51}$

G-32

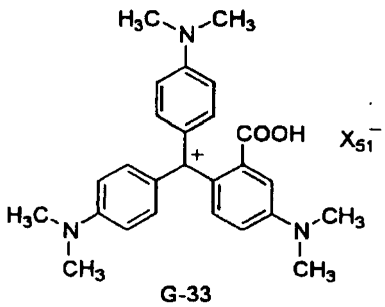

$X_{51}^-$

G-33

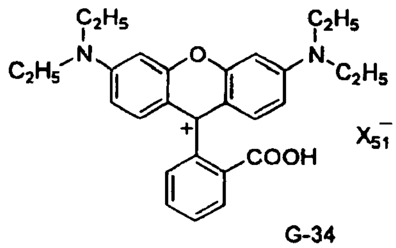

$X_{51}^-$

G-34

<Acid-color development product of cyanine base, mainly base-discolorable dye>

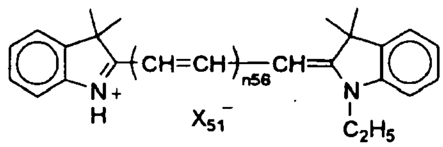

| | $n_{56}$ |
|---|---|
| G-35 | 0 |
| G-36 | 1 |
| G-37 | 2 |

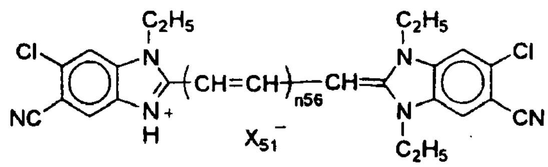

| | $n_{56}$ |
|---|---|
| G-38 | 0 |
| G-39 | 1 |

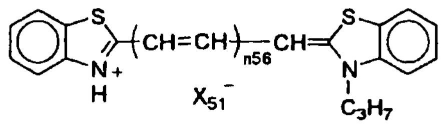

| | $n_{56}$ |
|---|---|
| G-40 | 0 |
| G-41 | 1 |

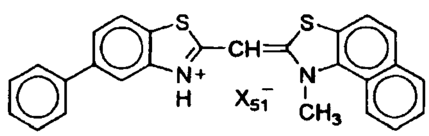

G-42

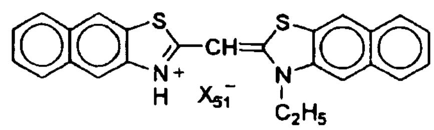

G-43

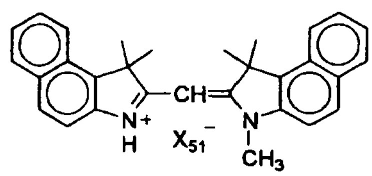

G-44

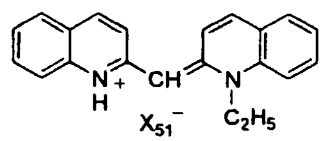

G-45

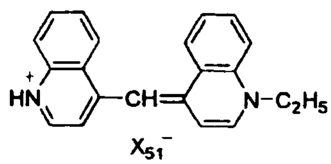

G-46

A preferred example of the discolorable dye of the invention is the following discolorable dye which is subjected to hologram exposure to generate the excited state of the sensitizing dye from which electron moves to severe the bond, resulting in the discoloration thereof.

Such a discolorable dye is originally a cyanine dye. However, when the electron movement causes the bond to be severed, the discolorable dye is converted to a cyanine base (leucocyanine dye), causing the absorption to be eliminated or shifted to lower wavelength.

<Discoloration by severation of bond by electron movement>

$X_{51}^-$ is an anion.

| $R_{51}$ | 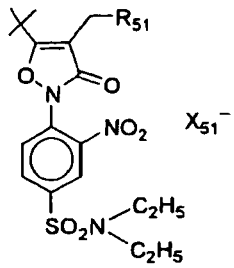 | 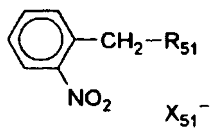 |
|---|---|---|
| GD-1 | G-47 | G-54 |
| GD-2 | G-48 | G-55 |
| GD-3 | G-49 | G-56 |
| GD-4 | G-50 | G-57 |
| GD-5 | G-51 | G-58 |
| GD-6 | G-52 | G-59 |
| GD-7 | G-53 | G-60 |

*: Substitution at position

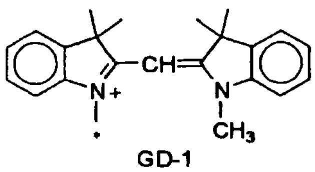

GD-1

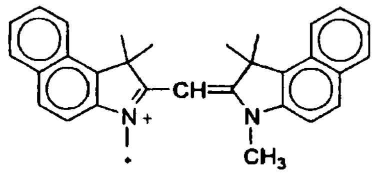

GD-2

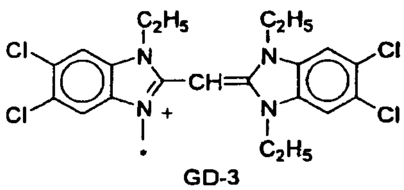

GD-3

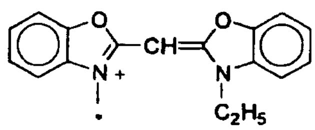

GD-4

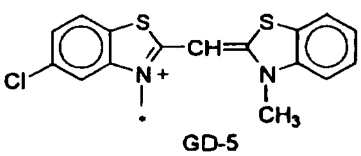

GD-5

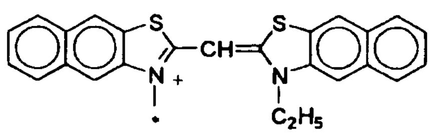

GD-6

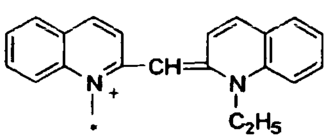

GD-7

Preferred examples of the discoloring agent precursor which is an acid generator include those exemplified above with reference to cationic polymerization initiator. Preferred examples of the discoloring agent precursor which is a radical generator include those exemplified above with reference to radical polymerization initiator. Preferred examples of the discoloring agent precursor which is a base generator include those exemplified above with reference to anionic polymerization initiator.

Specific preferred examples of the dye discoloration reaction include those exemplified in Japanese Patent Application No. 2004-88790.

6) Remaining discolorable dye latent image-latent image sensitized polymerization reaction

This hologram recording method preferably comprises a first step at which the sensitizing dye having absorption at hologram exposure wavelength absorbs light during hologram exposure to generate excited state with the energy of which it then discolors the discolorable dye having a molar absorptivity of 1,000 or less, preferably 100 or less, most preferably 0 at hologram reproducing light wavelength, whereby the discolorable dye left undiscolored forms a latent image and a second step at which the latent image of discolorable dye left undiscolored is irradiated with light having a wavelength different from that used for hologram exposure to cause polymerization by which interference fringes is recorded as refractive index modulation. This hologram recording method is excellent in high speed recording properties, adaptability to multiplexed recording, storage properties after recording, etc.

This hologram recording method more preferably comprises a first step at which the sensitizing dye having absorption at hologram exposure wavelength absorbs light during hologram exposure to generate excited state in which it then undergoes energy movement or electron movement with the discoloring agent precursor as defined in Clause (5) to cause the discoloring agent precursor to generate a discoloring agent which then discolors the discolorable dye whereby the discolorable dye left undiscolored forms a latent image and a second step at which the latent image of discolorable dye left undiscolored is irradiated with light having a wavelength different from that used for hologram exposure to cause energy movement or electron movement by which a polymerization initiator is activated to cause polymerization by which interference fringes is recorded as refractive index modulation.

Further, the compound group allowing the aforementioned hologram recording method preferably comprises:

1) a sensitizing dye which absorbs light upon hologram exposure to generate excited state at the first step;
2) a discolorable dye having a molar absorptivity of 1,000 or less capable of performing direct electron movement or energy movement to the discoloring agent precursor from the excited state of the sensitizing dye to undergo discoloration at the first step;
3) a polymerization initiator (optionally acting as a discoloring agent precursor 2) as well) which can undergo electron movement or energy movement from excited state of remaining discolorable dye to initiate the polymerization of the polymerizable compound at the second step;
4) a polymerizable compound; and
5) a binder.
In the case where energy or electron is moved to the discoloring agent precursor at the step 2),
6) it is preferred that a discoloring agent precursor which can undergo electron or energy movement from the excited state of the sensitizing dye to generate a discoloring agent at the first step be also incorporated.

Specific preferred examples of the sensitizing dye include those exemplified with reference to 1) color development reaction. Preferred examples of the polymerization initiator, the polymerizable compound and the binder include those exemplified with reference to 3) latent image color development-coloring material sensitized polymerization reaction. Particularly preferred examples of the binder of the invention exemplified below may be used.

Preferable examples of the discolorable dye and the discoloring agent precursor are 5) those which are the same as examples described for the discoloring reaction.

The light emitted at the second step preferably has a wavelength range at which the sensitizing dye exhibits a molar absorptivity of 1,000 or less, more preferably 500 or less.

At the wavelength range of the light emitted at the second step, the sensitizing dye preferably exhibits a molar linear absorption coefficient of 1,000 or less, more preferably 500 or less.

Further, the light emitted at the second step preferably has a wavelength range at which the coloring material exhibits a molar absorptivity of 1,000 or more.

In the "remaining discolorable dye latent image- latent image sensitized polymerization process" of the invention, it is also preferred that the discoloring agent precursor and the polymerization initiator partly or wholly act as each other.

In the case where a discolorable dye is added in addition to sensitizing dye, when the discoloring agent precursor and the polymerization initiator are different from each other (e.g., when the discoloring agent precursor is an acid generator or base general formula and the polymerization initiator is a radical polymerization initiator or when the discoloring agent precursor is a radical generator or nucleophilic agent generator and the polymerization initiator is an acid generator or base generator), it is preferred that the sensitizing dye can perform electron movement sensitization only on the discoloring agent precursor and the polymerization initiator can perform electron movement sensitization only by the discolorable dye.

In the hologram recording method and the hologram recording material allowing same, it is preferred from the standpoint of storage properties and non-destructive reproducibility that the sensitizing dye be decomposed and fixed at the first, the second step or the subsequent fixing step involving either or both of irradiation with light and application of heat. It is more preferred that the sensitizing dye be decomposed and fixed at the first step, the second step or the

subsequent fixing step involving either or both of irradiation with light and application of heat and the coloring material be decomposed and fixed at the second step or the subsequent fixing step involving either or both of irradiation with light and application of heat.

The concept of "remaining discolorable dye latent image-latent image sensitized polymerization reaction process" will be described hereinafter.

For example, the hologram recording material is irradiated with YAG.SHG laser beam having a wavelength of 532 nm so that the laser beam is absorbed by the sensitizing dye to generate excited state. Energy or electron is then moved from the the excited state of the sensitizing dye to the discoloring agent precursor to generate a discoloring agent by which the discolorable dye is then discolored. As a result, a latent image can be formed by the remaining discolorable dye (first step). Subsequently, the hologram recording material is irradiated with light having a wavelength of from 350 nm to 420 nm so that the light is absorbed by the remaining discolorable dye. Then, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference fringes. So far as the sensitizing dye and remaining discolorable dye can be decomposed and discolored at the first and second steps or the subsequent fixing step, a hologram recording material excellent in non-destructive reproduction and storage properties can be provided.

For example, when the hologram recording material having data, image, etc. recorded thereon is again irradiated with a laser beam having a wavelength of 532 nm, the data, image, etc. can be reproduced. Alternatively, the hologram recording material of the invention can act as a desired optical material.

Specific preferred examples of the remaining discolorable dye latent image-latent image sensitized polymerization reaction include those exemplified in Japanese Patent Application No. 2004-88790.

The hologram recording material of the invention may further comprise additives such as electron-donating compound, electron-accepting compound, chain transfer agent, crosslinking agent, heat stabilizer, plasticizer and solvent incorporated therein besides the aforementioned sensitizing dye, interference fringes-recording component, polymerization initiator, polymerizable compound, binder, discolorable dye, discoloring agent precursor, etc. as necessary.

The electron-donating compound is capable of reducing the radical cation in the sensitizing dye or coloring material. The electron-accepting compound is capable of oxidizing the radical anion in the sensitizing dye or coloring material. Thus, both the electron-donating compound and the electron-accepting compound are capable of reproducing the sensitizing dye. Specific preferred examples of these compounds include those exemplified in Japanese Patent Application No. 2004-238077.

In particular, the electron-donating compound is useful for the enhancement of sensitivity because it can rapidly reproduce the sensitizing dye or coloring material radical cation produced by the movement of electron to the dye precursor group. As the electron-donating compound there is preferably used one having a more negative oxidation potential than sensitizing dye, coloring material or discolorable dye. Specific preferred examples of the electron-donating compound will be given below, but the invention is not limited thereto.

Examples of electron-donating compound for reproduction of sensitizing dye

A-1

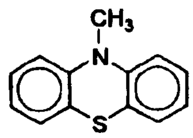

A-2

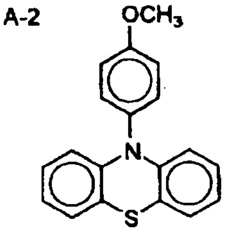

A-3

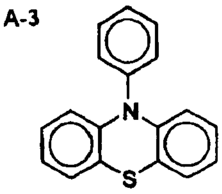

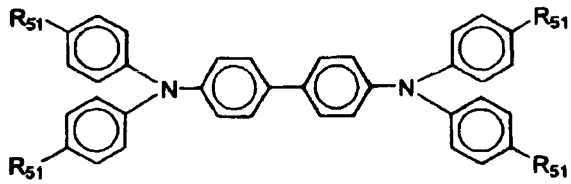

| | $R_{51}$ |
|---|---|
| A-4 | H |
| A-5 | $-OCH_3$ |

A-6

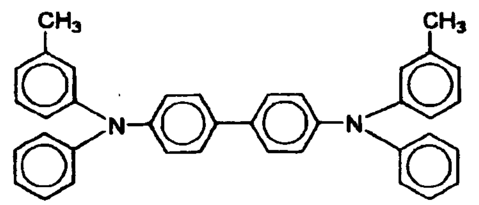

A-7

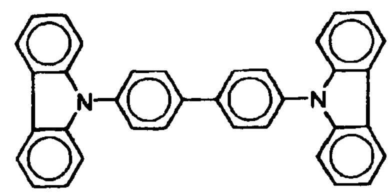

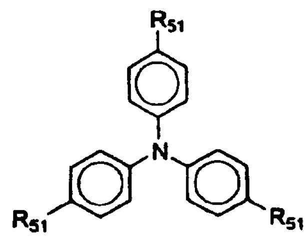

| | $R_{51}$ |
|---|---|
| A-8 | H |
| A-9 | $-CH_3$ |
| A-10 | $-OCH_3$ |

A-11

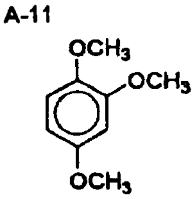

A-12

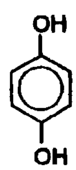

A-13

$(C_4H_9)_4\overset{+}{N}\ I^-$

A-14

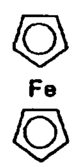

Particularly preferred examples of the electron- donating compound include phenothiazine-based compounds (e.g., 10-methylphenothiazine, 10-(4'-methoxyphenyl) phenothiazine), triphenylamine-based compounds (e.g., triphenylamine, tri(4'-methoxyphenyl)amine), and TPD- based compounds (e.g., TPD). Most desirable among these electron-donating compounds are phenothiazine-based compounds.

The aforementioned sensitizing dye, acid generator, base generator, dye precursor, discolorable dye, discoloring agent precursor, electron-donating compound, etc. may each be an oligomer or polymer. These components in the form of oligomer or polymer may be each incorporated in the main chain or side chains. These components may also be in the form of copolymer.

The polymer main chain may have any structure. Preferred examples of the structure of the polymer chain include polyethers such as polyacrylate, polymethacrylate, polystyrene and polyethylene oxide, polyesters, and polyamides.

The number of repeating units constituting the polymer or oligomer is from not smaller than 2 to not greater than 1,000,000, preferably from not smaller than 3 to not greater than 1,000,000, more preferably from not smaller than 5 to not greater than 500,000, even more preferably from not smaller than 10 to not greater than 100,000.

The molecular weight of the polymer or oligomer is preferably from not smaller than 500 to not greater than 10,000,000, more preferably from not smaller than 1,000 to not greater than 5,000,000, even more preferably from not smaller than 2,000 to not greater than 1,000,000, most preferably from not smaller than 3,000 to not greater than

1,000,000.

Specific preferred examples of chain transfer agent, crosslinking agent, heat stabilizer, plasticizer, solvent, etc. include those exemplified in Japanese Patent Application No. 2004-23892.

Preferred examples of the chain transfer agent include thiols. Examples of these thiols include 2- mercaptobenzoxazole, 2-mercaptobenzthiazole, 2- mercaptobenzimidazole, 4-methyl-4H-1,2,4-triazole-3- thiol, p-bromobenzenethiol, thiocyanuric acid, 1,4-bis(mercapto)benzene, and p-toluenethiol.

In particular, in the case where the polymerization initiator is a 2,4,5-triphenylimidazolyl dimer, a chain transfer agent is preferably used.

The hologram recording material of the invention may comprise a heat stabilizer incorporated therein to enhance the storage properties thereof during storage.

Examples of useful heat stabilizers include hydroquinone, phenidone, p-methoxypheno, alkyl- substituted hydroquinone, alkyl-substituted quinone, aryl-substituted hydroquinone, aryl-substituted quinone, catechol, t-butylcatechol, pyrogallol, 2- naphthol, 2,6-di-t-butyl-p-cresol, phenothiazine, and chloranyl.

The plasticizer is used to change the adhesivity, flexibility, hardness and other mechanical properties of the hologram recording material. Examples of the plasticizer employable herein include triethylene glycol dicaprylate, triethylene glycol bis(2- ethylhexanoate), tetraethylene glycol diheptanoate, diethyl sebacate, dibutyl sberate, tris(2-ethylhexyl) phosphate, tricresyl phosphate, dibutyl phthalate, alcohols, and phenols.

A particularly preferred binder (thermosetting polymer) of the invention will be described hereinafter.

The aforementioned binder polymer preferably comprises a reactive polymer and a crosslinking agent and forms a polymer matrix produced by a polymerization reaction (e.g., thermal reaction). More preferably, the reactive polymer is a polyol and the crosslinking agent is an NCO-terminated prepolymer (isocyanate). The binder polymer preferably shows an exothermic peak within 12 minutes after the mixing of the polyol and the NCO-terminated prepolymer. The optical recording medium made of the hologram recording material prepared from the binder polymer has no dispersion of product quality, undergoes no foaming and is optically flat and uniform in thickness. The resulting product exhibits excellent optical properties and a desired dynamic range and sensitivity.

In order to satisfy the demand for optical properties, care must be taken to sufficiently deaerate all the materials before the thermal or catalytic activation of reaction. It is also necessary that any impurities that can produce a gas as by-product be removed to prevent the final matrix obtained by curing the polymer from foaming.

In order to allow mass production of optical recording media, it is preferred that the formation of the thermally crosslinked matrix system be conducted in a short period of time (preferably 20 minutes or less).

In order to prepare a high performance optical recording medium according to a two-component urethane matrix system, it is for example necessary that the polyol and all additives be substantially free of water content. The polyol containing isocyanate and catalyst and all other components which have been once mixed need to be deaerated to sufficiently remove the air which has been taken therein during mixing. Since deaeration takes much time, it is necessary that no urethane reaction occur before the removal of all foams from the mixture of isocyanate and polyol.

The polyol is selected from the group consisting of polytetramethylene glycol, polycaprolactone and diol and triol of polypropylene oxide. The polyol is preferably a triol of polypropylene oxide or polytetramethylene ether having a molecular weight of from 450 to 6,000. The polyol is preferably free of water content. A high temperature vacuum metallizing may be conducted or an additive such as water remover may be used to prevent the polymer from having water content left therein before use.

Examples of the additives include butylated hydroxytoluene (BHT), phenothiazine, hydroquinone, methyl ether of hydroquinone, peroxide, phosphite, hydroxyamine, and defoaming agent or deaerator for removing foams taken in the polyol.

A tin catalyst may be used. Examples of the tin catalyst include dimethyl dilaurate tin, dibutyl dilaurate tin, and stannous octoate.

The binder polymer is produced by a process comprising a step of mixing a matrix precursor and an optical refractive index-modulating component and a step of curing the mixture *in situ* to form a matrix. The reaction of polymerizing the matrix precursor during curing is independent of the optical refractive index modulation reaction of the optical refractive index-modulating component and thus preferably causes no reaction of the optical refractive index-modulating component during the reaction of forming the polymer matrix. As a result of the independence of the polymer matrix and the optical refractive index-modulating component from each other, recording properties useful in optical recording medium made of hologram recording material can be provided. For example, refractive index can be highly modulated without raising the concentration of the optical refractive index-modulating component.

As previously mentioned, the binder polymer is obtained by mixing the matrix precursor and the optical refractive index-modulating component, and then curing the precursor *in situ* to form a polymer matrix. The reaction of polymerizing the matrix precursor during curing is independent of the reaction of optical refractive index modulation reaction of the optical refractive index-modulating component. In other words, the optical refractive index-modulating component is substantially inactive during curing of matrix. The formation of the polymer matrix is considered to be completed when

the product shows an elastic modulus of at least about $10^5$ Pa, normally from about $10^5$ Pa to about $10^9$ Pa, preferably from about $10^6$ Pa to about $10^8$ Pa.

At least one optical refractive index-modulating component contains one or more components which are substantially not present in the polymer matrix, except its functional groups. The term "substantially not present" as used herein is meant to indicate that the optical refractive index-modulating component is present in the matrix in an amount of only 20% or less of all the components of the recording material, that is, is not covalently bonded to the polymer matrix. The resulting hologram recording material exhibits a desired refractive index difference because the polymer matrix has nothing to do with the optical refractive index-modulating component.

The polymer matrix is a solid polymer which has been produced from a matrix precursor *in situ* by a curing process (Curing indicates a process for reacting a precursor to form a polymer matrix). Examples of the matrix precursor include employable herein include one or more monomers, one or more oligomers, and mixture of monomer and oligomer. Further, one precursor molecule or a group of precursor molecules may have one or more precursor functional groups. The precursor functional group indicates one or more groups in the precursor molecule which act as a polymerization site during curing of matrix. In order to accelerate the mixing with the optical refractive index-modulating component, the precursor preferably stays liquid at a temperature of from about -50°C to about 80°C. The polymerization of the matrix is preferably effected at room temperature. Further, the polymerization of the matrix is preferably effected in 5 minutes or less. The glass transition temperature (Tg) of the hologram recording material is preferably so low that the optical refractive index-modulating component undergoes sufficient diffusion and chemical reaction during the holographic recording process. In general, Tg is preferably not more than 50°C more than the temperature at which the holographic recording is effected. In the case of typical holographic recording, Tg is preferably between about -130°C and about 80°C (if measured by an ordinary method).

Examples of the polymerization reaction for forming the polymer matrix include cationic epoxy polymerization reaction, a cationic vinyl ether polymerization reaction, a cationic alkenyl ether polymerization reaction, a cationic allyl ether polymerization reaction, a cationic ketene acetal polymerization reaction, an epoxy amine stepwise polymerization reaction, an epoxy mercaptane stepwise polymerization reaction, an unsaturated ester amine stepwise polymerization reaction (involving Michael addition), an unsaturated ester mercaptane stepwise polymerization reaction (involving Michael addition), a vinyl-silicon hydride stepwise polymerization reaction (hydrosilylation), an isocyanate-hydroxyl group stepwise polymerization reaction (urethane formation reaction), an isocyanate-amine stepwise polymerization reaction (urea formation reaction), and a combination thereof. Preferred among these polymerization reactions are isocyanate-hydroxyl group stepwise polymerization reaction (urethane formation reaction), isocyanate-amine stepwise polymerization reaction (urea formation reaction), and a combination thereof.

Some of these reactions can be initiated or accelerated with a proper catalyst. For example, the cationic epoxy polymerization reaction can be rapidly effected in the presence of a $BF_3$-based catalyst. The other cationic polymerization reactions proceed in the presence of proton. The epoxy-mercaptane reaction and Michael addition are accelerated with a base such as amine. The hydrosilylation reaction proceeds rapidly in the presence of a transition metal catalyst such as platinum. The urethane and urea formation reactions can rapidly proceed in the presence of a tin catalyst. For the formation of matrix, an optically activated catalyst may be used.

An example of the formulation of hologram recording material comprising the binder polymer will be given below.

| | |
|---|---|
| NCO-terminated prepolymer | 20 to 50% by weight |
| Optical refractive index-modulating component | 1 to 15% by weight |
| Polyol | 40 to 75% by weight |
| Catalyst | 0.1 to 3% by weight |
| Additives | 0.001 to 0.5% by weight |

The NCO-terminated prepolymer is a by-product of the reaction of diol with diisocyanate and can be selected from the group consisting of those having an NCO content of from 10 to 25% by weight. The NCO content can be calculated directly on the basis of prepolymer, unreacted diisocyanate, and polyisocyanate added optionally for the enhancement of properties. An aromatic diisocyanate-based prepolymer is preferred. However, in the case where the NCO-terminated prepolymer is an aliphatic diisocyanate-based prepolymer, it is necessary that an NCO content of from 5 to 100% by weight be from an aromatic diisocyanate or aliphatic polyisocyanate. Preferred aromatic diisocyanates are not limited but include diphenylmethane diisocyanate (MDI) and toluene diisocyanate (HDI). Preferred examples of aliphatic isocyanate include hexamethylene diisocyanate (HDI), biuret thereof, isocyanurate, uretidione, and other derivatives.

Particularly preferred examples of NCO-terminated prepolymer are the following two examples.

(1) An NCO-terminated prepolymer comprising biscyclohexylmethane diisocyanate, an NCO-terminated prepolymer

produced by the reaction of biscyclohexylmethane diisocyanate with polytetramethylene glycol, butylated hydroxytoluene and/or a hexamethylene diisocyanate derivative, wherein the polyol contains a polyol of polypropylene oxide and a polyol of polytetramethylene ether and an exothermic peak occurs within 12 minutes after the mixing of the polyol with the NCO-terminated prepolymer.

(2) An NCO-terminated prepolymer comprising a material selected from the group consisting of diphenylmethane diisocyanate, toluene diisocyanate, hexamethylene diisocyanate and hexamethylene diisocyanate, wherein the polyol comprises a polyol of polypropylene oxide and an exothermic peak occurs within 12 minutes after the mixing of the polyol with the NCO-terminated prepolymer.

In the case where the binder polymer is used to prepare an optical recording medium, a mixture of a matrix precursor and an optical refractive index-modulating component may be deposited between two sheets of plate using a gasket for retaining a material. The plate is typically made of glass. Besides glass, other materials transparent to illumination for use in data recording, e.g., plastic such as polycarbonate and poly (methylmethacrylate) may be used. Between the two sheets of plate may be provided a space for adjusting the optical recording medium to a desired thickness. During the curing of the matrix, the material shrinks to generate a stress in the plate. The stress causes the change of parallelism and/or gap between the two plates, resulting in the occurrence of adverse effects on the optical properties of the recording medium. In order to eliminate this effect, it is effective to place the plates in a device equipped with a supporting table, e.g., vacuum chuck. In this arrangement, adjustment is made possible in response to change causing the change of parallelism and/or gap between the plates. In accordance with this device, a related art interference method may be used to monitor parallelism at real time, allowing necessary adjustment during curing. For this method, reference can be made to US Patent Application No. 08/867,563, which is a part of the present specification when the name of the literature is disclosed. The hologram recording material of the invention can be supported by other methods. For example, it is possible that the mixture of the matrix precursor and the optical refractive index-modulating component is provided in the pores in a nanoporous glass material such as Vycor glass prior to the curing of the matrix. A related art polymer process such as closed mold forming or sheet extrusion is also included. A lamellar medium, i.e., medium having a recording material layer provided between a number of substrates such as glass is possible.

The amount of data to be recorded in the hologram recording material is proportional to the product of refractive index difference $\Delta n$ of recording material and the thickness d of recording material. (The refractive index difference $\Delta n$ has heretofore been known and is defined by the intensity of change of sinusoidal wave of refractive index of a material having a plane wave and a volume hologram recorded therein. The refractive index changes according to the equation $n(x) = no + \Delta n \cos(Kx)$ in which n(x) is a spatial refractive index change, x is a position vector, K is a lattice wave vector, and no is the base line refractive index of a medium. For details, reference can be made to P. Hariharan, "Optical Holography: Principles, Techniques, and Applications, Cambridge University Press, Cambridge, 1991, at 44.) In general, the refractive index difference $\Delta n$ of a material is calculated from the diffraction efficiency of a single volume hologram or a multiple set of volume holograms recorded in the medium. The refractive index difference $\Delta n$ is related to a medium having no data recorded therein but is observed and measured on the medium having data recorded therein. The recording material of the invention preferably has a thickness of 200 $\mu$m or more and $\Delta n$ of $3 \times 10^{-3}$ or more.

Another example of particularly preferred binder polymer of the invention will be described hereinafter.

The other preferred binder polymer system is phase-separated from the optical refractive index-modulating component. The binder polymer exhibits a Rayleigh ratio of about $7 \times 10^{-3}$ or less at 90° of scattering of light having a wavelength effective for formation of hologram. The binder polymer is produced by a reaction independent of the optical refractive index modulation reaction of the optical refractive index-modulating component. It is particularly preferred that the binder polymer be made of a melamine-formaldehyde resin.

Rayleigh ratio ($R\theta$) is a known property. As explained in M. Kerker, ''The Scattering of Light and Other Electromagnetic Radiation", Academic Press, 1969, 38, Rayleigh ratio ($R\theta$) is defined by the energy which is scattered by a unit amount in the direction $\theta$ of steradian when the medium is irradiated with nonpolarized light at a unit dose. The Rayleigh ratio of a material is typically determined by the comparison in energy scattered with a reference material having a known Rayleigh ratio.

The elastic modulus of the binder polymer is preferably $10^6$ Pa or more, more preferably from $10^6$ to about $10^9$ $P_a$, even more preferably $10^7$ Pa or more.

The hologram recording material of the invention comprising the aforementioned binder polymer is prepared by mixing an optical refractive index-modulating component and a polymer matrix precursor, and then curing the mixture. The curing of the binder polymer is preferably carried out by a reaction independent of the optical refractive index modulation reaction of the optical refractive index-modulating component. The polymer matrix and the optical refractive index-modulating component are selected such that (a) the matrix precursor and the optical refractive index-modulating component can be substantially dissolved or mixed with each other but (b) during curing, as the matrix precursor undergoes polymerization, the resulting polymer and the optical refractive index-modulating component are phase-separated. This process can provide eliminated scattering of light, allowing effective holography.

The polymer matrix preferably exhibits a three-dimensionally cross-connected structure to provide a desired strength. In particular, the cross-connected structure suppresses bulk shrinkage of a hologram recording material.

Examples of the polymerization reaction to be employed for the formation of the polymer matrix include a cationic epoxy polymerization reaction, a cationic vinyl ether polymerization reaction, an epoxy amine stepwise polymerization reaction, an epoxy mercaptane stepwise polymerization reaction (involving Michael addition), an unsaturated ester mercaptane stepwise polymerization reaction, a vinyl-silicon hydride stepwise polymerization reaction (hydrosilylation), an isocyanate-hydroxyl group stepwise polymerization reaction (urethane formation), and an isocyanate-amine stepwise polymerization reaction (urea formation). Some of these reactions are functionalized or accelerated with a proper catalyst.

In order to render the system phase-separatable, the optical refractive index-modulating component and the matrix precursor (and the resulting polymer) are selected on the basis of the matrix and the optical refractive index-modulating component. The guide line known to those skilled in the art is disclosed in, e.g., references on polymer-dispersed liquid crystal (PDLC). For papers on PDLC, reference can be made to P. Drzaic, "Liquid Crystal Dispersions, in Series on Liquid Crystals, Vol. 1, World Scientific, 1995, and J. W. Doane, "Polymer Dispersed Liquid Crystal Displays", in Liquid Crystals-Applications and Uses, Vol. 1, pp. 361-395, World Scientific, 1990. These disclosures are hereby incorporated by reference. The requirements for the accomplishment of the dispersion of liquid crystal in the polymer matrix due to phase separation of polymer are essentially the same as the requirements for the establishment of a definite region of optical refractive index-modulating component in the polymer matrix of the invention. The phase separation induced by the polymerization of an oligomer in the original position is discussed in Drzaic, supra, at pages 31-47 and 75-92 (The latter part discusses related dynamic requirements) and Doane, supra, at page 364. As disclosed in these citations, the final size of the definite region of optical refractive index-modulating component will be decided by many factors, including the rate at which the region is formed, the growth of region by diffusion and the mechanism of confinement of polymer matrix in the entire structure. For example, rapid polymerization is attributed to rapid formation of region and rapid rise of hardness of matrix phase and thus tends to give a smaller region. Further, Doane discusses about the effect of phase separation by scattering of light and refractive index contrast.

For example, organic aerogels are explained in US Patent 5,081,163 to Pekala, G. Ruben and R. Pekala, "High Resolution TEM of Organic Aergogels and Inorganic Aerogels", Mat. Res. Soc. Symp. Proc., Vol. 180, 785, 1990, L. Hrubesh and R. Pekala, "Thermal Properties of Organic and Inorganic Aerogels", J. Mater. Res., Vol. 9, No. 3, 731, 1994, and R. Pekala et al., "A Comparison of Mechanical Properties and Scaling Law Relationships for Silica Aerogels and Their Organic Counterparts", Mat. Res. Soc. Symp. Proc., Vol. 207, 197, 1991. These disclosures are hereby incorporated by reference. These organic aerogels act as polymer matrix of the invention. These organic aerogels help phase separation due to their capability of forming porous matrix structure. As explained in US Patent 5,081,163, lines 1 - 59, 6th column, the preparation of an aerogel involves formation of pores filled with a solvent and subsequent removal of the solvent leading to the formation of a matrix having air-filled pores characteristic to aerogel. In the invention, however, these pores preferably retain the optical refractive index-modulating component therein. A standard method for the preparation of aerogel involving phase separation guide line discovered in PDLC technology is effective to provide such a structure. The formation of such an organic aerogel matrix containing a region of optical refractive index-modulating component is disclosed in the following examples. By providing an optical refractive index-modulating component which is polymerized in a mechanism independent of the matrix precursor and selecting a matrix precursor and an optical refractive index-modulating component such that phase separation occurs according to matrix polymerization, the interference with the process of forming the matrix structure of aerogel can be eliminated. In this manner, a structure suitable for hologram recording material (i.e., definite region of optical refractive index-modulating component) can be obtained.

In addition to the dynamic factors, variables such as concentration, molecular weight and curing conditions have a great effect on phase separation and thus are adjusted to provide desired results. Further, the refractive index contrast between the matrix and the optical refractive index-modulating component, too, is one of requirements for the selection of a material for better holographic properties. The refractive index contrast and the specific wavelength used, too, have an effect on Rayleigh ratio.

The binder polymer thus obtained undergoes phase separation from the optical refractive index-modulating component and thus has a definite region dominantly containing the optical refractive index-modulating component and exhibits a Rayleigh ratio of about $7 \times 10^{-3}$ or less at 90° of scattering of light having a wavelength for formation of hologram as previously mentioned. In general, a definite region of optical refractive index-modulating component having a maximum size of about 50 nm or less is suitable for the accomplishment of this low light scattering. Preferably, at least a part of the definite region of optical refractive index-modulating component is connected to at least one of other regions. This mutual connection makes it easy for the optical refractive index-modulating component to diffuse from one region into the other during hologram formation. It was observed that the flood curing rate suggests substantial absence of monomer in the matrix and hence easy diffusion from region to region. However, the size of the region, the mutual connection of regions and the specific level of light scattering are secondary factors for the accomplishment of effective holographic

properties. Accordingly, the size of the region, the mutual connection of regions and the light scattering tend to vary with the matrix and the optical refractive index-modulating component.

The hologram recording material of the invention may be prepared by any ordinary method.

For the production of the film of the hologram recording material of the invention, the aforementioned binder and various components may be spread over the substrate in the form of solution in a solvent or the like using a spin coater, bar coater or the like.

Preferred examples of the solvent to be used herein include ketone-based solvents such as methyl ethyl ketone, methyl isobutyl ketone, acetone and cyclohexanone, ester-based solvents such as ethyl acetate, butyl acetate, ethylene glycol diacetate, ethyl lactate and cellosolve acetate, hydrocarbon-based solvents such as tetrahydrofurane, dioxane and diethyl ether, cellosolve-based solvents such as methyl cellosolve, ethyl cellosolve, butyl cellosolve and dimethyl cellosolve, alcohol-based solvents such as methanol, ethanol, n-propanol, 2-propanol, n-butanol and diacetone alcohol, fluorine-based solvents such as 2,2,3,3-tetrafluoropropanol, halogenated hydrocarbon- based solvents such as dichloromethane, chloroform and 1,2-dichloroethane, amide-based solvents such as N,N- dimethylformamide, and nitrile-based solvents such as acetonitrile and propionitrile.

The hologram recording material of the invention can be prepared by spreading the aforementioned coating solution directly over the substrate using a spin coater, roll coater, bar coater or the like or by casting the coating solution into a film which is then laminated on the substrate using an ordinary method.

The term "substrate" as used herein is meant to indicate an arbitrary natural or synthetic support, preferably one which can occur in the form of flexible or rigid film, sheet or plate.

Preferred examples of the substrate include polyethylene terephthalate, resin-undercoated polyethylne terephthalate, flame-treated or electrostatically discharged polyethylene terephthalate, cellulose acetate, polycarbonate, polymethyl methacrylate, polyester, polyvinyl alcohol, and glass.

The solvent used can be evaporated away during drying. The evaporation may be effected under heating or reduced pressure.

The film of the hologram recording material of the invention may be prepared by melting the binder comprising various components at a temperature of not lower than the glass transition temperature or melting point of the binder, and then melt-extruding or injection -molding the molten binder. During this procedure, a reactive crosslinkable binder may be used as the binder so that the binder thus extruded or molded can be crosslinked and cured to raise the strength of the film. In this case, the crosslinking reaction may involve radical polymerization reaction, cationic polymerization reaction, condensation polymerization reaction, addition polymerization reaction or the like. Alternatively, methods disclosed in JP-A-2000-250382, JP-A-2000-172154, etc. are preferably used.

Further, a method is preferably used which comprises dissolving various components in a monomer solution for forming a binder, and then subjecting the monomer to photopolymerization or photopolymerization to produce a polymer which is then used as a binder. Examples of the polymerization method employable herein include radical polymerization reaction, cationic polymerization reaction, condensation polymerization reaction, and addition polymerization reaction.

Moreover, a protective layer for blocking oxygen may be formed on the hologram recording material. The protective layer may be formed by laminating a film or sheet of a plastic such as polyolefin (e.g., polypropylene, polyethylene), polyvinyl chloride, polyvinylidene chloride, polyvinyl alcohol, polyethylene terephthalate and cellophane on the hologram recording material using an electrostatic contact method or an extrusion machine or by spreading the aforementioned polymer solution over the hologram recording material. Alternatively, a glass sheet may be laminated on the hologram recording material. Further, an adhesive or liquid material may be provided interposed between the protective layer and the photosensitive layer and/or between the substrate and the photosensitive layer to enhance airtightness.

In the case where the hologram recording material of the invention is used for holographic light memory, it is preferred from the standpoint of enhancement of S/N ratio during the reproduction of signal that the hologram recording material undergo no shrinkage after hologram recording.

To this end, it is preferred that the hologram recording material of the invention comprise an inflating agent disclosed in JP-A-2000-86914 incorporated therein or a shrinkage-resistant binder disclosed in JP-A-200-250382, JP-A-2000-172154 and JP- A-11-344917 incorporated therein.

Further, it is preferred that the interference fringes gap be adjusted using a diffusion element disclosed in JP-A-3-46687, JP-A-5-204288, JP-T-9-506441, etc.

When a known ordinary photopolymer as disclosed in JP-A-6-43634, JP-A-2-3082, JP-A-3-50588, JP-A-5-107999, JP-A-8-16078, JP-T-2001-523842 and JP-T-11-512847 is subjected to multiplexed recording, the latter half of multiplexed recording is conducted on the area where polymerization has proceeded so much. Therefore, the latter half of multiplexed recording requires more exposure time to record the same signal than the former half of multiplexed recording (lower sensitivity). This has been a serious problem in system design. In other, it has been disadvantageous in that the range within which the refractive index modulation shows linear rise with respect to exposure is very narrow.

On the contrary, 1) color development reaction, 2) latent image color development-coloring material self- sensitized amplification color development reaction and 5) dye discoloration reaction process recording methods of the invention involve no polymerization during the recording of interference fringes. Even 3) latent image color development-coloring material sensitized polymerization reaction and 6) remaining discolorable dye latent image-latent image sensitized polymerization reaction process recording methods of the invention involve little polymerization reaction during hologram exposure (first step) and entire exposure causing block polymerization by which refractive index modulation is conducted at the second step. Accordingly, much multiplexed recording can be conducted in any of the recording methods 1) to 3), 5) and 6). Further, any multiplexed recording can be conducted at a constant exposure, i.e., with a linear rise of refractive index modulation relative to exposure. Therefore, a broad dynamic range can be obtained. Thus, 1) to 3) and 5) and 6) process recording methods of the invention are very advantageous from the standpoint of the aforementioned adaptability to multiplexed recording.

This is advantageous from the standpoint of enhancement of density (capacity), simplification of recording system, enhancement of S/N ratio, etc.

As mentioned above, the hologram recording material of the invention gives drastic solution to the aforementioned problems. In particular, the hologram recording material of the invention allows quite a new recording method which attains high sensitivity, good storage properties, dry processing properties and multiplexed recording properties (high recording density). The hologram recording material is particularly suited for optical recording medium (holographic optical memory).

Further, the hologram recording material of the invention can be used for recording media as disclosed in JP-T-2005-500581, JP-T-2005-501285, Japanese Patent No. 3393064, JP-A-2003-85768, JP-A-2004-265472, and JP-2004-126040. Moreover, the hologram recording material of the invention can perform hologram recording and reproduction using a recording/reproducing apparatus as disclosed in JP-A-2004-272268, JP-A-2004-177958, JP-A-2003-43904, Japanese Patent No. 3451663, JP-A-2004-335044, JP-A-2004-361928, JP-A-2004-171611, JP-A-2003-228849, JP-A-2002-83431, JP-A-2002-123948, JP-A-2004-30734, JP-A-2004-362750, Japanese Patent No. 3430012, JP-A-2003-178457, JP-A-2003-178458, JP-A-2003 -178462, JP-A-2003-178484, and JP-A-2003-151143.

The hologram recording material of the invention can be used as three-dimensional display hologram, holographic optical element (HOE, such as headup display (HUD) for automobile, pickup lens for optical disc, head mount display, color filter for liquid crystal, reflector for reflective liquid crystal, lens, diffraction grating, interference filter, connector for optical fiber, light polarizer for facsimile, window glass for building), cover paper for book, magazine, and display for POP, etc. The hologram recording material of the invention is preferably used for gift and credit card, paper money and packaging for the purpose of security against forgery.

The invention will be further described in the following examples, but the invention is not limited thereto.

Example 1

(Hologram recording method involving color development process)

Using Posiratio (produced by Liquid Control Inc.), 200 g of Baytech WE-180 (50/50 blend of biscyclohexylmethane diisocyanate and NCO-terminated prepolymer based on biscyclohexylmethane diisocyanate and polytetramethylene glycol available from Bayer Inc.), 200 g of Mondur ML (liquid diphenylmethane diisocyanate available from Bayer Inc.), an optical refractive index-modulating component (as set forth in the table below) and 254 mg of butylated hydroxytoluene (BHT) were thoroughly mixed in the tank A thereof to form a uniform solution which was then deaerated. In the tank B of the device were thoroughly mixed 807 g of a polypropylene oxide triol having a molecular weight of 1,000, 310 μl of t-butyl peroxide and 10.1 g of dibutyl laurate tin to form a uniform solution which was then deaerated. Subsequently, the content of the tanks A and B were mixed to prepare compositions 101 to 110.

These compositions for hologram recording material 101 to 110 were each spread (optionally in a multi-layer form) over a glass substrate to a thickness of about 200 μm using a blade to form a photosensitive layer which was then dried at room temperature for 1 day. The photosensitive layer was then covered by TAC layer to prepare hologram recording materials 101 to 110.

The hologram recording materials 101 to 110 were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 mW/cm$^2$. During exposure, the holographic exposure time was varied from 0.1 to 400 seconds (radiation energy ranging from 0.8 to 3,200 mJ/cm$^2$). During hologram exposure, He-Ne laser beam having a wavelength of 632 nm was passed through the center of exposed area at the Bragg angle. The ratio of diffracted light to transmitted light (relative diffraction efficiency) was then measured at real time. Since the sensitizing dye shows no absorption at 632 nm, the hologram recording material is not sensitive to He-Ne laser beam. In Fig. 1, the reference numeral 10 indicates a YAG laser, the reference numeral 12 indicates a laser beam, the reference numeral 14 indicates

a mirror, the reference numeral 20 indicates a beam splitter, the reference numeral 22 indicates a beam segment, the reference numeral 24 indicates a mirror, the reference numeral 26 indicates a spatial filter, the reference numeral 40 indicates a beam expander, the reference numeral 30 indicates a hologram recording material, the reference numeral 28 indicates a sample, the reference numeral 32 indicates a He-Ne laser beam, the reference numeral 34 indicates a He-Ne laser, the reference numeral 36 indicates a detector, and the reference numeral 38 indicates a rotary stage.

These hologram recording materials were also each measured for multiplexity M/#/200 μm. M/# is decided by the refractive index difference and the thickness of the material and is typically 1.5 or more. In the invention, M/# is converted to 200 μm of thickness of the material. Further, M/# is defined as the dynamic range of the recording material. M/# can be measured by multiplexing a series of holograms the exposure time of which are predetermined such that all the optical refractive index-modulating components in the material are consumed. M/# can be defined as the sum of root of diffraction efficiency of all multiplexed holograms.

These hologram recording materials were also each examined for start of exothermic reaction, exothermic peak and shrinkage.

The start of exothermic reaction indicates that the temperature of a material distributed on a dish starts to rise, initiating the reaction. For the measurement of exothermic reaction, the temperature of the material distributed on the dish was measured by means of a thermocouple or thermometer inserted in the material. The time required until the temperature of the material rises from 24˚C to 30˚C was measured. For the recording of exothermic peak, the time required until the temperature of the thermocouple or thermometer was monitored. Shrinkage (causing the thickness of the material first) is decided by measuring the Bragg detuning of angle-multiplexed hologram (shift of reading angle). for the details of the qualitative relationship between the physical shrinkage of the material and the Bragg detuning, reference can be made to the aforementioned reference, i.e., Applied Physics Letters, Volume 73, Number 10, pp. 1,337-1,339, September 7, 1998.

For comparison, a radical polymerization photopolymer process hologram recording material disclosed in Example 1 of JP-T-2004-537620 (Comparative Example 1 set forth in the table below) was prepared.

The results are set forth in Table 2 below.

Table 1

| Sample | Sensitizing dye | | Electron-donating | | Interference fringes compound recording component | | | | Additives |
|---|---|---|---|---|---|---|---|---|---|
| 101 | S-71 | 4% | — | | 1-5 | 50% | +L-2 | 10% | SO-1 8% |
| 102 | S-75 | 8% | — | | | | " | | |
| 103 | S-75 | 4% | A-1 | 36% | | | " | | |
| 104 | S-81 | 30% | — | | | | " | | SO-2 36% |
| 105 | S-88 | 30% | — | | | | " | | |
| 106 | S-92 | 0.84% | A-1 | 42% | | | " | | SO-3 8% |
| 107 | S-93 | 1.6% | " | | | | " | | |
| 108 | S-6 | 0.5% | " | | PB-2 | 20% | +DD-33 | 10% | |
| 109 | S-93 | 1.6% | " | | E-3 | 25% | | | Trioctylamine 10% |
| 110 | S-81 | 30% | — | | E-4 | 25% | | | |

Note) The unit % indicates % by weight based on binder polymer.

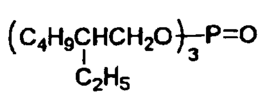

SO-1

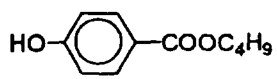

SO-2

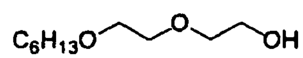

SO-3

Table 2

| Sample | Maximum diffraction efficienct η | M/# | Start of exotherm | Exothermic Peak | % Shrinkage |
|---|---|---|---|---|---|
| 101 | 84% | 2.9 | 1 min | 2 min | < 0.01% |
| 102 | 87 | 3.0 | " | " | " |
| 103 | 87 | 3.0 | " | " | " |
| 104 | 83 | 2.8 | " | " | " |
| 105 | 82 | 2.9 | " | " | " |
| 106 | 85 | 3.1 | " | " | " |
| 107 | 88 | 3.1 | " | " | " |
| 108 | 83 | 2.8 | " | " | " |
| 109 | 84 | 3.0 | " | " | " |
| 110 | 83 | 2.9 | " | " | " |
| Comparative Example 1 | 81 | 1.8 | " | " | 0.12% |

As can be seen in Table 2 above, the known example described in JP-T-2004-537620 shows a high diffraction efficiency but shows insufficient M/# and shrinkage resistance. On the other hand, the inventive hologram recording materials 101 to 110 employ a recording process which is quite different from the known hologram recording process, i.e., hologram recording process involving refractive index modulation by color development reaction rather than by the movement and polymerization of material. Thus, the inventive hologram recording materials 101 to 110 can perform recording at a high diffraction efficiency as well as a shrinkage as extremely small as 0.01% or less with a high multiplexity M/# and thus are suitable particularly for holographic memory.

Further, the hologram recording material of the invention shows a substantially linear rise of Δn (refractive index modulation in interference fringes, calculated from diffraction efficiency and layer thickness by Kugelnick's equation) with exposure ($mJ/cm^2$) and thus is favorable for multiplexed recording.

Multiplexed hologram recording was actually made on the same area of a hologram recording material of the invention 10 times at a dose corresponding to one tenth of the exposure giving half the aforementioned maximum diffraction efficiency and a reference light angle varying by 2 degrees every recording job. Thereafter, the hologram recording material was irradiated with a reproducing light at an angle varying by 2 degrees. As a result, it was confirmed that these object lights can be reproduced. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-T-2004-537620 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multipiexity, i.e., recording density.

Even when the sensitizing dye to be used in Samples 101 to 110 were changed to S-1, S-4, S-8, S-10, S-11, S-19, S-23, S-31, S-33, S-34, S-43, S-45, S-46, S-50, S-58, S-67, S-73, S-74, S-77, S-80, S-91, S-95 or S-96, similar effects were obtained.

Further, even when the acid generator to be used as interference fringes recording component in Samples 101 to 107 were changed to I-3, I-4, I-6, I-7, I-8, I-9, I-10, 4-(octylphenyl)phenyl iodonium hexafluoroantimonate, tris(4-methylphenyl)sulfonium tetra (pentafluoro phenyl)borate, triphenylsulfonium perfluoropentanoate, bis(1-(4-diphenylsulfonium)phenylsulfide ditrifurate, dimethylphenasyl sulfonium perfluorobutane sulfonate, benzoyl tosylate, I-22 or I-23 or when the acid-colorable dye precursor polymer to be used as interference fringes recording component in Samples 101 to 107 were changed to L-1, L-3, LC-1, LC-4, LC-9, LC-11, LC-12 or LC-13, similar effects were obtained.

Further, eve when the base generator to be used as interference fringes recording component in Sample 108 was changed to PB-3, PB-4, PB-5, PB-6, PB-7, PB-8 or PB-9 or when the base-colorable dye precursor (non-dissociative product of dissociative dye) to be used in Sample 108 was changed to DD-1, DD-13, DD-15, DD-17, DD-22, DD-30, DD-31, DD-32, DD-34, DD-35, DD-36, DD-37 or DD-38, similar effects were obtained.

Further, even when the interference fringes-recording component to be used in Samples 109 and 110 were changed to E-5, E-9, E-10, E-11, E-12, E-13, E-14, E-15, E-16, E-18, E-20, E-25, E-26, E-27, E-28, E-29 or E-30, similar effects were obtained.

Further, even when the electron-donating compound to be used in Samples 103 and 106 to 109 were changed to A-2, A-3, A-4, A-5, A-6, A-9, A-10 or A-11, similar effects were obtained.

Further, even when the binder to be used in Samples 101 to 110 were changed to polymethyl methacrylates (Mw: 996,000, 350,000, 120,000), poly(methyl methacrylate-butyl methacrylate) copolymer (Mw: 75,000), polyvinyl acetate (Mw: 83,000), polycarbonate, cellulose acetate butyrate, etc., similar effects were obtained.

Moreover, even when Baytech WE-180 to be used as a binder polymer component in Samples 101 to 110 were changed to Baytech MP-160 (NCO-terminated prepolymer based on diphenylmethane diisocyanate and polypropylene ether glycol available from Bayer Inc.), similar effects were obtained. In addition, even when the isocyanate composition to be used as a binder polymer component was changed to Baytech WE-180 (180 g) or Desmodur N3200 (biuret derivative of HDI available from Bayer Inc.) (120 g) and the polyol composition to be used as a binder polymer component was changed to PMEG 1000 (polytetramethylene ether diol having a molecular weight of 1,000) (300 g) or a polypropylene oxide triol having a molecular weight of 1,500 (300 g), similar effects were obtained.

Moreover, even when the binder polymer to be used in Samples 101 to 110 were changed to a melamine-formaldehyde resin such as poly(melamine-formaldehyde) methylated resin available from Aldrich Chemical Inc., similar effects were obtained.

Example 2

(Hologram recording by latent image color development-coloring material self-sensitized amplification color development reaction)

Hologram recording materials 201 to 204 were prepared in the same manner as in Example 1 except that the components set forth in Table 3 were used. The unit % indicates % by weight.

Table 3

| Sample | Sensitizing dye Electron-donating compound | | Dye precursor group + polymerization initiator | Polymerizable compound | | Binder |
|---|---|---|---|---|---|---|
| 201 | S-93 | 0.8% | L-2(5%)+I-5(20%) | M-1 | 32.2% | 32% |
| | A-1 | 10% | | | | |
| 202 | S-92 | 0.4% | L-2(5%)+I-5(20%) | POEA: | NA | 32% |
| | A-1 | 10% | | = 4:1 | 32.6% in total | |
| 203 | S-6 | 0.2% | DD-33(5%)+PB-2(20%) | M-2 | 32.8% | 32% |
| | A-1 | 10% | | | | |
| 204 | S-93 | 0.8% | E-4(20%)+I-2(1.6%) | POEA: | NVC | 33% |
| | A-1 | 10% | +MBO(2.4%) | = 2:1 | 32.2% in total | |

M-1

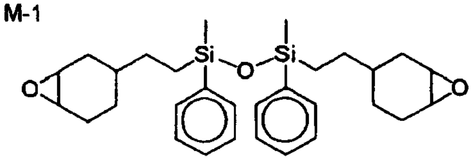

M-2

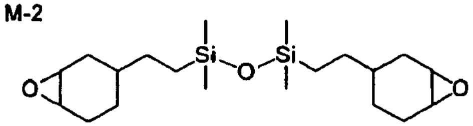

POEA

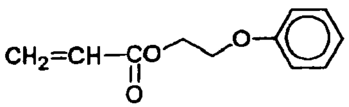

NVC

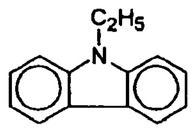

NA

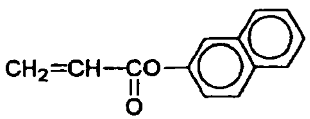

MBO

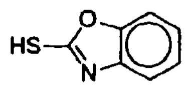

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 40 seconds (radiation energy ranging from 0.8 to 320 $mJ/cm^2$) (first step). He-Ne laser beam having a wavelength of 632 nm was passed through the center of exposed area at the Bragg angle. The ratio of diffracted light to transmitted light (relative diffraction efficiency) was then measured at real time (diffraction efficiency $\eta$ after first step). Since the sensitizing dye shows no absorption at 632 nm, the hologram recording material is not sensitive to He-Ne laser beam.

Thereafter, the hologram recording materials were each then entirely irradiated with light rays having a wavelength range of from 370 to 410 nm (second step). The diffraction efficiency was measured (diffraction efficiency $\eta$ after second step). By dividing the radiation dose required to give the maximum diffraction efficiency using only the first step rather than the second step by the radiation dose required at the first step if the second step is used, the "percent amplification" was determined. The results are set forth in Table 4.

Table 4

| Sample | Diffraction efficiency $\eta$ after first step | Diffraction efficiency $\eta$ after second step | % Amplification |
|---|---|---|---|
| 201 | 17% | 82% | 6.2 |
| 202 | 16 | 85 | 6.7 |
| 203 | 16 | 82 | 5.1 |
| 204 | 16 | 83 | 5.8 |

| Sample | M/# | Start of exotherm | Exothermic Peak | % Shrinkage |
|---|---|---|---|---|
| 201 | 2.6 | 1 min | 2 min | < 0.01% |
| 202 | 2.7 | " | " | " |
| 203 | 2.5 | " | " | " |
| 204 | 2.5 | " | " | " |

As can be seen in Table 4, when the hologram recording material of the invention is used, the radiation dose required at the first step can be reduced to one seventh to one fifth of that required when the second step is not employed. It is also made obvious that the second step allows block exposure and hence polymerization with the coloring material of the first step as a latent image, resulting in amplification of refractive index modulation that allows the reduction of the first step, i.e., enhancement of sensitivity. It goes without saying that the known hologram recording material disclosed in JP-T-2004-537620 cannot undergo such amplification that allows enhancement of sensitivity. It is also made obvious that the hologram recording material of the invention exhibits a higher M/# value than JP-T-2004-537620.

Further, the hologram recording material of the invention shows a substantially linear rise of $\Delta n$ (refractive index modulation in interference fringes, calculated from diffraction efficiency and layer thickness by Kugelnick's equation) with exposure ($mJ/cm^2$) both after the first and second steps and thus is favorable for multiplexed recording.

Multiplexed hologram recording was actually made on the same area of a hologram recording material of the invention 10 times at a dose corresponding to one tenth of the exposure giving the aforementioned maximum diffraction efficiency and a reference light angle varying by 2 degrees every recording job (first step). Thereafter, the hologram recording material was entirely irradiated with light having a wavelength of from 370 nm to 410 nm to perform recording amplification by polymerization (second step). As a result, it was confirmed that these object lights can be reproduced by irradiating the hologram recording material with a reproducing light at an angle varying by 2 degrees. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-T-2004-537620 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

On the other hand, the hologram recording method of the invention employs color development reaction as a means of forming a latent image rather than polymerization during hologram recording (first step) and thus is not subject to the aforementioned disadvantages. Therefore, the hologram recording method of the invention is superior to the known photopolymer process.

Even when the sensitizing dye to be used in Samples 201 to 204 were changed to S-1, S-4, S-8, S-10, S-11, S-19, S-23, S-31, S-33, S-34, S-43, S-45, S-46, S-50, S-58, S-67, S-71, S-73, S-74, S-75, S-77, S-80, S-81, S-88, S-91, S-94, S-95 or S-96, similar effects were obtained.

Further, even when the acid generator to be used as interference fringes recording component in Samples 201 and 202 were changed to I-3, I-4, I-6, I-7, I-8, I-9, I-10, 4-(octylphenyl)phenyl iodonium hexafluoroantimonate, tris (4-methylphenyl)sulfonium tetra(pentafluoro phenyl)borate, triphenylsulfonium perfluoropentanoate, bis(1-(4-diphenylsulfonium) phenylsulfide ditrifurate or dimethylphenasyl sulfonium perfluorobutane sulfonate or when the acid-colorable dye precursor polymer to be used as interference fringes recording component in Samples 201 and 202 were changed to L-1, L-3, LC-1, LC-4, LC-9, LC-11, LC-12 or LC-13, similar effects were obtained.

Further, eve when the base generator (which acts also as anionic polymerization initiator) to be used as interference fringes recording component/polymerization initiator in Sample 203 was changed to PB-3, PB-4, PB-5, PB-6, PB-7, PB-8 or PB-9 or when the base-colorable dye precursor (non-dissociative product of dissociative dye) to be used in Sample 203 was changed to DD-1, DD-13, DD-15, DD-17, DD-22, DD-30, DD-31, DD-32, DD-34, DD-35, DD-36, DD-37 or DD-38, similar effects were obtained.

Further, even when the dye precursor to be used in Sample 204 was changed to E-3, E-5, E-9, E-10, E-11, E-12, E-13, E-14, E-15, E-16, E-18, E-20, E-25, E-26, E-27, E-28, E-29 or E-30 or when the radical polymerization initiator to be used in Sample 204 was changed to I-1 or I-11 to I-20, similar effects were obtained.

Further, even when the electron-donating compound to be used in Samples 201 to 204 were changed to A-2, A-3, A-4, A-5, A-6, A-9, A-10 or A-11, similar effects were obtained.

The lights with which the hologram recording material was entirely irradiated during the aforementioned procedure had an optimum wavelength in the respective system.

Moreover, even when Baytech WE-180 to be used as a binder polymer component in Samples 201 to 204 were changed to Baytech MP-160 (NCO-terminated prepolymer based on diphenylmethane diisocyanate and polypropylene ether glycol available from Bayer Inc.), similar effects were obtained. In addition, even when the isocyanate composition to be used as a binder polymer component was changed to Baytech WE-180 (180 g) or Desmodur N3200 (biuret derivative of HDI available from Bayer Inc.) (120 g) and the polyol composition to be used as a binder polymer component was changed to PMEG 1000 (polytetramethylene ether diol having a molecular weight of 1,000) (300 g) or a polypropylene oxide triol having a molecular weight of 1,500 (300 g), similar effects were obtained.

Moreover, even when the binder polymer to be used in Samples 201 to 204 were changed to a melamine-formaldehyde resin such as poly(melamine-formaldehyde) methylated resin available from Aldrich Chemical Inc., similar effects were obtained.

Example 3

(Discoloration process (sensitizing dye + discolorable dye) hologram recording method)

Hologram recording materials 301 to 307 were prepared in the same manner as in Example 1 except that the components set forth in Table 5 were used. The unit % indicates % by weight.

Table 5

| Sample | Sensitizing dye | | Electron-donating compound | | Discoloring agent precursor | | Discolorable dye | |
|---|---|---|---|---|---|---|---|---|
| 301 | S-6 | 0.5% | A-1 | 42% | I-5 | 50% | G-16 | 16% |
| 302 | S-93 | 1.6% | A-1 | 42% | I-5 | 50% | G-28 | 16% |
| 303 | S-92 | 0.84% | A-1 | 42% | I-5 | 50% | G-15 | 8% |
| 304 | S-75 | 8% | — | | I-5 | 50% | G-16 | 8% |
| 305 | S-75 | 8% | — | | I-5 | 50% | G-13 | 8% |
| 306 | S-75 | 4% | A-1 | 36% | I-5 | 50% | G-16 | 16% |
| 307 | S-93 | 1.3% | A-1 | 42% | PB-2 | 20% | G-35 | 8% |

($X_{51}$ represents $PF_6^-$)

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 400 seconds (radiation energy ranging from 0.8 to 320 $mJ/cm^2$). He-Ne laser beam having a wavelength of 632 nm was passed through the center of exposed area at the Bragg angle. The ratio of diffracted light to transmitted light (relative

diffraction efficiency) was then measured at real time. Since the sensitizing dye shows no absorption at 632 nm, the hologram recording material is not sensitive to He-Ne laser beam.

For comparison, a radical polymerization photopolymer process hologram recording material disclosed in Example 1 of JP-T-2004-537620 (Comparative Example 2 described below) was prepared.

Table 6

| Sample | Maximum diffraction efficiency η | M/# | Start of exotherm | Exothermic Peak | % Shrinkage |
|---|---|---|---|---|---|
| 301 | 87% | 3.2 | 1 min | 2 min | <0.01% |
| 302 | 92 | 3.4 | " | " | " |
| 303 | 85 | 3.2 | " | " | " |
| 304 | 88 | 3.1 | " | " | " |
| 305 | 92 | 3.2 | " | " | " |
| 306 | 86 | 3.0 | " | " | " |
| 307 | 84 | 2.9 | " | " | " |
| Comparative Example 2 | 81 | 1.8 | " | " | 0.12% |

As can be seen in Table 6 above, the known example described in JP-T-2004-537620 shows a high diffraction efficiency but shows insufficient M/#, sensitivity and shrinkage resistance. On the other hand, the inventive hologram recording materials 301 to 307 employ a recording process which is quite different from the known hologram recording process, i.e., hologram recording process involving refractive index modulation by discoloration reaction rather than by the movement and polymerization of material. Thus, the inventive hologram recording materials 301 to 307 can perform recording at a high diffraction efficiency as well as a shrinkage as extremely small as 0.01% or less with a high multiplexity M/# and thus are suitable particularly for holographic memory.

Further, the hologram recording material of the invention shows a substantially linear rise of Δn (refractive index modulation in interference fringes, calculated from diffraction efficiency and layer thickness by Kugelnick's equation) with exposure ($mJ/cm^2$) and thus is favorable for multiplexed recording.

Multiplexed hologram recording was actually made on the same area of a hologram recording material of the invention 10 times at a dose corresponding to one tenth of the exposure giving half the aforementioned maximum diffraction efficiency and a reference light angle varying by 2 degrees every recording job. Thereafter, the hologram recording material was irradiated with a reproducing light at an angle varying by 2 degrees. As a result, it was confirmed that these object lights can be reproduced. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-T-2004-537620 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

Example 4

(Hologram recording by remaining discolorable dye latent image-latent image sensitization polymerization reaction)

Hologram recording materials 401 to 404 were prepared in the same manner as in Example 1 except that the components set forth in Table 7 were used. The unit % indicates % by weight.

Table 7

| Sample | Sensitizing dye<br>Electron-donating compound | | Discolorable dye | | Discoloring agent precursor<br>Polymerization initiator | | Polymerizable compound<br>Binder | |
|---|---|---|---|---|---|---|---|---|
| 401 | S-75 | 4% | G-16 | 4% | I-5 | 18% | M-2 | 37% |
| | | | | | | | 37% | |
| 402 | S-93 | 0.8% | G-28 | 4% | I-5 | 18% | TEGDA | 33.2% |
| | A-1 | 10% | | | | | 34% | |
| 403 | S-92 | 0.4% | G-30 | 4% | PB-2 | 18% | M-2 | 33.6% |
| | A-1 | 10% | ($X_{51}$ represents $PF_6^-$) | | | | 34% | |
| 404 | S-6 | 0.2% | G-47 | 13% | | | DDA28% | PFOA7% |
| | A-1 | 10% | | | I-2 1.6%+MBO | 2.4% | 37% | |

M-2

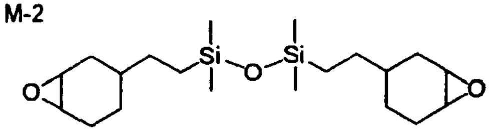

MBO

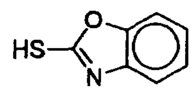

DDA

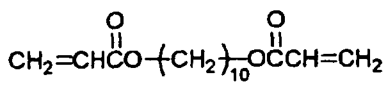

PFOA

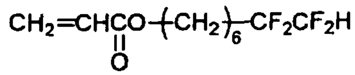

TEGDA

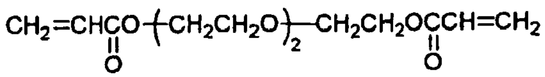

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 40 seconds (radiation energy ranging from 0.8 to 320 $mJ/cm^2$) (first step). He-Ne laser beam having a wavelength of 632 nm was passed through the center of exposed area at the Bragg angle. The ratio of diffracted light to transmitted light (relative diffraction efficiency) was then measured at real time (diffraction efficiency η after first step). Since the sensitizing dye shows no absorption at 632 nm, the hologram recording material is not sensitive to He-Ne laser beam.

Thereafter, the hologram recording materials were each then entirely irradiated with light rays having a wavelength range of from 370 to 410 nm (second step). The diffraction efficiency was measured (diffraction efficiency η after second step). By dividing the radiation dose required to give the maximum diffraction efficiency using only the first step rather than the second step by the radiation dose required at the first step if the second step is used, the "percent amplification" was determined. The results are set forth in Table 8.

Table 8

| Sample | | Diffraction efficiency η after first step | Diffraction efficiency η after second step | % Amplification |
|---|---|---|---|---|
| 401 | | 18% | 85% | 6.3 |
| 402 | | 18 | 87 | 6.8 |
| 403 | | 17 | 81 | 5.2 |
| 404 | | 17 | 84 | 6.1 |
| Sample | M/# | Start of exotherm | Exothermic Peak | % Shrinkage |
| 401 | 2.8 | 1 min | 2 min | < 0.01% |
| 402 | 2.9 | " | " | " |
| 403 | 2.6 | " | " | " |
| 404 | 2.6 | " | " | " |

As can be seen in Table 8, when the hologram recording material of the invention is used, the radiation dose required at the first step can be reduced to one fifth to one seventh of that required when the second step is not employed. It is also made obvious that the second step allows block exposure and hence polymerization with the discolorable dye left undiscolored at the first step as a latent image, resulting in amplification of refractive index modulation that allows the reduction of the first step, i.e., enhancement of sensitivity. It goes without saying that the known hologram recording material disclosed in JP-T-2004-537620 cannot undergo such amplification that allows enhancement of sensitivity.

Further, the hologram recording material of the invention shows a substantially linear rise of $\Delta n$ (refractive index modulation in interference fringes, calculated from diffraction efficiency and layer thickness by Kugelnick's equation) with exposure ($mJ/cm^2$) both after the first and second steps and thus is favorable for multiplexed recording.

Multiplexed hologram recording was actually made on the same area of a hologram recording material of the invention 10 times at a dose corresponding to one tenth of the exposure giving the aforementioned maximum diffraction efficiency and a reference light angle varying by 2 degrees every recording job (first step). Thereafter, the hologram recording material was entirely irradiated with light having a wavelength of from 370 nm to 410 nm to perform recording amplification by polymerization (second step). As a result, it was confirmed that these object lights can be reproduced by irradiating the hologram recording material with a reproducing light at an angle varying by 2 degrees. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-T-2004-537620 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

On the other hand, the hologram recording method of the invention employs discoloration reaction as a means of forming a latent image rather than polymerization during hologram recording (first step) and thus is not subject to the aforementioned disadvantages. Therefore, the hologram recording method of the invention is superior to the known photopolymer process.

Even when the sensitizing dye to be used in Samples 301 to 307 and 401 to 404 were changed to S-1, S-4,

S-8, S-10, S-11, S-19, S-23, S-31, S-33, S-34, S-43, S-45, S-46, S-50, S-58, S-67, S-71, S-73, S-74, S-77, S-80, S-81, S-88, S-91, S-94, S-95 or S-96, similar effects were obtained.

Further, even when the discoloring agent precursor (acid generator, optionally also acid or radical polymerization initiator) to be used in Samples 301 to 306, 401 and 402 were changed to 1-3, I-4, I-6, I-7, I-8, I-9, I-10, 4-(octylphenyl) phenyl iodonium hexafluoroantimonate, tris(4-methylphenyl)sulfonium tetra(pentafluorophenyl)borate, triphenylsulfonium perfluoropentanoate, bis(1-(4-diphenylsulfonium) phenylsulfide ditrifurate, dimethylphenasyl sulfonium perfluorobutane sulfonate, benzoin tosylate, I-22 or I-23 or when the acid-discolorable dye to be used in Samples 301 to 306, 401 and 402 were changed to G-14, G-17, G-21, G-22, G-26 or G-27, similar effects were obtained.

Further, eve when the discoloring agent precursor (base generator, optionally also anionic polymerization initiator) to be used in Samples 307 and 403 were changed to PB-3, PB-4, PB-5, PB-6, PB-7, PB-8 or PB-9 or when the base-discolorable dye to be used in Samples 307 and 403 were changed to G-29, G-32, G-38, G-40, G-42, G-43, G-44 or G-45, similar effects were obtained. Moreover, even when the radical polymerization initiator to be used in Sample 404 was changed to I-1 or I-11 to I-20 or when the discolorable dye to be used in Sample 404 was changed to G-48, G-49, G-51 or G-52, similar effects were obtained.

Further, even when the electron-donating compound to be used in Samples 301 to 303, 306, 307 or 402 to 404 were changed to A-2, A-3, A-4, A-5, A-6, A-9, A-10 or A-11, similar effects were obtained.

Further, even when the binder to be used in Samples 301 to 307 were changed to polymethyl methacrylates (Mw: 996,000, 350,000, 120,000), poly(methyl methacrylate-butyl methacrylate) copolymer (Mw: 75,000), polyvinyl acetate (Mw: 83,000), polycarbonate, cellulose acetate butyrate, etc., similar effects were obtained.

Moreover, even when Baytech WE-180 to be used as a binder polymer component in Samples 301 to 307 and 401 to 404 were changed to Baytech MP-160 (NCO-terminated prepolymer based on diphenylmethane diisocyanate and polypropylene ether glycol available from Bayer Inc.), similar effects were obtained. In addition, even when the isocyanate composition to be used as a binder polymer component was changed to Baytech WE-180 (180 g) or Desmodur N3200 (biuret derivative of HDI available from Bayer Inc.) (120 g) and the polyol composition to be used as a binder polymer component was changed to PMEG 1000 (polytetramethylene ether diol having a molecular weight of 1,000) (300 g) or a polypropylene oxide triol having a molecular weight of 1,500 (300 g), similar effects were obtained.

Moreover, even when the binder polymer to be used in Samples 301 to 307 and 401 to 404 were changed to a melamine-formaldehyde resin such as poly(melamine- formaldehyde) methylated resin available from Aldrich Chemical Inc., similar effects were obtained.

The lights with which the hologram recording material was entirely irradiated during the aforementioned procedure had an optimum wavelength in the respective system.

While the invention has been described in detail and with reference to specific embodiments thereof, it will be apparent to one skilled in the art that various changes and modifications can be made therein without departing from the spirit and scope thereof.

The entire disclosure of each and every foreign patent application from which the benefit of foreign priority has been claimed in the present application is incorporated herein by reference, as if fully set forth herein.

## Claims

1. A hologram recording material comprising:

   an optical refractive index-modulating component; and
   a curable polymer,

   wherein the optical refractive index-modulating component performs at least one of: (1) a color development reaction; (2) a color development reaction amplified by a self-sensitization with a coloring material of a latent image; (3) a color development reaction amplified by a self-sensitization with a coloring material of a latent image; (4) an alignment change in a compound having a birefringence; (5) a dye discoloration reaction; and (6) a latent image-sensitized polymerization reaction sensitized by a latent image of a residual of a discolorable dye, to record interference fringes providing a refractive index modulation.

2. The hologram recording material according to Claim 1, wherein the curable polymer forms a polymer matrix produced by a polymerization reaction which is at least one of: a cationic epoxy polymerization reaction; a cationic vinyl ether polymerization reaction; a cationic alkenyl ether polymerization reaction; a cationic allyl ether polymerization reaction; a cationic ketene acetal polymerization reaction; an epoxy amine stepwise polymerization reaction; an epoxy mercaptane stepwise polymerization reaction; an unsaturated ester amine stepwise polymerization reaction; an unsaturated ester mercaptane stepwise polymerization reaction; a vinyl- silicon hydride stepwise polymerization reaction;

an isocyanate-hydroxyl group stepwise polymerization reaction; and an isocyanate-amine stepwise polymerization reaction.

3. The hologram recording material according to Claim 1, wherein the curable polymer comprises a reactive polymer and a crosslinking agent, and the curable polymer undergoes a polymerization reaction to form a polymer matrix.

4. The hologram recording material according to Claim 2, wherein the polymer matrix is formed by a thermal reaction.

5. The hologram recording material according to Claim 2, wherein the polymerization reaction for producing the polymer matrix is independent of an optical refractive index-modulation reaction of the optical refractive index-modulating component, and the polymerization reaction causes no reaction of the optical refractive index-modulating component during the polymerization reaction.

6. The hologram recording material according to Claim 3, wherein the reactive polymer is a polyol, and the crosslinking agent is an NCO-terminated prepolymer.

7. The hologram recording material according to Claim 6, wherein an exothermic peak occurs within 12 minutes after mixing the polyol with the NCO- terminated prepolymer.

8. The hologram recording material according to Claim 6, wherein the polymerization reaction is at least one of an isocyanate-hydroxyl group stepwise polymerization reaction and an isocyanate-amine stepwise polymerization reaction.

9. The hologram recording material according to Claim 6, wherein the NCO-terminated prepolymer comprises a material selected from the group consisting of an aromatic isocyanate and an aliphatic isocyanate and a combination thereof.

10. The hologram recording material according to Claim 6, wherein the NCO-terminated prepolymer comprises a material selected from the group consisting of an aromatic diisocyanate, a hexamethylene diisocyanate, a hexamethylene diisocyanate derivative and a combination thereof.

11. The hologram recording material according to Claim 6, wherein the polyol comprises a polyol of polypropylene oxide.

12. The hologram recording material as defined in Claim 6, wherein the polyol comprises a polytetramethylene ether diol.

13. The hologram recording material according to Claim 6, which has a thickness of 200 μm or more and $\Delta n$ of $3 \times 10^{-3}$ or more.

14. The hologram recording material according to Claim 6, wherein
the NCO-terminated prepolymer comprises at least one of a biscyclohexylmethane diisocyanate, an NCO-terminated prepolymer produced by a reaction of a biscyclohexylmethane diisocyanate with a polytetramethylene glycol, a butylated hydroxyltoluene and a hexamethylene diisocyanate derivative,
the polyol comprises a polyol of polypropylene oxide and a polyol of polytetramethylene ether, and
an exothermic peak occurs within 12 minutes after mixing the polyol with the NCO-terminated prepolymer.

15. The hologram recording material according to Claim 6, wherein
the NCO-terminated prepolymer comprises a material selected from the group consisting of a diphenylmethane diisocyanate, a toluene diisocyanate, hexamethylene diisocyanate and a hexamethylene diisocyanate,
the polyol comprises a polyol of polypropylene oxide, and
an exothermic peak occurs within 12 minutes after mixin the polyol with the NCO-terminated prepolymer.

16. The hologram recording material according to Claim 1, wherein the curable polymer comprises a melamine-formaldehyde resin.

17. The hologram recording material according to Claim 1, wherein
the optical refractive index-modulating component and the curable polymer undergo phase separation to exhibit a Rayleigh ratio of about $7 \times 10^{-3}$ or less at 90° of scattering of light having a wavelength effective for hologram recording, and
the curable polymer is produced by a reaction independent of an optical refractive index modulation reaction of the

optical refractive index-modulating component.

**18.** The hologram recording material according to Claim 1, wherein (2) the color development reaction amplified by a self-sensitization with a coloring material of a latent image comprises:

a first step of generating a coloring material as a latent image by holographic exposure, the coloring material having no absorption in a wavelength of a hologram reproducing light; and
a second step of irradiating the latent image of the coloring material with a light having a wavelength, which is different from that of the holographic exposure and in which the sensitizing dye has a molar absorption coefficient of 5,000 or less, to self-sensitize and self-amplify the coloring material,

wherein each of the first and second steps is dry process.

**19.** The hologram recording material according to Claim 1, comprising, as a group of compounds capable of performing hologram recording by one of (1) the color development reaction amplified by a self sensitization with a coloring material of a latent image:

a sensitizing dye absorbing light upon hologram exposure to generate an excited state thereof; and
an interference fringes-recording component containing a dye precursor capable of forming a coloring material, wherein the coloring material has an absorption shifted to a longer wavelength than that of the dye precursor and has no absorption in a wavelength of a hologram reproducing light,

wherein the interference fringes are recorded by forming the refractive index modulation through a color development of the coloring material as a result of an electron or energy transfer from the excited state of the sensitizing dye or an excited state of the coloring material.

**20.** The hologram recording material according to Claim 1, wherein (3) the polymerization reaction sensitized with the coloring material of the latent image comprises:

a first step of generating a coloring material as a latent image by holographic exposure, the coloring material having no absorption in a wavelength of a hologram reproducing light; and
a second step of irradiating the latent image of the coloring material with a light having a wavelength, which is different from that of the holographic exposure, to cause a polymerization reaction,

wherein each of the first and second steps is dry process.

**21.** The hologram recording material according to Claim 20, comprising, as a group of compounds capable of performing hologram recording:

a sensitizing dye absorbing light upon hologram exposure to generate an excited state thereof at the first step;
a dye precursor capable of forming a coloring material by an electron or energy transfer from the excited state of the sensitizing dye in the first step or from an excited state of the coloring material in the second step, wherein the coloring material has an absorption shifted to a longer wavelength than that in the dye precursor, the coloring material has an absorption in a wavelength in which the sensitizing has a molar absorption coefficient of 5,000 or less, and the coloring material has no absorption in a wavelength of a hologram reproducing light;
a polymerizable compound;
a polymerization initiator capable of initiating a polymerization of the polymerizable compound by an energy or electron transfer from the excited state of the sensitizing dye in the first step or from an excited state of the coloring material in the second step; and
a binder.

**22.** The hologram recording material according to Claim 1, comprising, as a group of compounds capable of performing (5) the dye discoloration reaction:

a sensitizing dye absorbing light upon hologram exposure to generate an excited state thereof; and
a discolorable dye and a discoloring agent precursor, the discoloring agent precursor comprising at least one of a radical generator, an acid generator, a base generator, a nucleophilic agent generator, an electrophilic agent generator and an triplet oxygen,

wherein the interference fringes are recorded by forming the refractive index modulation through at least one of: discoloring the discolorable dye as a result of an energy or electron transfer from the excited state of the sensitizing dye directly to the discolorable dye; and discoloring the discolorable dye by a discoloring agent formed by an energy or electron transfer from the excited state of the sensitizing dye to the discoloring agent precursor.

**23.** The hologram recording material according to Claim 1, wherein 6) the latent image-sensitized polymerization reaction sensitized by a latent image of a residual of a discolorable dye comprising:

a first step in which:

a sensitizing dye having absorption in a wavelength of a hologram recording light absorbs light upon holographic exposure to generate the excited state thereof,
a color of a discolorable dye is discolored by at least one of; an energy or electron transfer from the excited state of the sensitizing dye directly to the discolorable dye; and a discoloring agent formed by an energy or electron transfer from the excited state of the sensitizing dye to a discoloring agent precursor, the discoloring agent precursor comprising at least one of a radical generator, an acid generator, a base generator, a nucleophilic agent generator, an electrophilic agent generator and an triplet oxygen, and
a residual of the discolorable dye forms a latent image; and

a second step of irradiating the latent image of the residual of the discolorable dye with light having a wavelength, which is different from that the holographic exposure, to cause a polymerization reaction by activating a polymerization initiator as a result of an energy or electron transfer from the residual of the discolorable dye.

**24.** The hologram recording material according to Claim 23, comprising, as a group of compounds capable of performing hologram recording:

a sensitizing dye absorbing light upon hologram exposure to generate an excited state thereof at the first step;
a discolorable dye capable of discoloring itself in the first step as a result of at least one of: an energy or electron transfer directly from the excited state of the sensitizing dye; and an generation of the discoloring agent by an energy or electron transfer from the excited state of the sensitizing dye to the discoloring agent precursor, the discolorable dye having a molar absorption coefficient of 1,000 or less at a wavelength of a hologram reproducing light;
a polymerizable compound;
a polymerization initiator capable of initiating a polymerization of the polymerizable compound by an electron or energy transfer from the excited state of the residual of the discolorable dye in the second step; and
a binder.

**25.** The hologram recording material according to Claim 1, wherein the interference fringes are non-rewritable.

**26.** The hologram recording method according to Claim 1, which is capable of performing a multiplexed recording by subjecting the hologram recording material to holographic exposure ten times or more.

**27.** The hologram recording material according to Claim 26, wherein the multiplexed recording is performed under a common exposure amount in each holographic exposure.

**28.** An optical recording medium comprising a hologram recording material according to Claim 1.

**29.** The optical recording medium according to Claim 28, wherein the hologram recording material is stored in a light-shielding cartridge during storage.

*FIG. 1*